# EUROPEAN PATENT APPLICATION

(11) **EP 4 593 575 A1**
(43) Date of publication of application: **30.07.2025**
(21) Application number: 25151258.8
(22) Date of filing: 10.01.2025
(51) Int. Cl.: H10K 85/60, H10K 50/11

(54) **ORGANIC LIGHT EMITTING DEVICE, COMPOSITION FOR ORGANIC MATERIAL LAYER OF ORGANIC LIGHT EMITTING DEVICE AND METHOD FOR MANUFACTURING ORGANIC LIGHT EMITTING DEVICE**

(30) Priority: 26.01.2024 KR 20240012153; 04.11.2024 KR 20240154120
(71) Applicant: LT Materials Co., Ltd., Yongin-City 17118 (KR)
(72) Inventor: KIM, Byeong-Gwan, 17118 Yongin-City, Gyeonggi-Do (KR); LEE, Gi-Back, 17118 Yongin-City, Gyeonggi-Do (KR); MO, Jun-Tae, 17118 Yongin-City, Gyeonggi-Do (KR); KIM, Dong-Jun, 17118 Yongin-City, Gyeonggi-Do (KR); CHOI, Dae-Hyuk, 17118 Yongin-City, Gyeonggi-Do (KR)
(74) Representative: Goddar, Heinz J.

(57) **Abstract**

Disclosed are an organic light emitting device including a heterocyclic compound represented by Chemical Formula A and a heterocyclic compound represented by the following Chemical Formula B, a composition for an organic material layer of the organic light emitting device, and a method for manufacturing the organic light emitting device.

The organic light emitting device, the composition for an organic material layer of the organic light emitting device, and the method for manufacturing the organic light emitting device described in the present specification can reduce the driving voltage of the device, improve the light emitting efficiency, and improve the service life characteristics of the device.

## Description

### CROSS-REFERENCE TO RELATED APPLICATIONS

This application claims priority to and the benefit of Korean Patent Application Nos. 10-2024-0012153 and 10-2024-0154120 filed in the Korean Intellectual Property Office on January 26, 2024 and November 4, 2024, respectively, the entire contents of which are incorporated herein by reference.

### TECHNICAL FIELD

The present specification relates to an organic light emitting device, a composition for an organic material layer of the organic light emitting device, and a method for manufacturing an organic light emitting device.

### BACKGROUND ART

A light emitting device is a kind of self-emitting type display device, and has an advantage in that the viewing angle is wide, the contrast is excellent, and the response speed is fast.

An organic light emitting device has a structure in which an organic thin film is disposed between two electrodes. When a voltage is applied to an organic light emitting device having the structure, electrons and holes injected from the two electrodes combine with each other in an organic thin film to make a pair, and then, emit light while being extinguished. The organic thin film may be composed of a single layer or multiple layers, if necessary.

A material for the organic thin film may have a light emitting function, if necessary. For example, as the material for the organic thin film, it is also possible to use a compound, which may itself constitute an emission layer alone, or it is also possible to use a compound, which may serve as a host or a dopant of a host-dopant-based emission layer. In addition, as a material for the organic thin film, it is also possible to use a compound, which may play a role such as a hole injection, hole transport, electron blocking, hole blocking, electron transport or electron injection.

In order to improve the performance, service life, or efficiency of the organic light emitting device, there is a continuous need for developing a material for an organic thin film.

### [Related Art Document]

### [Patent Document]

(Patent Document 1) US Patent No. 4,356,429

### SUMMARY OF THE INVENTION

The present invention has been made in an effort to provide an organic light emitting device, a composition for an organic material layer of the organic light emitting device, and a method for manufacturing an organic light emitting device.

An exemplary embodiment of the present invention provides an organic light emitting device including: a first electrode; a second electrode provided to face the first electrode; and an organic material layer having one or more layers disposed between the first electrode and the second electrode, in which one or more layers of the organic material layer include a heterocyclic compound represented by the following Chemical Formula A; and a heterocyclic compound represented by the following Chemical Formula B.

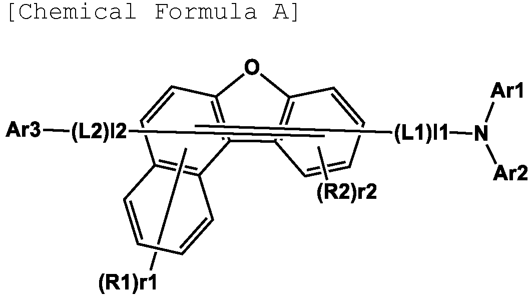

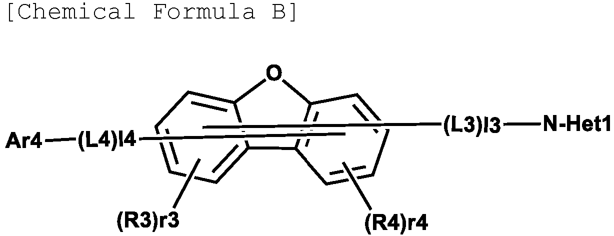

In Chemical Formulae A and B,
L1 to L4 are the same as or different from each other, and are each independently a direct bond; a substituted or unsubstituted arylene group having 6 to 60 carbon atoms; or a substituted or unsubstituted heteroarylene group having 2 to 60 carbon atoms,
Ar1 to Ar3 are the same as or different from each other, and are each independently a substituted or unsubstituted aryl group having 6 to 60 carbon atoms; a substituted or unsubstituted heteroaryl group having 2 to 60 carbon atoms; or a combination thereof,
Ar4 is a substituted or unsubstituted aryl group having 6 to 60 carbon atoms; a substituted or unsubstituted heteroaryl group having 2 to 60 carbon atoms; or a substituted or unsubstituted amine group,
R1 and R2 are the same as or different from each other, and are each independently hydrogen; deuterium; a halogen group; a cyano group; a substituted or unsubstituted alkyl group having 1 to 60 carbon atoms; a substituted or unsubstituted cycloalkyl group having 3 to 60 carbon atoms; a substituted or unsubstituted heterocycloalkyl group having 2 to 60 carbon atoms; a substituted or unsubstituted aryl group having 6 to 60 carbon atoms; or a substituted or unsubstituted heteroaryl group having 2 to 60 carbon atoms,
R3 and R4 are the same as or different from each other, and are each independently hydrogen; deuterium; a halogen group; a cyano group; a substituted or unsubstituted alkyl group having 1 to 60 carbon atoms; a substituted or unsubstituted cycloalkyl group having 3 to 60 carbon atoms; a substituted or unsubstituted heterocycloalkyl group having 2 to 60 carbon atoms; a substituted or unsubstituted aryl group having 6 to 60 carbon atoms; or a substituted or unsubstituted heteroaryl group having 2 to 60 carbon atoms, or two or more adjacent groups are bonded to each other to form a substituted or unsubstituted ring,
11 to l4 are the same as or different from each other, and are each independently an integer from 1 to 3, and when l1 to l4 are each an integer of 2 or higher, the types of substituents in the parenthesis are the same as or different from each other,
r1 is an integer from 0 to 6,
each of r2 to r4 is an integer from 0 to 4,
the sum of r1 and r2 is 8,
the sum of r3 and r4 is 6,
when each of l1 to l4 and r1 to r4 is an integer of 2 or higher, substituents in the parenthesis are the same as or different from each other,
N-Het1 is represented by the following Chemical Formula N, 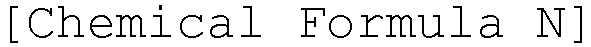 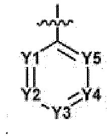
in Chemical Formula N, 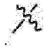 means a moiety linked to L3,
Y1 to Y5 are the same as or different from each other, and are each independently CRa or N, and at least one is N, and
Ra is a substituted or unsubstituted aryl group having 6 to 60 carbon atoms; or a substituted or unsubstituted heteroaryl group having 2 to 60 carbon atoms.

Another exemplary embodiment provides a composition for an organic material layer of an organic light emitting device, the composition including: the heterocyclic compound represented by Chemical Formula A; and the heterocyclic compound represented by Chemical Formula B.

The final exemplary embodiment of the present specification provides a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the above-described composition for an organic material layer of an organic light emitting device.

An organic light emitting device according to an exemplary embodiment of the present application includes an organic material layer, and the organic material layer includes the heterocyclic compound represented by Chemical Formula A and the heterocyclic compound represented by Chemical Formula B. Further, in a composition for an organic material layer of an organic light emitting device according to an exemplary embodiment of the present application, the heterocyclic compound represented by Chemical Formula A and the heterocyclic compound represented by Chemical Formula B can be used as materials for an organic material layer of an organic light emitting device. More specifically, the organic material layer of the organic light emitting device and the composition for an organic material layer of an organic light emitting device are characterized by including a heterocyclic compound represented by Chemical Formula A as a P-type host material and a heterocyclic compound represented by Chemical Formula B as an N-type host material.

When a heterocyclic compound represented by Chemical Formula A, which can be used as a unipolar P-type host material with excellent hole mobility, and a compound represented by Chemical Formula B, which can be used as a unipolar N-type host material with excellent electron mobility, are mixed at an appropriate ratio and used as materials for the device, hole transport characteristics and electron transport characteristics can be maximized because it is easy to adjust the number of holes and electrons in the emission layer in a well-balanced manner, and as a result, it can be confirmed that the efficiency and service life of the device are improved because the exciton generation efficiency is increased. This is because it is easier to adjust the charge density by adjusting the ratio compared to when using a single bipolar type host or a composition with a different combination such as two or more premixed compositions, a p-type host and an n-type host can be combined at various ratios, and through the various combinations, many mixed host systems can be developed, which is advantageous for improving device characteristics.

Accordingly, when the composition for an organic material layer is used for an organic light emitting device or an organic light emitting device is manufactured, the driving voltage of the device can be lowered, the light efficiency of the device can be improved, the thermal stability of the compound can be improved, and the service life characteristics of the device can be improved.

### BRIEF DESCRIPTION OF THE DRAWINGS

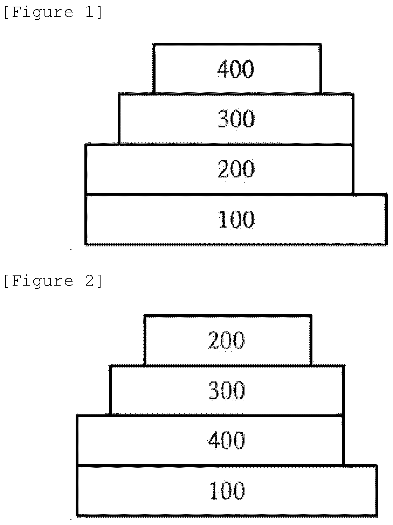

FIGS. 1 to 3 are views each exemplarily illustrating a stacking structure of an organic light emitting device according to an exemplary embodiment of the present specification.

### DETAILED DESCRIPTION

Hereinafter, the present specification will be described in more detail.

When one part "includes" one constituent element in the present specification, unless otherwise specifically described, this does not mean that another constituent element is excluded, but means that another constituent element may be further included.

In the present specification, 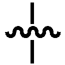 of a chemical formula means a position to be bonded.

The term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more are substituted, the two or more substituents may be the same as or different from each other.

In the present specification, "substituted or unsubstituted" means being unsubstituted or substituted with one or more substituents selected from the group consisting of deuterium; a halogen group; a cyano group; an alkyl group having 1 to 60 carbon atoms; an alkenyl group having 2 to 60 carbon atoms; an alkynyl group having 2 to 60 carbon atoms; a cycloalkyl group having 3 to 60 carbon atoms; a heterocycloalkyl group having 2 to 60 carbon atoms; an aryl group having 6 to 60 carbon atoms; a heteroaryl group having 2 to 60 carbon atoms; a silyl group; a phosphine oxide group; and an amine group, or with a substituent to which two or more substituents selected among the exemplified substituents are linked.

In the present specification, "when a substituent is not indicated in the structure of a chemical formula or compound" means that a hydrogen atom is bonded to a carbon atom. However, since deuterium (²H) or tritium corresponds to an isotope of hydrogen, it may be interpreted as a concept included in hydrogen, as long as it is not explicitly excluded.

That is, in the present application, deuterium exhibits an effect equivalent to that of hydrogen in terms of driving voltage, light emitting efficiency, and service life, or exhibits improved effects in some evaluation criteria, according to Chem. Commun., 2014, 50, 14870, and since the effect falls within the scope that a person with ordinary skill in the art may be predicted to have the equivalent effect without conducting specific experiments, deuterium, an isotope of hydrogen, is interpreted as a concept included in hydrogen, as long as it is not explicitly excluded.

According to an exemplary embodiment of the present specification, "when a substituent is not indicated in the structure of a chemical formula or compound" may mean that all the positions that may be reached by the substituent are hydrogen; or deuterium. That is, deuterium is an isotope of hydrogen, and some hydrogen atoms may be deuterium which is an isotope, and in this case, the content of deuterium may be 0% to 100%.

According to an exemplary embodiment of the present specification, in "the case where a substituent is not indicated in the structure of a chemical formula or compound", when the content of deuterium is 0%, the content of hydrogen is 100%, and all the substituents do not explicitly exclude deuterium such as hydrogen, hydrogen and deuterium may be mixed and used in the compound.

According to an exemplary embodiment of the present specification, deuterium is one of the isotopes of hydrogen, is an element that has a deuteron composed of one proton and one neutron as a nucleus, and may be represented by hydrogen-2, and the element symbol may also be expressed as D or ²H.

According to an exemplary embodiment of the present specification, the isotope means an atom with the same atomic number (Z), but different mass numbers (A), and may also be interpreted as an element which has the same number of protons, but different number of neutrons.

According to an exemplary embodiment of the present specification, when the total number of substituents of a basic compound is defined as T1 and the number of specific substituents among the substituents is defined as T2, the content T% of the specific substituent may be defined as T2/T1×100 = T%.

That is, when taking a phenyl group represented by 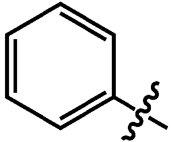 as an example, herein, a deuterium content of 20% may be represented by 20% when the total number of substituents that the phenyl group can have is 5 (T1 in the formula) and the number of deuterium atoms among the substituents is 1 (T2 in the formula). That is, a deuterium content of 20% in the phenyl group may be represented by the following structural formula.

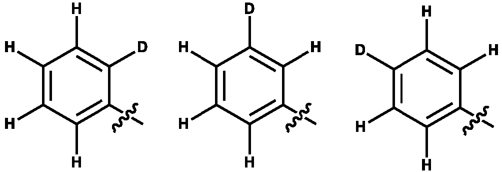

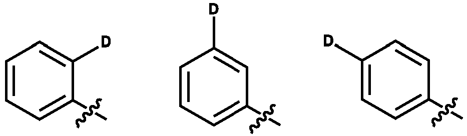

Further, according to an exemplary embodiment of the present specification, "a phenyl group having a deuterium content of 0%" may mean a phenyl group that does not include a deuterium atom, that is, has five hydrogen atoms.

In the present specification, the halogen may be fluorine, chlorine, bromine or iodine.

In the present specification, the alkyl group includes a straight-chain or branched-chain having 1 to 60 carbon atoms, and may be additionally substituted with another substituent. The number of carbon atoms of the alkyl group may be 1 to 60, specifically 1 to 40, and more specifically 1 to 20. Specific examples thereof include a methyl group, an ethyl group, a propyl group, an n-propyl group, an isopropyl group, a butyl group, an n-butyl group, an isobutyl group, a tert-butyl group, a sec-butyl group, a 1-methylbutyl group, a 1-ethyl-butyl group, a pentyl group, an n-pentyl group, an isopentyl group, a neopentyl group, a tert-pentyl group, a hexyl group, an n-hexyl group, a 1-methylpentyl group, a 2-methylpentyl group, a 4-methyl-2-pentyl group, a 3,3-dimethylbutyl group, a 2-ethylbutyl group, a heptyl group, an n-heptyl group, a 1-methylhexyl group, a cyclopentylmethyl group, a cyclohexylmethyl group, an octyl group, an n-octyl group, a tert-octyl group, a 1-methylheptyl group, a 2-ethylhexyl group, a 2-propylpentyl group, an n-nonyl group, a 2,2-dimethylheptyl group, a 1-ethyl-propyl group, a 1,1-dimethyl-propyl group, an isohexyl group, a 2-methylpentyl group, a 4-methylhexyl group, a 5-methylhexyl group, and the like, but are not limited thereto.

In the present specification, the alkenyl group includes a straight-chain or branched-chain having 2 to 60 carbon atoms, and may be additionally substituted with another substituent. The number of carbon atoms of the alkenyl group may be 2 to 60, specifically 2 to 40, and more specifically 2 to 20. Specific examples thereof include a vinyl group, a 1-propenyl group, an isopropenyl group, a 1-butenyl group; a 2-butenyl group; a 3-butenyl group, a 1-pentenyl group, a 2-pentenyl group, a 3-pentenyl group, a 3-methyl-1-butenyl group, a 1,3-butadienyl group, an allyl group, a 1-phenylvinyl-1-yl group, a 2-phenylvinyl-1-yl group, a 2,2-diphenylvinyl-1-yl group, a 2-phenyl-2-(naphthyl-1-yl)vinyl-1-yl group, a 2,2-bis(diphenyl-1-yl)vinyl-1-yl group, a stilbenyl group, a styrenyl group and the like, but are not limited thereto.

In the present specification, the alkynyl group includes a straight-chain or branched-chain having 2 to 60 carbon atoms, and may be additionally substituted with another substituent. The number of carbon atoms of the alkynyl group may be 2 to 60, specifically 2 to 40, and more specifically 2 to 20.

In the present specification, an alkoxy group may be straight-chained, branched, or cyclic. The number of carbon atoms of the alkoxy group is not particularly limited, but is preferably 1 to 20. Specific examples thereof include methoxy, ethoxy, n-propoxy, isopropoxy, n-butoxy, isobutoxy, tert-butoxy, sec-butoxy, n-pentyloxy, neopentyloxy, isopentyloxy, n-hexyloxy, 3,3-dimethylbutyloxy, 2-ethylbutyloxy, n-octyloxy, n-nonyloxy, n-decyloxy, benzyloxy, p-methylbenzyloxy, and the like, but are not limited thereto.

In the present specification, the cycloalkyl group includes a monocycle or polycycle having 3 to 60 carbon atoms, and may be additionally substituted with another substituent. Here, the polycycle means a group in which a cycloalkyl group is directly linked to or fused with another cyclic group. Here, another cyclic group may also be a cycloalkyl group, but may also be another kind of cyclic group, for example, a heterocycloalkyl group, an aryl group, a heteroaryl group, and the like. The number of carbon atoms of the cycloalkyl group may be 3 to 60, specifically 3 to 40, and more specifically 5 to 20. Specific examples thereof include a cyclopropyl group, a cyclobutyl group, a cyclopentyl group, a 3-methylcyclopentyl group, a 2,3-dimethylcyclopentyl group, a cyclohexyl group, a 3-methylcyclohexyl group, a 4-methylcyclohexyl group, a 2,3-dimethylcyclohexyl group, a 3,4,5-trimethylcyclohexyl group, a 4-tert-butylcyclohexyl group, a cycloheptyl group, a cyclooctyl group, and the like, but are not limited thereto.

In the present specification, the heterocycloalkyl group includes O, S, Se, N, or Si as a heteroatom, includes a monocycle or polycycle having 2 to 60 carbon atoms, and may be additionally substituted with another substituent. Here, the polycycle means a group in which a heterocycloalkyl group is directly linked to or fused with another cyclic group. Here, another cyclic group may also be a heterocycloalkyl group, but may also be another kind of cyclic group, for example, a cycloalkyl group, an aryl group, a heteroaryl group, and the like. The number of carbon atoms of the heterocycloalkyl group may be 2 to 60, specifically 2 to 40, and more specifically 3 to 20.

In the present specification, the aryl group includes a monocycle or polycycle having 6 to 60 carbon atoms, and may be additionally substituted with another substituent. Here, the polycycle means a group in which an aryl group is directly linked to or fused with another cyclic group. Here, another cyclic group may also be an aryl group, but may also be another kind of cyclic group, for example, a cycloalkyl group, a heterocycloalkyl group, a heteroaryl group, and the like. The aryl group includes a spiro group. The number of carbon atoms of the aryl group may be 6 to 60, specifically 6 to 40, and more specifically 6 to 25. Specific examples of the aryl group include a phenyl group, a biphenyl group, a terphenyl group, a naphthyl group, an anthryl group, a chrysenyl group, a phenanthrenyl group, a perylenyl group, a fluoranthenyl group, a triphenylenyl group, a phenalenyl group, a pyrenyl group, a tetracenyl group, a pentacenyl group, a fluorenyl group, an indenyl group, an acenaphthylenyl group, a benzofluorenyl group, a spirobifluorenyl group, a 2,3-dihydro-1H-indenyl group, a fused cyclic group thereof, and the like, but are not limited thereto.

In the present specification, the terphenyl group may be selected from the following structures.

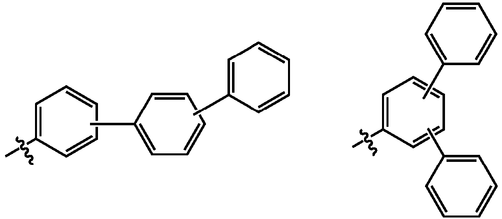

In the present specification, the fluorenyl group may be substituted, and adjacent substituents may be bonded to each other to form a substituted or unsubstituted ring. When the fluorenyl group is substituted, the substituent may be selected from the following structures, but is not limited thereto.

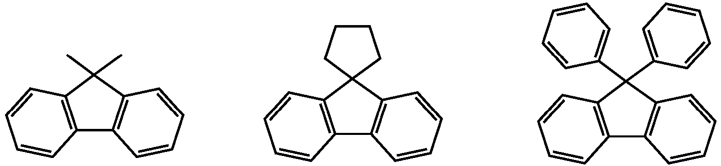

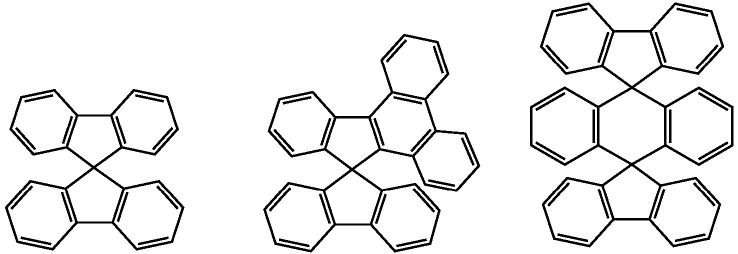

In the present specification, the heteroaryl group includes S, O, Se, N, or Si as a heteroatom, includes a monocycle or a polycycle having 2 to 60 carbon atoms, and may be additionally substituted with another substituent. Here, the polycycle means a group in which a heteroaryl group is directly linked to or fused with another cyclic group. Here, another cyclic group may also be a heteroaryl group, but may also be another kind of cyclic group, for example, a cycloalkyl group, a heterocycloalkyl group, an aryl group, and the like. The number of carbon atoms of the heteroaryl group may be 2 to 60, specifically 2 to 40, and more specifically 3 to 25. Specific examples of the heteroaryl group include a pyridyl group, a pyrrolyl group, a pyrimidyl group, a pyridazinyl group, a furanyl group, a thiophene group, an imidazolyl group, a pyrazolyl group, an oxazolyl group, an isoxazolyl group, a thiazolyl group, an isothiazolyl group, a triazolyl group, a furazanyl group, an oxadiazolyl group, a thiadiazolyl group, a dithiazolyl group, a tetrazolyl group, a pyranyl group, a thiopyranyl group, a diazinyl group, an oxazinyl group, a thiazinyl group, a dioxynyl group, a triazinyl group, a tetrazinyl group, a quinolyl group, an isoquinolyl group, a quinazolinyl group, an isoquinazolinyl group, a quinozolilyl group, a naphthyridyl group, an acridinyl group, a phenanthridinyl group, an imidazopyridinyl group, a diaza naphthalenyl group, a triazaindene group, an indolyl group, an indolizinyl group, a benzothiazolyl group, a benzoxazolyl group, a benzimidazolyl group, a benzothiophene group, a benzofuran group, a dibenzothiophene group, a dibenzofuran group, a carbazolyl group, a benzocarbazolyl group, a dibenzocarbazolyl group, a phenazinyl group, a dibenzosilole group, spirobi (dibenzosilole), a dihydrophenazinyl group, a phenoxazinyl group, a phenanthridyl group, an imidazopyridinyl group, a thienyl group, an indolo[2,3-a]carbazolyl group, an indolo[2,3-b]carbazolyl group, an indolinyl group, a 10,11-dihydro-dibenzo[b,f]azepin group, a 9,10-dihydroacridinyl group, a phenanthrazinyl group, a phenothiathiazinyl group, a phthalazinyl group, a naphthylidinyl group, a phenanthrolinyl group, a benzo[c] [1,2,5]thiadiazolyl group, a 2,3-dihydrobenzo[b]thiophene group, a 2,3-dihydrobenzofuran group, a 5,10-dihydrodibenzo[b,e] [1,4]azasilinyl group, a pyrazolo[1,5-c]quinazolinyl group, a pyrido[1,2-b]indazolyl group, a pyrido[1,2-a]imidazo[1,2-e]indolinyl group, a 5,11-dihydroindeno[1,2-b]carbazolyl group, and the like, but are not limited thereto.

In the present specification, when the substituent is a carbazole group, it means being bonded to nitrogen or carbon of carbazole.

In the present specification, when a carbazole group is substituted, an additional substituent may be substituted with the nitrogen or carbon of the carbazole.

In the present specification, a benzocarbazole group may be any one of the following structures.

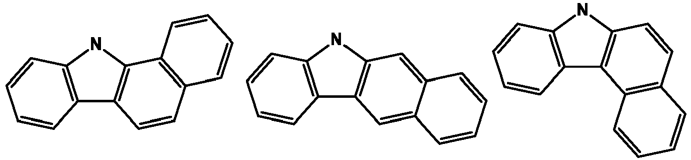

In the present specification, a dibenzocarbazole group may be any one of the following structures.

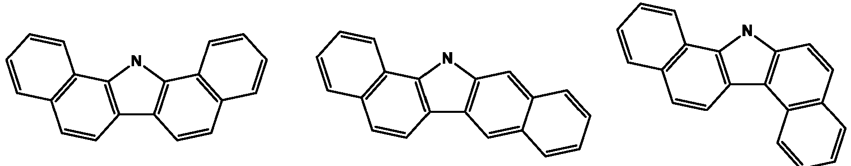

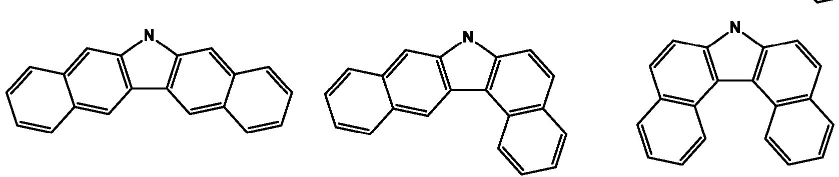

In the present specification, a naphthobenzofuran group may be any one of the following structures.

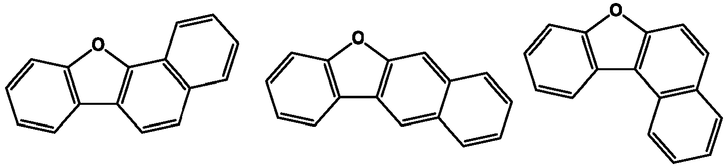

In the present specification, a naphthobenzothiophene group may be any one of the following structures.

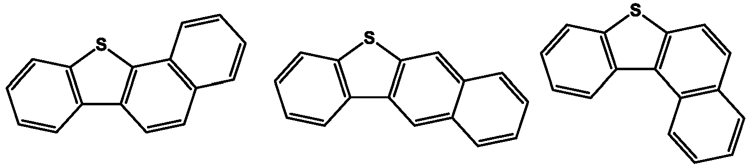

In the present specification, a silyl group includes Si and is a substituent to which the Si atom is directly linked as a radical, and is represented by - Si(R101) (R102) (R103), and R101 to R103 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group.

Specific examples of the silyl group include 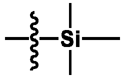 (a trimethylsilyl group), 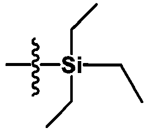 (a triethylsilyl group), 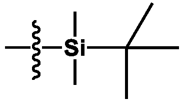 (a t-butyldimethylsilyl group), 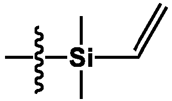 (a vinyldimethylsilyl group), 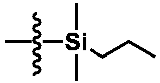 (a propyldimethylsilyl group), 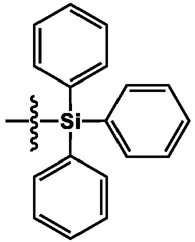 (a triphenylsilyl group), 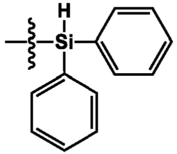 (a diphenylsilyl group), 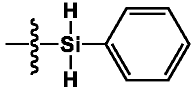 (a phenylsilyl group) and the like, but are not limited thereto.

In the present specification, the phosphine oxide group is represented by -P(=O) (R104) (R105), and R104 and R105 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. Specifically, the phosphine oxide group may be substituted with an alkyl group or an aryl group, and the above-described example may be applied to the alkyl group and the aryl group. Examples of the phosphine oxide group include a dimethylphosphine oxide group, a diphenylphosphine oxide group, a dinaphthylphosphine oxide group, and the like, but are not limited thereto.

In the present specification, the amine group is represented by -N(R106) (R107), and R106 and R107 are the same as or different from each other, and may be each independently a substituent composed of at least one of hydrogen; deuterium; a halogen group; an alkyl group; an alkenyl group; an alkoxy group; a cycloalkyl group; a heterocycloalkyl group; an aryl group; and a heteroaryl group. The amine group may be selected from the group consisting of -NH₂; a monoalkylamine group; a monoarylamine group; a monoheteroarylamine group; a dialkylamine group; a diarylamine group; a diheteroarylamine group; an alkylarylamine group; an alkylheteroarylamine group; and an arylheteroarylamine group, and the number of carbon atoms thereof is not particularly limited, but is preferably 1 to 30. Specific examples of the amine group include a methylamine group, a dimethylamine group, an ethylamine group, a diethylamine group, a phenylamine group, a naphthylamine group, a biphenylamine group, a dibiphenylamine group, an anthracenylamine group, a 9-methyl-anthracenylamine group, a diphenylamine group, a phenylnaphthylamine group, a ditolylamine group, a phenyltolylamine group, a triphenylamine group, a biphenylnaphthylamine group, a phenylbiphenylamine group, a biphenylfluorenylamine group, a phenyltriphenylenylamine group, a biphenyltriphenylenylamine group, and the like, but are not limited thereto.

In the present specification, the above-described examples of the aryl group may be applied to an arylene group except for a divalent arylene group.

In the present specification, the above-described examples of the heteroaryl group may be applied to a heteroarylene group except for a divalent heteroarylene group.

In the present specification, an "adjacent" group may mean a substituent substituting an atom directly linked to an atom substituted by the corresponding substituent, a substituent sterically most closely positioned to the corresponding substituent, or another substituent substituting an atom substituted by the corresponding substituent. For example, two substituents substituted at the ortho position in a benzene ring and two substituents substituted at the same carbon in an aliphatic ring may be interpreted as groups which are "adjacent" to each other.

Hydrocarbon rings and hetero rings that adjacent groups may form include an aliphatic hydrocarbon ring, an aromatic hydrocarbon ring, an aliphatic hetero ring and an aromatic hetero ring, and structures exemplified by the above-described cycloalkyl group, aryl group, heterocycloalkyl group and heteroaryl group may be each applied to the rings, except for those that are not monovalent groups.

In an exemplary embodiment of the present specification, a group not represented by a substituent; or a group represented by hydrogen may mean a group all substitutable with deuterium. That is, it may be shown that hydrogen (H); or deuterium (D) can be substituted with each other.

In general, compounds bonded with hydrogen and compounds substituted with deuterium exhibit a difference in thermodynamic behavior. The reason for this is that the mass of a deuterium atom is 2-fold higher than that of hydrogen, but due to the difference in the mass of atoms, deuterium is characterized by having even lower vibration energy.

Further, the single bond dissociation energy of carbon and deuterium is higher than the single bond dissociation energy of carbon and hydrogen. Accordingly, the deuterium-substituted structure has an effect of increasing the thermal stability of the molecule and improving the service life of the device using the increased thermal stability.

When a compound is deposited on a silicon wafer, a material including deuterium tends to be packed so that the intermolecular distance is reduced. Further, when the surface of a thin film is observed using an atomic force microscope (AFM), it can be confirmed that the thin film made of a compound including deuterium is deposited with a more uniform surface without any aggregated portion.

### <Organic light emitting device>

Hereinafter, the organic light emitting device according to the present specification will be described.

The organic material layer of an organic light emitting device according to an exemplary embodiment of the present specification includes a heterocyclic compound represented by the following Chemical Formula A.

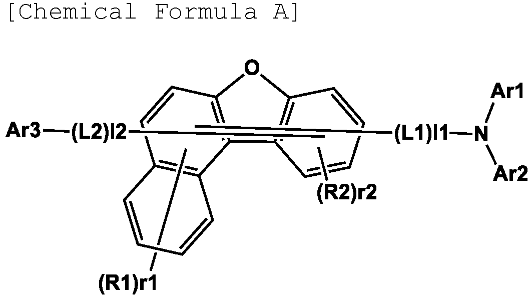

In Chemical Formula A, the description of each substituent is as described above.

The heterocyclic compound represented by Chemical Formula A is a 2-substituted naphthobenzofuran, the first substituent 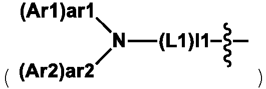 acts as a donor unit to increase the electron density of an aromatic unit, shift the HOMO energy level toward the vacuum level, and enhance the hole generation characteristics, and the second substituent 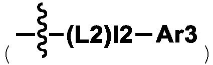 is substituted at various positions of the core skeleton to change the thermal characteristics of the material, such as the glass transition temperature and thermal decomposition temperature, thereby increasing the thermal stability and changing the length and molecular orientation of a conjugated structure to improve the hole characteristics, so that it is possible to exhibit characteristics that are excellent in electron and charge transport characteristics as a whole.

When a heterocyclic compound represented by Chemical Formula A, which has excellent hole transport characteristics, is used together with a heterocyclic compound represented by Chemical Formula B, which has fast electron transport characteristics, the heterocyclic compound represented by Chemical Formula A acts as a P-type host material to easily adjust the number of holes and electrons in the organic material layer (particularly, an emission layer (EML)) in a well-balanced manner, so that it is possible to maximize hole transport characteristics and electron transport characteristics. Therefore, degradation caused by the accumulation of electrons and holes does not occur because charge balance occurs in the organic material layer, and as a result, exciton generation efficiency increases, so that it is possible to exhibit high efficiency and long service life characteristics.

The organic material layer of an organic light emitting device according to an exemplary embodiment of the present specification includes a heterocyclic compound represented by the following Chemical Formula B.

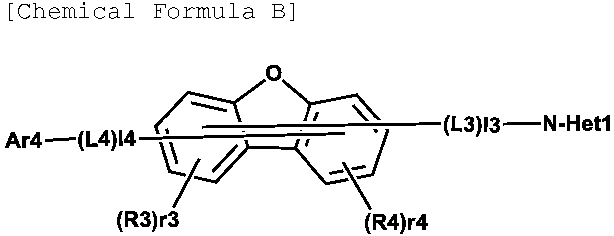

In Chemical Formula B, the description of each substituent is as described above.

The compound represented by Chemical Formula B is 2-substituted as an oxygen-containing fused heterocyclic ring (dibenzofuran) having 3 or more rings, N-Het1 (is represented by structural formula N, and corresponds to triazine, and the like) in the first substituent 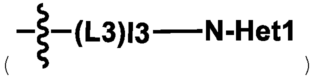 acts as an acceptor unit to lower the electron density of an aromatic unit, deepen the LUMO energy level, and enhance the electron transfer characteristics, and Ar4 in the second substituent 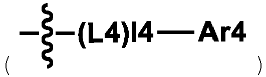 is substituted at various positions of the core skeleton to increase the thermal stability by changing the thermal characteristics of the material, such as glass transition temperature and thermal decomposition temperature and to improve hole characteristics by changing the length and molecular orientation of a conjugated structure, so that it is possible to exhibit high efficiency due to excellent electron and hole transport characteristics as a whole.

When a heterocyclic compound represented by Chemical Formula B with fast electron transport characteristics is used together with a heterocyclic compound represented by Chemical Formula A with excellent hole transport characteristics, the heterocyclic compound represented by Chemical Formula B acts as an N-type host material, and excitons are generated between the two hosts due to the large difference between HOMO and LUMO of the two hosts in the organic material layer (particularly the emission layer (EML)) and shows exciplex characteristics that form a charge transport complex in the excited state, so that there is an effect in that the driving voltage is lowered by the strong hole and electron transport characteristics and an exciplex is formed between the two hosts, thereby allowing the energy transfer process to be exhibited dominantly during the light emission process. When the two compounds are used in combination, charge balance is maintained and electron injection and movement are facilitated, so that high efficiency and low driving voltage may be simultaneously implemented and excellent service life characteristics may also be exhibited.

The compound according to exemplary embodiments may have low driving voltage, high light emitting efficiency, and/or long service life characteristics when used in an organic light emitting device.

According to an exemplary embodiment of the present specification, Chemical Formula A may be represented by the following Chemical Formula A-1.

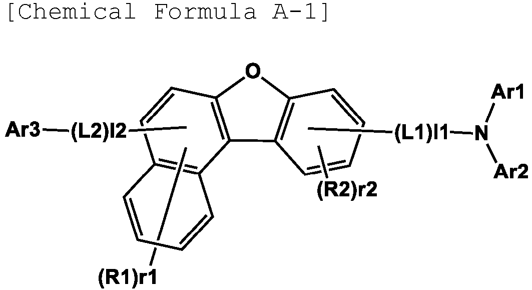

In Chemical Formula A-1,
each of L1, L2, Ar1 to Ar3, R1, R2, l1, l2, r1, and r2 is the same as that defined in Chemical Formula A.

According to an exemplary embodiment of the present specification, Chemical Formula A may be represented by any one of the following Chemical Formulae A-101 to A-108.

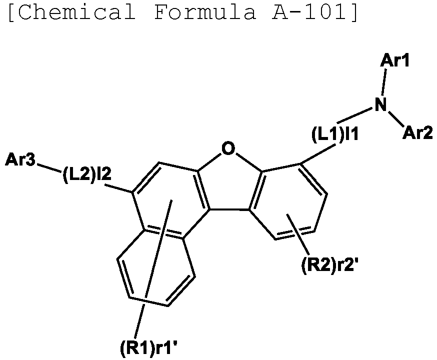

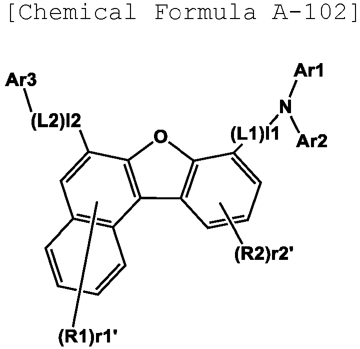

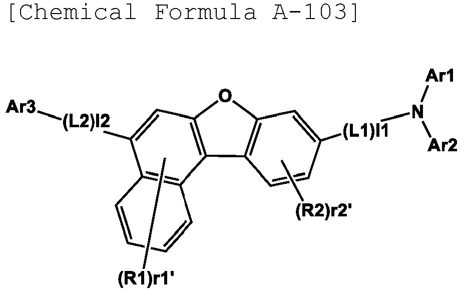

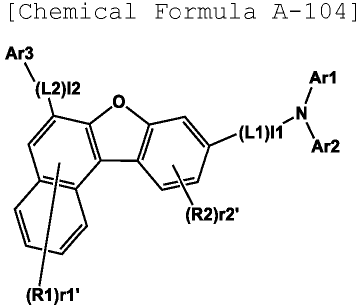

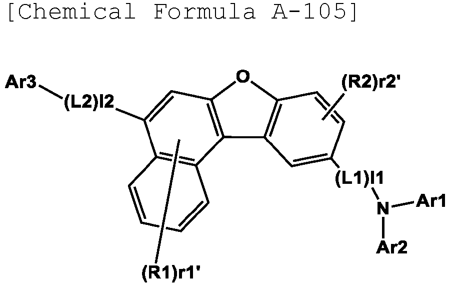

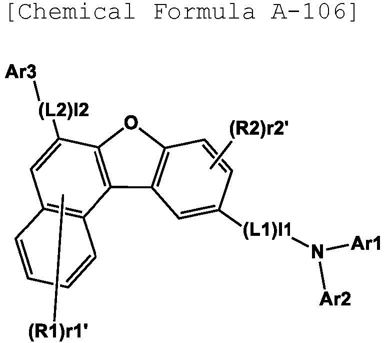

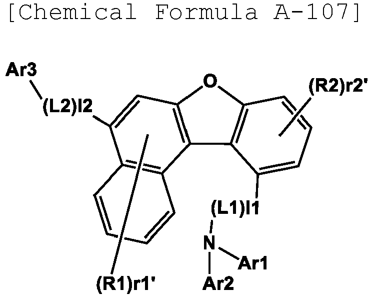

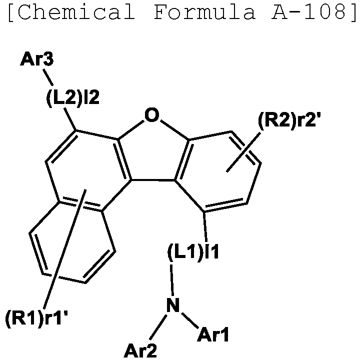

In Chemical Formulae A-101 to A-108,
each of L1, L2, Ar1 to Ar3, R1, R2, l1, l2, r1, and r2 is the same as that defined in Chemical Formula A,
r1' is an integer from 0 to 5,
r2' is an integer from 0 to 3, and
when each of r1' and r2' is an integer of 2 or higher, the types of substituents in the parenthesis are the same as or different from each other.

According to an exemplary embodiment of the present specification, Chemical Formula B may be represented by any one of the following Chemical Formulae B-1 or B-2.

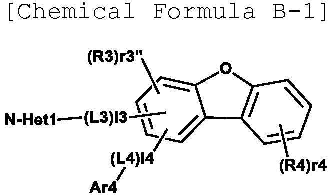

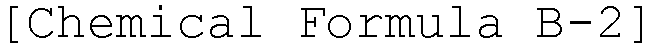

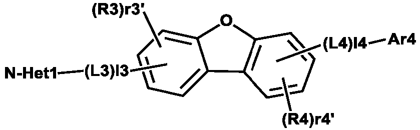

In Chemical Formulae B-1 and B-2,
each of L3, L4, Ar4, N-Het1, R3, R4, l3, l4, and r4 is the same as that defined in Chemical Formula B,
r3' is an integer from 0 to 3, and when r3' is an integer of 2 or higher, R3's are the same as or different from each other,
r3" is an integer from 0 to 2, and when r3" is 2, R3's are the same as or different from each other, and
r4' is an integer from 0 to 3, and when r4' is an integer of 2 or higher, R4's are the same as or different from each other.

According to an exemplary embodiment of the present specification, Chemical Formula B may be represented by the following Chemical Formula B-11 or B-12.

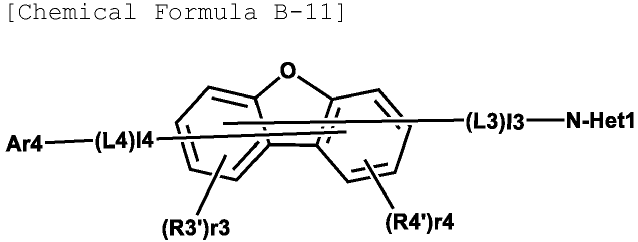

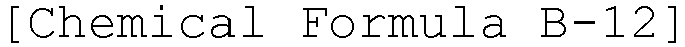

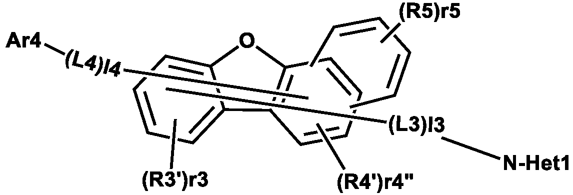

In Chemical Formulae B-11 and B-12,
each of L3, L4, Ar4, N-Het1, r3, r4, l3, and l4 is the same as that defined in Chemical Formula B,
R3', R4', and R5 are the same as or different from each other, and are each independently hydrogen; deuterium; a halogen group; a cyano group; a substituted or unsubstituted alkyl group having 1 to 60 carbon atoms; a substituted or unsubstituted cycloalkyl group having 3 to 60 carbon atoms; a substituted or unsubstituted heterocycloalkyl group having 2 to 60 carbon atoms; a substituted or unsubstituted aryl group having 6 to 60 carbon atoms; or a substituted or unsubstituted heteroaryl group having 2 to 60 carbon atoms,
r4" is an integer from 0 to 2, and when r4" is 2, R4"s are the same as or different from each other, and
r5 is an integer from 0 to 4, and when r5 is an integer of 2 or higher, R5's are the same as or different from each other.

According to an exemplary embodiment of the present specification, Chemical Formula B may be represented by any one of the following Chemical Formulae B-101 to B-115.

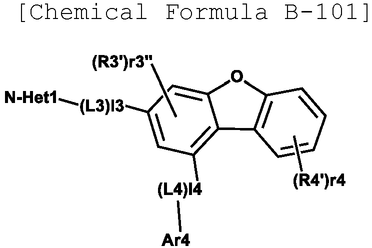

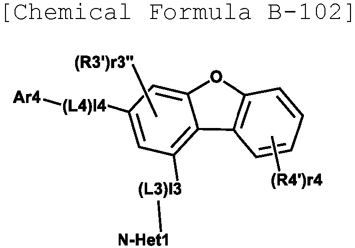

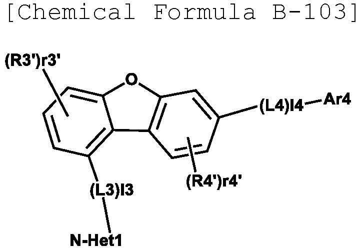

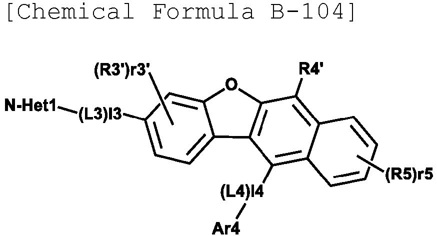

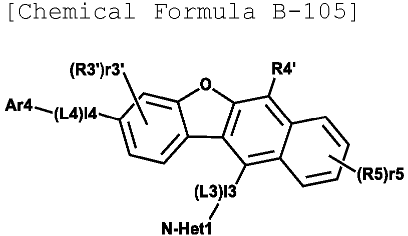

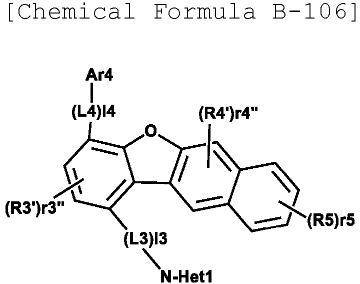

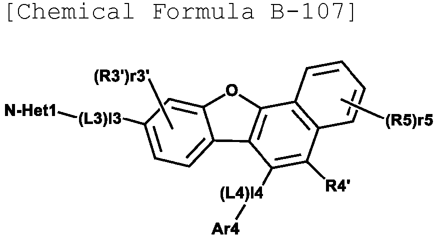

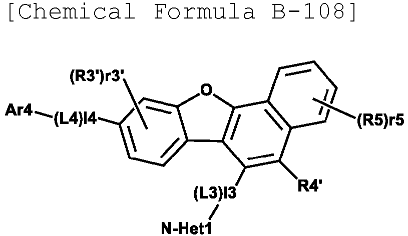

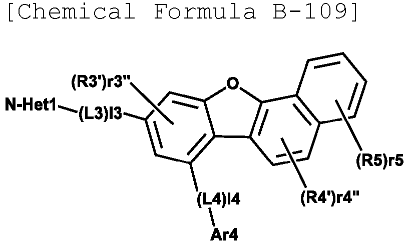

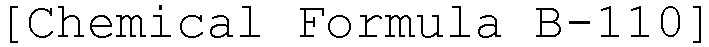

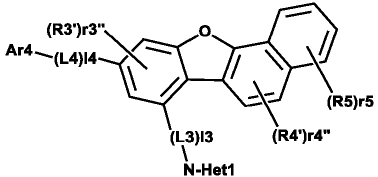

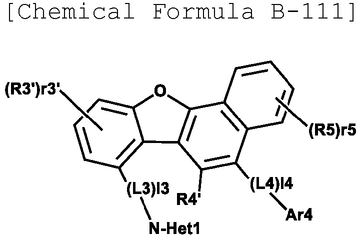

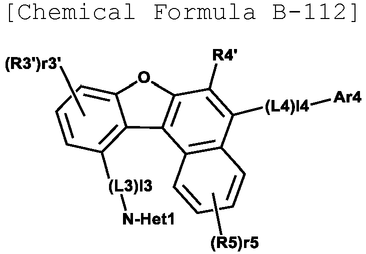

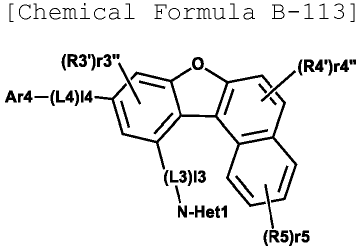

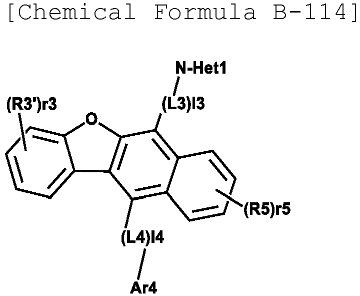

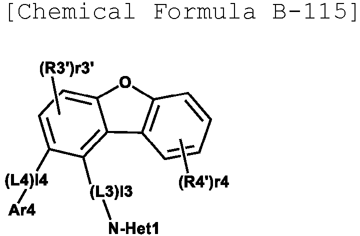

In Chemical Formulae B-101 to B-115,
each of L3, L4, Ar4, N-Het1, r3, r4, l3, and l4 is the same as that defined in Chemical Formula B,
R3', R4', and R5 are the same as or different from each other, and are each independently hydrogen; deuterium; a halogen group; a cyano group; a substituted or unsubstituted alkyl group having 1 to 60 carbon atoms; a substituted or unsubstituted cycloalkyl group having 3 to 60 carbon atoms; a substituted or unsubstituted heterocycloalkyl group having 2 to 60 carbon atoms; a substituted or unsubstituted aryl group having 6 to 60 carbon atoms; or a substituted or unsubstituted heteroaryl group having 2 to 60 carbon atoms,
r3' is an integer from 0 to 3, and when r3' is an integer of 2 or higher, R3"s are the same as or different from each other,
r3" is an integer from 0 to 2, and when r3" is 2, R3"s are the same as or different from each other,
r4' is an integer from 0 to 3, and when r4' is an integer of 2 or higher, R4"s are the same as or different from each other,
r4" is an integer from 0 to 2, and when r4" is 2, R4"s are the same as or different from each other, and
r5 is an integer from 0 to 4, and when r5 is an integer of 2 or higher, R5's are the same as or different from each other.

According to an exemplary embodiment of the present specification, L1 to L4 are the same as or different from each other, and may be each independently a direct bond; a substituted or unsubstituted arylene group having 6 to 40 carbon atoms; or a substituted or unsubstituted heteroarylene group having 2 to 40 carbon atoms.

According to an exemplary embodiment of the present specification, L1 to L4 are the same as or different from each other, and may be each independently a direct bond; or a substituted or unsubstituted arylene group having 6 to 30 carbon atoms.

According to an exemplary embodiment of the present specification, L1 to L4 are the same as or different from each other, and may be each independently a direct bond; or an arylene group having 6 to 30 carbon atoms, which is unsubstituted or substituted with deuterium.

According to an exemplary embodiment of the present specification, L1 to L4 are the same as or different from each other, and may be each independently a direct bond; a substituted or unsubstituted phenylene group; a substituted or unsubstituted biphenylene group; or a substituted or unsubstituted naphthylene group.

According to an exemplary embodiment of the present specification, L1 to L4 are the same as or different from each other, and may be each independently a direct bond; a phenylene group unsubstituted or substituted with deuterium; a biphenylene group unsubstituted or substituted with deuterium; or a naphthylene group unsubstituted or substituted with deuterium.

According to an exemplary embodiment of the present specification, Ar1 to Ar3 are the same as or different from each other, and may be each independently a substituted or unsubstituted aryl group having 6 to 40 carbon atoms; a substituted or unsubstituted heteroaryl group having 2 to 40 carbon atoms; or a combination thereof.

According to an exemplary embodiment of the present specification, Ar1 to Ar3 are the same as or different from each other, and may be each independently a substituted or unsubstituted aryl group having 6 to 30 carbon atoms; a substituted or unsubstituted heteroaryl group having 2 to 30 carbon atoms; or a combination thereof.

According to an exemplary embodiment of the present specification, Ar1 to Ar3 are the same as or different from each other, and may be each independently an aryl group having 6 to 30 carbon atoms, which is unsubstituted or substituted with a substituent selected from the group consisting of deuterium, an alkyl group, and an aryl group; a heteroaryl group having 2 to 30 carbon atoms, which is unsubstituted or substituted with a substituent selected from the group consisting of deuterium, an alkyl group, and an aryl group; or a combination thereof.

According to an exemplary embodiment of the present specification, Ar1 to Ar3 are the same as or different from each other, and may be each independently a phenyl group; a biphenyl group; a terphenyl group; a naphthyl group; a fluorenyl group; a spirobifluorenyl group; a phenathrenyl group; a dibenzofuranyl group; a dibenzothiophenyl group; a naphthobenzofuranyl group; a naphthobenzothiophenyl group; a carbazole group; or a combination thereof, which may be each independently unsubstituted or substituted with a substituent selected from the group consisting of deuterium, a halogen group, an alkyl group, and an aryl group.

According to an exemplary embodiment of the present specification, Ar4 may be a substituted or unsubstituted aryl group having 6 to 40 carbon atoms; a substituted or unsubstituted heteroaryl group having 2 to 40 carbon atoms; or a substituted or unsubstituted amine group.

According to an exemplary embodiment of the present specification, Ar4 is a substituted or unsubstituted aryl group having 6 to 30 carbon atoms; a substituted or unsubstituted heteroaryl group having 2 to 30 carbon atoms; or -NRbRc, and Rb and Rc are the same as or different from each other, and may be each independently hydrogen; deuterium; a substituted or unsubstituted alkyl group having 1 to 30 carbon atoms; a substituted or unsubstituted cycloalkyl group having 3 to 30 carbon atoms; a substituted or unsubstituted heterocycloalkyl group having 2 to 30 carbon atoms; a substituted or unsubstituted aryl group having 6 to 30 carbon atoms; or a substituted or unsubstituted heteroaryl group having 2 to 30 carbon atoms.

According to an exemplary embodiment of the present specification, Ar4 is an aryl group having 6 to 30 carbon atoms, which is unsubstituted or substituted with deuterium or an aryl group; a heteroaryl group having 2 to 30 carbon atoms, which is unsubstituted or substituted with deuterium or an aryl group; or -NRbRc, and Rb and Rc are the same as or different from each other, and may be each independently hydrogen; deuterium; an aryl group having 6 to 30 carbon atoms, which is unsubstituted or substituted with deuterium or an aryl group; or a heteroaryl group having 2 to 30 carbon atoms, which is unsubstituted or substituted with deuterium or an aryl group.

According to an exemplary embodiment of the present specification, Ar4 is an aryl group having 6 to 20 carbon atoms, which is unsubstituted or substituted with deuterium or an aryl group; a heteroaryl group having 2 to 20 carbon atoms, which is unsubstituted or substituted with deuterium or an aryl group; or -NRbRc, and Rb and Rc are the same as or different from each other, and may be each independently hydrogen; deuterium; an aryl group having 6 to 20 carbon atoms, which is unsubstituted or substituted with deuterium or an aryl group; or a heteroaryl group having 2 to 20 carbon atoms, which is unsubstituted or substituted with deuterium or an aryl group.

According to an exemplary embodiment of the present specification, Ar4 may be a phenyl group; a biphenyl group; a naphthyl group; a dibenzofuranyl group; a dibenzothiophenyl group; a 9-carbazole group; a 9-benzocarbazole group; or -NRbRc, the phenyl group; the biphenyl group; the naphthyl group; the dibenzofuranyl group; the dibenzothiophenyl group; the 9-carbazole group; and the 9-benzocarbazole group may be each independently unsubstituted or substituted with deuterium, a phenyl group, or a naphthyl group, and Rb and Rc are the same as or different from each other, and may be each independently hydrogen; deuterium; a phenyl group unsubstituted or substituted with deuterium; a biphenyl group unsubstituted or substituted with deuterium; a naphthyl group unsubstituted or substituted with deuterium; a dibenzofuranyl group unsubstituted or substituted with deuterium; or a dibenzothiophenyl group unsubstituted or substituted with deuterium.

According to an exemplary embodiment of the present specification, R1 and R2 are the same as or different from each other, and may be each independently hydrogen; deuterium; a halogen group; a cyano group; a substituted or unsubstituted alkyl group having 1 to 40 carbon atoms; a substituted or unsubstituted cycloalkyl group having 3 to 40 carbon atoms; a substituted or unsubstituted heterocycloalkyl group having 2 to 40 carbon atoms; a substituted or unsubstituted aryl group having 6 to 40 carbon atoms; or a substituted or unsubstituted heteroaryl group having 2 to 40 carbon atoms.

According to an exemplary embodiment of the present specification, R1 and R2 are the same as or different from each other, and may be each independently hydrogen; deuterium; a halogen group; a cyano group; a substituted or unsubstituted alkyl group having 1 to 30 carbon atoms; a substituted or unsubstituted cycloalkyl group having 3 to 30 carbon atoms; a substituted or unsubstituted heterocycloalkyl group having 2 to 30 carbon atoms; a substituted or unsubstituted aryl group having 6 to 30 carbon atoms; or a substituted or unsubstituted heteroaryl group having 2 to 30 carbon atoms.

According to an exemplary embodiment of the present specification, R1 and R2 are the same as or different from each other, and may be each independently hydrogen; deuterium; a halogen group; a cyano group; a substituted or unsubstituted alkyl group having 1 to 20 carbon atoms; a substituted or unsubstituted cycloalkyl group having 3 to 20 carbon atoms; a substituted or unsubstituted heterocycloalkyl group having 2 to 20 carbon atoms; a substituted or unsubstituted aryl group having 6 to 20 carbon atoms; or a substituted or unsubstituted heteroaryl group having 2 to 20 carbon atoms.

According to an exemplary embodiment of the present specification, R1 and R2 are the same as or different from each other, and may be each independently hydrogen; deuterium; a halogen group; a substituted or unsubstituted alkyl group having 1 to 20 carbon atoms; a substituted or unsubstituted cycloalkyl group having 3 to 20 carbon atoms; or a substituted or unsubstituted heterocycloalkyl group having 2 to 20 carbon atoms.

According to an exemplary embodiment of the present specification, R1 and R2 are the same as or different from each other, and may be each independently hydrogen; or deuterium.

According to an exemplary embodiment of the present specification, R3 and R4 are the same as or different from each other, and are each independently hydrogen; deuterium; a halogen group; a cyano group; a substituted or unsubstituted alkyl group having 1 to 40 carbon atoms; a substituted or unsubstituted cycloalkyl group having 3 to 40 carbon atoms; a substituted or unsubstituted heterocycloalkyl group having 2 to 40 carbon atoms; a substituted or unsubstituted aryl group having 6 to 40 carbon atoms; or a substituted or unsubstituted heteroaryl group having 2 to 40 carbon atoms, or two or more adjacent groups may be bonded to each other to form a substituted or unsubstituted ring.

According to an exemplary embodiment of the present specification, R3 and R4 are the same as or different from each other, and are each independently hydrogen; deuterium; a halogen group; a cyano group; a substituted or unsubstituted alkyl group having 1 to 30 carbon atoms; a substituted or unsubstituted cycloalkyl group having 3 to 30 carbon atoms; a substituted or unsubstituted heterocycloalkyl group having 2 to 30 carbon atoms; a substituted or unsubstituted aryl group having 6 to 30 carbon atoms; or a substituted or unsubstituted heteroaryl group having 2 to 30 carbon atoms, or two or more adjacent groups may be bonded to each other to form a substituted or unsubstituted aromatic ring having 6 to 30 carbon atoms.

According to an exemplary embodiment of the present specification, R3 and R4 are the same as or different from each other, and are each independently hydrogen; deuterium; or a substituted or unsubstituted alkyl group having 1 to 30 carbon atoms, or two or more adjacent groups may be bonded to each other to form a substituted or unsubstituted aromatic hydrocarbon ring having 6 to 30 carbon atoms.

According to an exemplary embodiment of the present specification, R3 and R4 are the same as or different from each other, and are each independently hydrogen; or deuterium, or two or more adjacent groups may be bonded to each other to form a benzene ring unsubstituted or substituted with deuterium.

In an exemplary embodiment of the present application, Chemical Formula N may be selected from the following structural formulae.

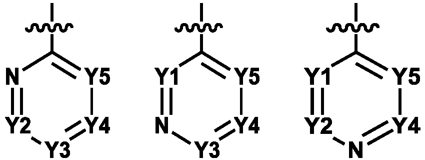

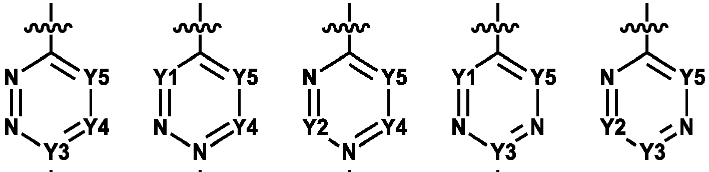

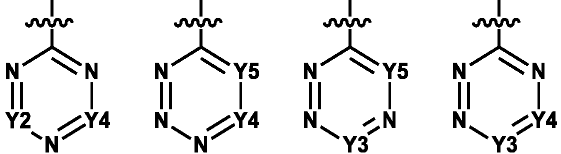

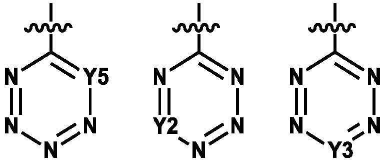

In the structural formulae,
the definitions of 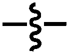 and Y1 to Y5 are the same as those defined in Chemical Formula N.

According to an exemplary embodiment of the present specification, Y1 to Y5 are the same as or different from each other, and are each independently CRa or N, and two or more groups may be N. In other words, the structural formula N may be any one of the following structures.

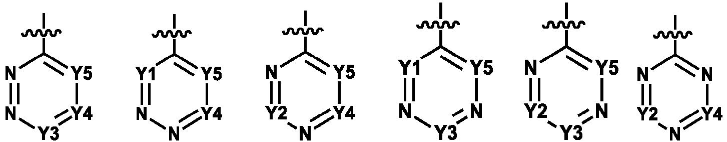

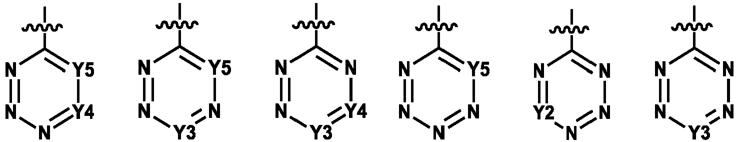

In the structural formulae, the definitions of 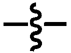 and Y1 to Y5 are the same as those defined in Chemical Formula N.

According to an exemplary embodiment of the present specification, Y1 to Y5 are the same as or different from each other, and are each independently CRa or N, and three groups may be N. In other words, the structural formula N may be any one of the following structures.

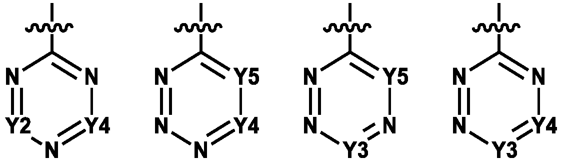

Preferably, the structural formula N may be

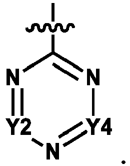

In the structural formulae, the definitions of 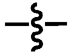 and Y2 to Y5 are the same as those defined in Chemical Formula N.

According to an exemplary embodiment of the present specification, Ra may be a substituted or unsubstituted aryl group having 6 to 30 carbon atoms; a substituted or unsubstituted heteroaryl group having 2 to 30 carbon atoms; or a combination thereof.

According to an exemplary embodiment of the present specification, Ra may be a substituted or unsubstituted aryl group having 6 to 20 carbon atoms; a substituted or unsubstituted heteroaryl group having 2 to 20 carbon atoms; or a combination thereof.

According to an exemplary embodiment of the present specification, Ra may be an aryl group having 6 to 20 carbon atoms, which is unsubstituted or substituted with a substituent selected from the group consisting of deuterium and an aryl group; a heteroaryl group having 2 to 20 carbon atoms, which is unsubstituted or substituted with deuterium; or a combination thereof.

According to an exemplary embodiment of the present specification, Ra may be a phenyl group unsubstituted or substituted with deuterium, a phenyl group, or a naphthyl group; a naphthyl group unsubstituted or substituted with deuterium or a phenyl group; a phenanthrenyl group unsubstituted or substituted with deuterium; a dibenzofuranyl group unsubstituted or substituted with deuterium; a dibenzothiophenyl group unsubstituted or substituted with deuterium; or a combination thereof.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 1% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 10% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 20% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 30% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 60% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 80% to 100%.

According to an exemplary embodiment of the present specification, the deuterium contents of the heterocyclic compound represented by Chemical Formula A and the heterocyclic compound represented by Chemical Formula B may be the same as or different from each other, and may be each independently 0% or 90% to 100%.

Chemical Formula A may be represented by any one of the following heterocyclic compounds.

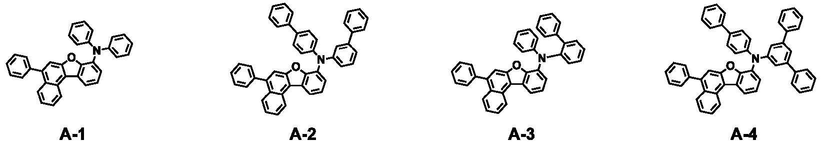

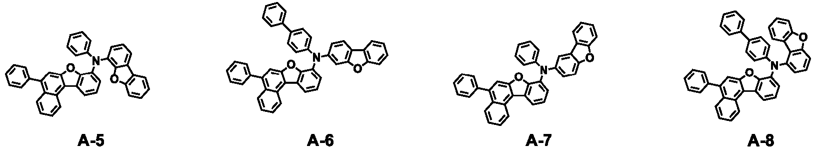

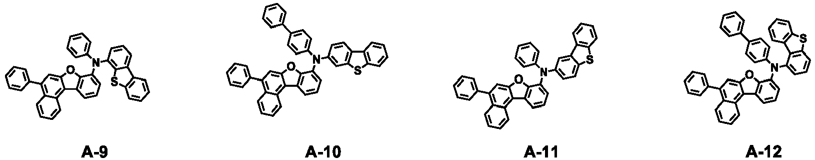

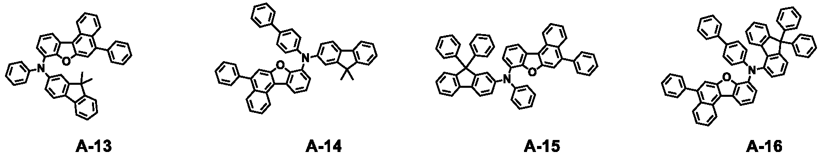

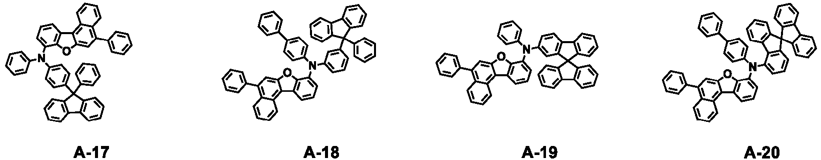

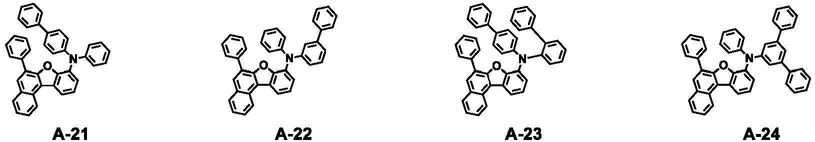

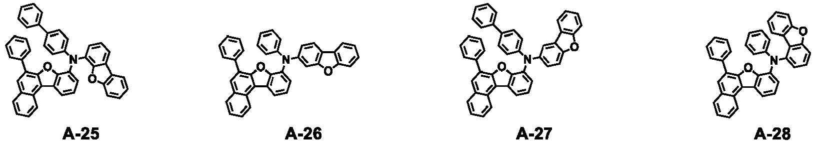

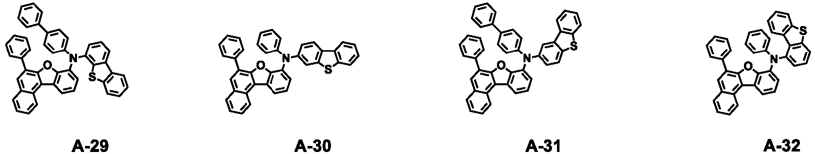

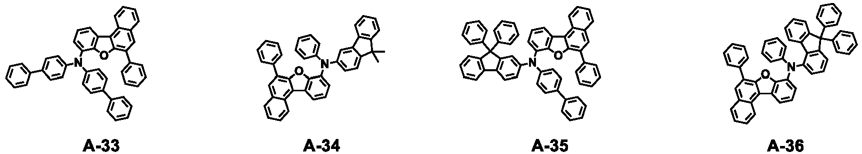

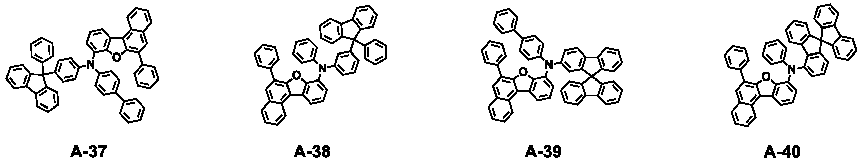

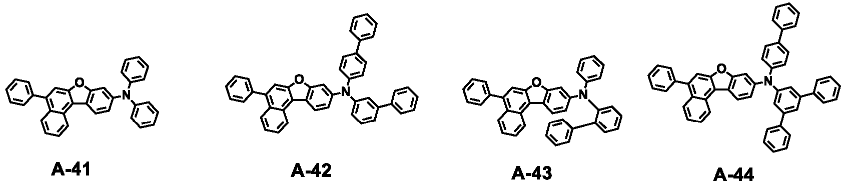

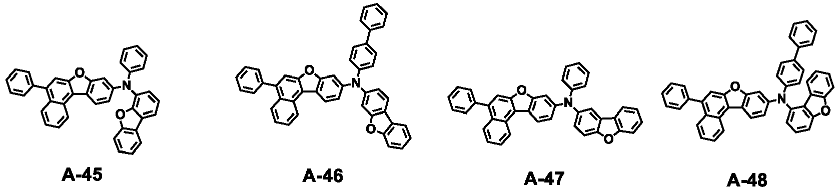

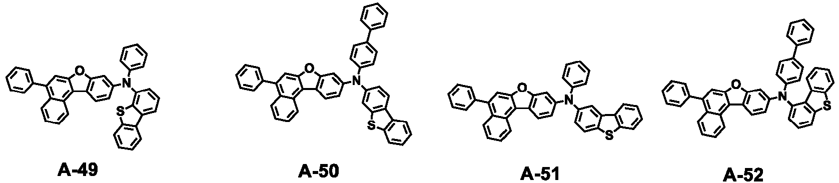

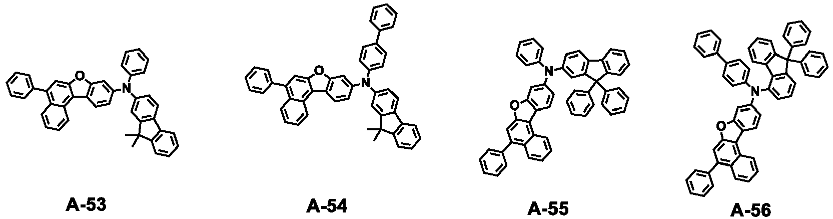

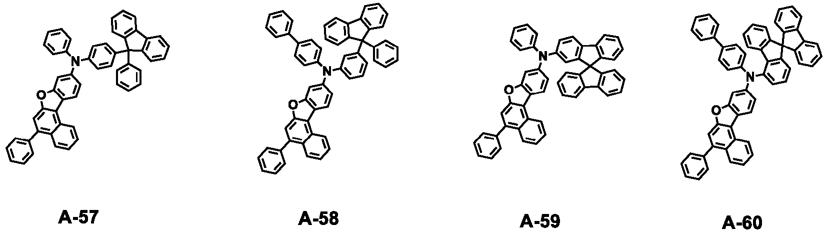

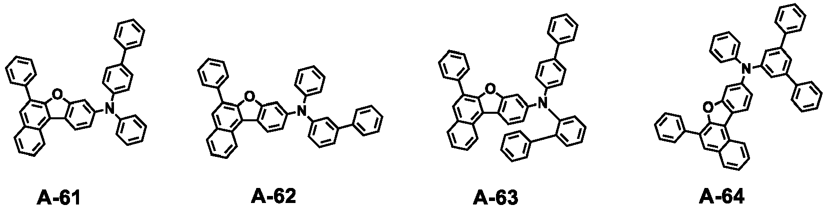

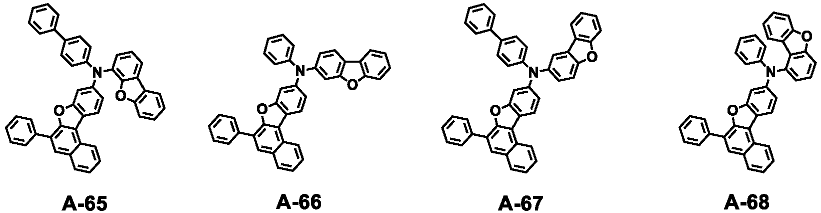

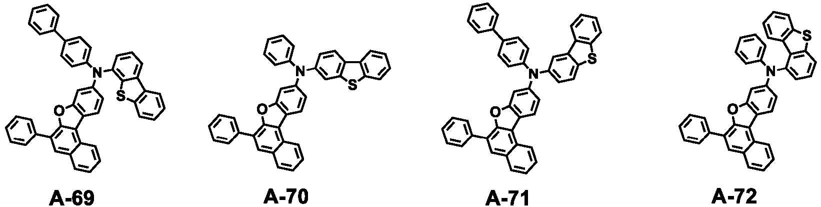

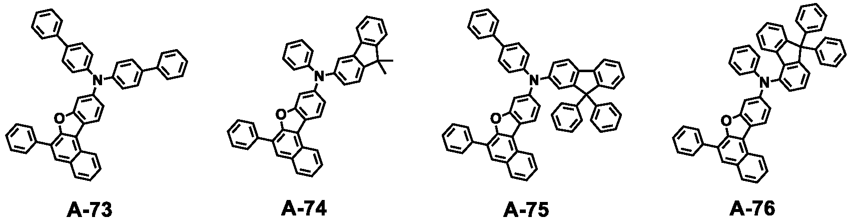

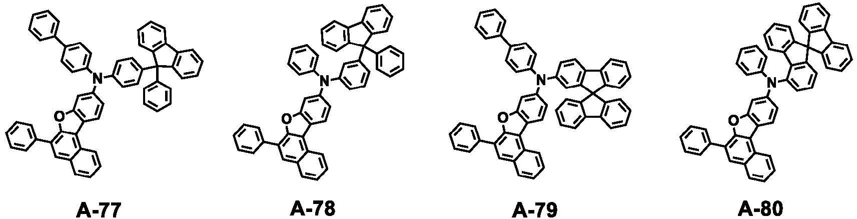

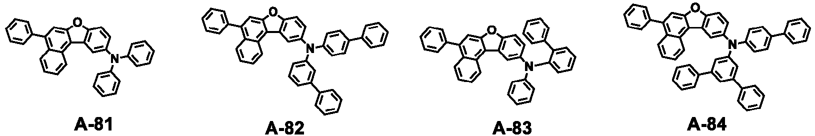

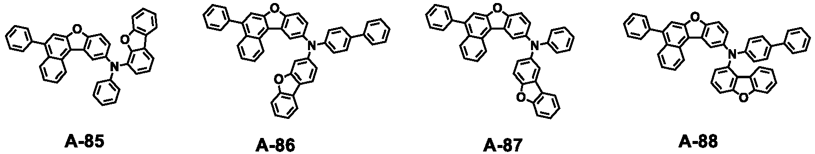

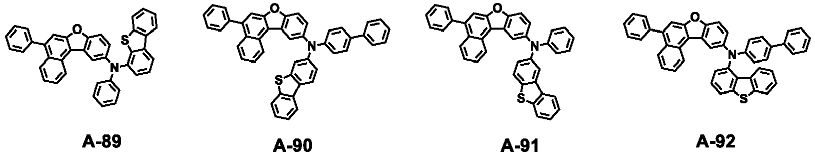

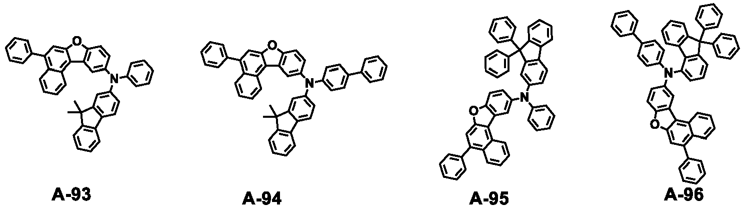

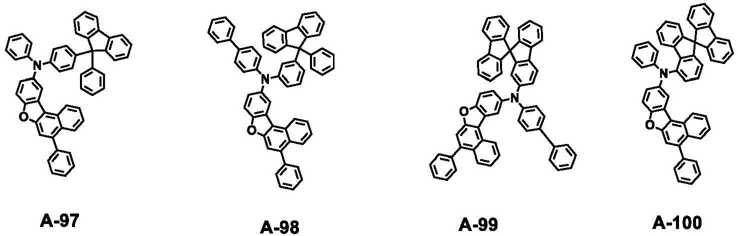

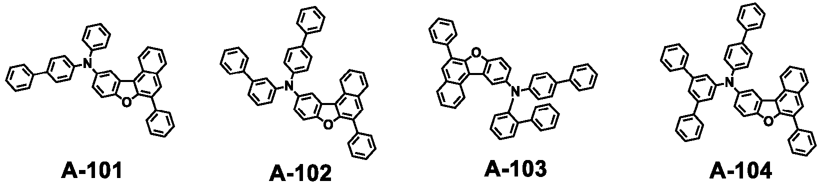

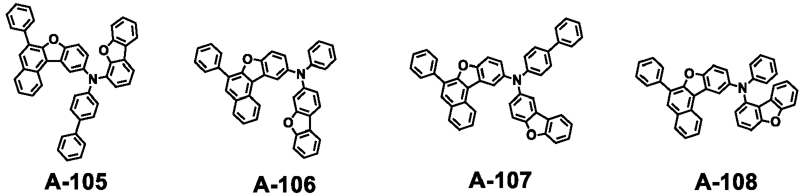

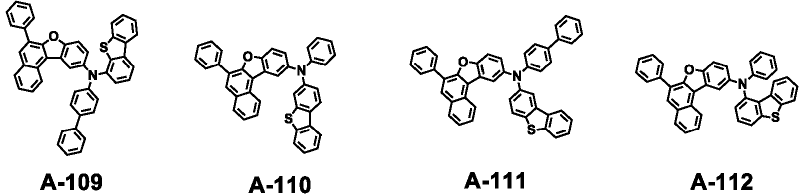

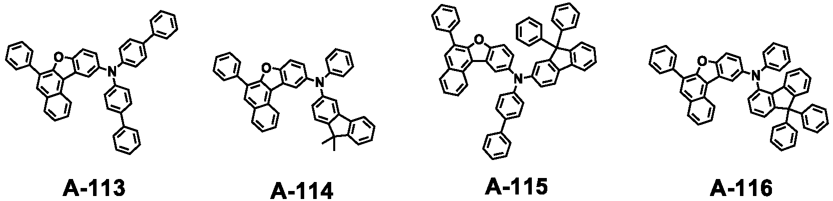

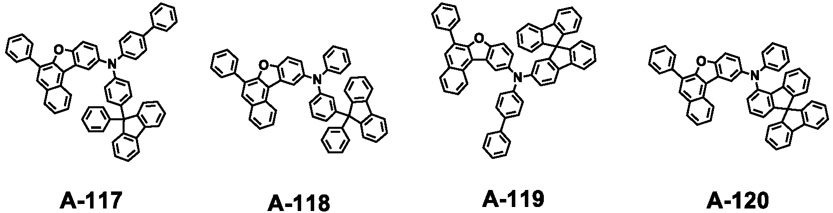

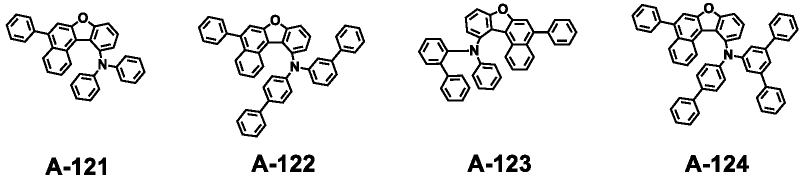

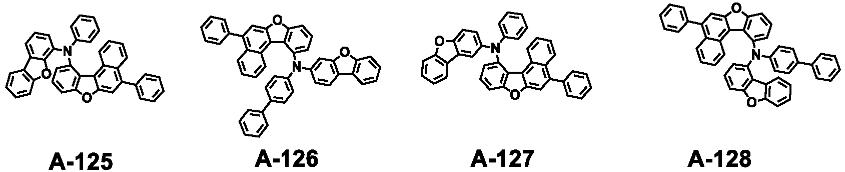

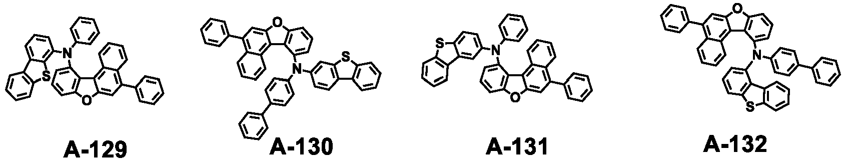

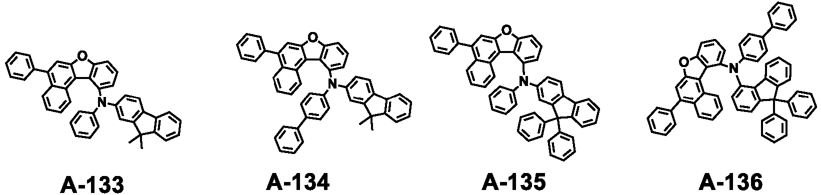

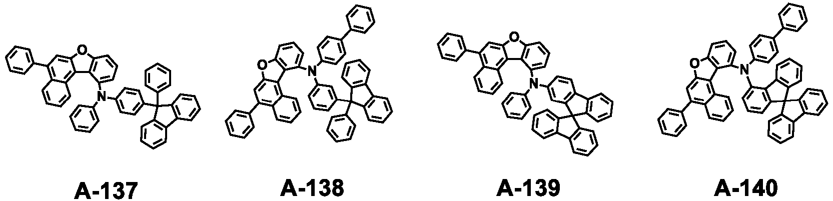

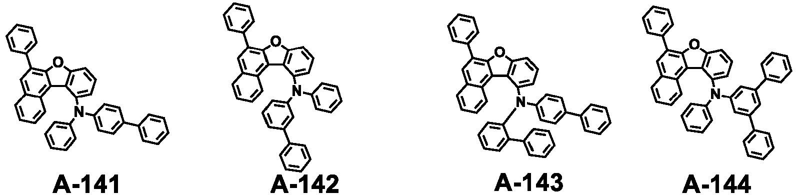

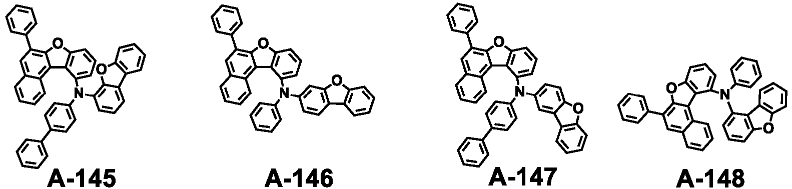

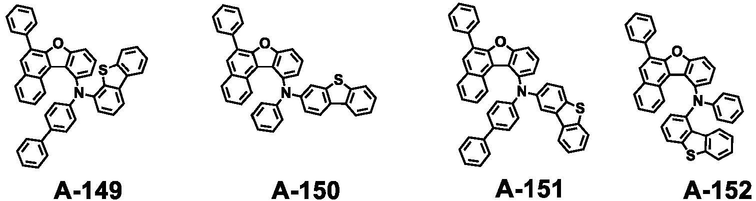

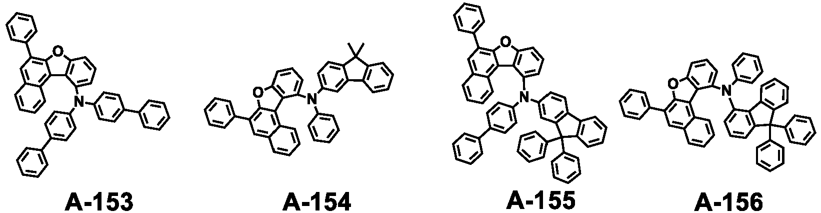

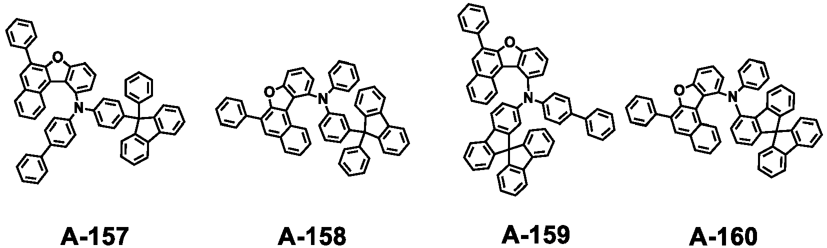

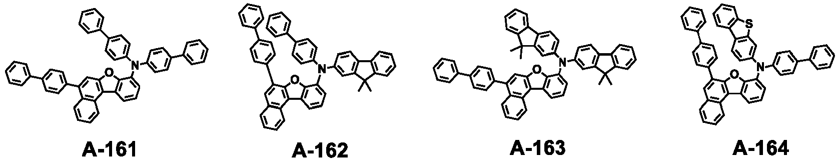

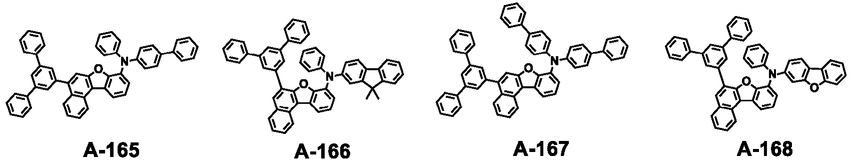

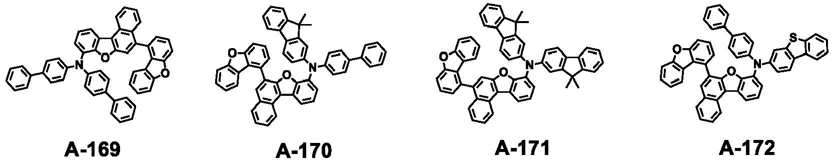

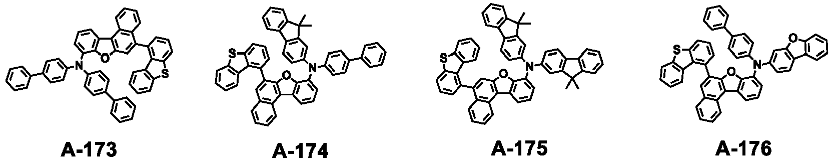

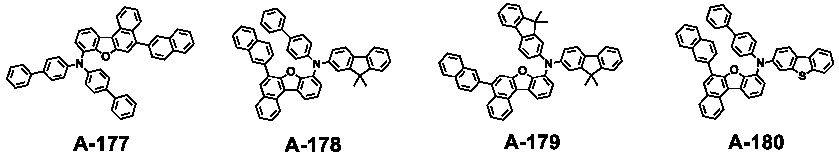

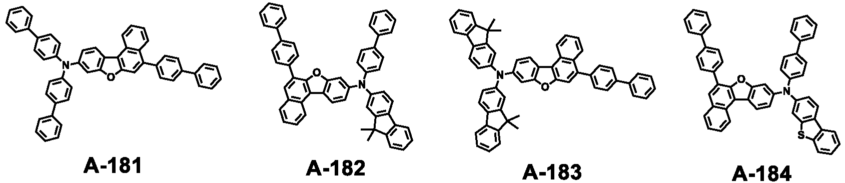

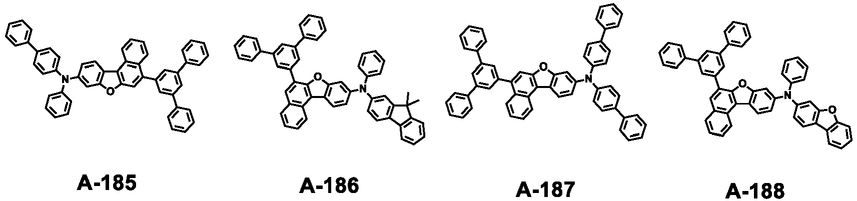

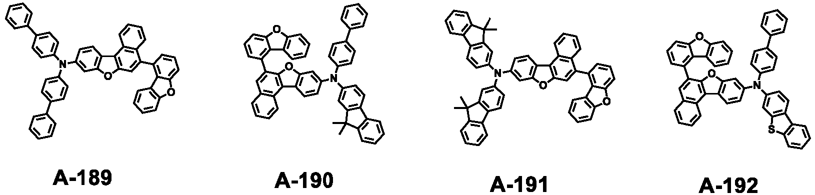

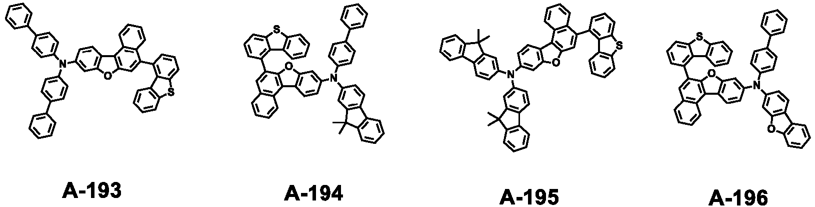

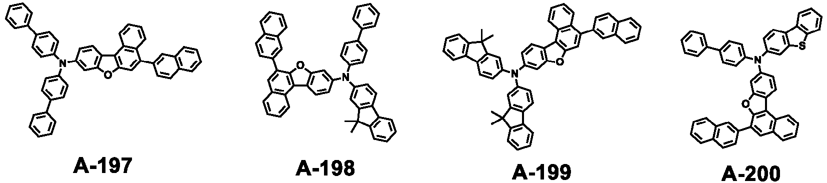

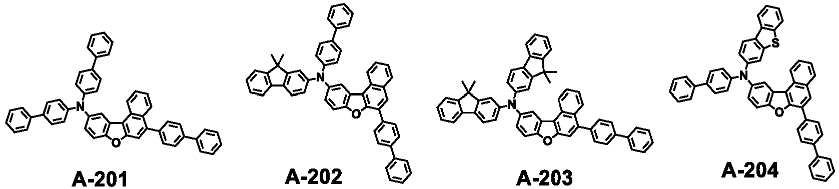

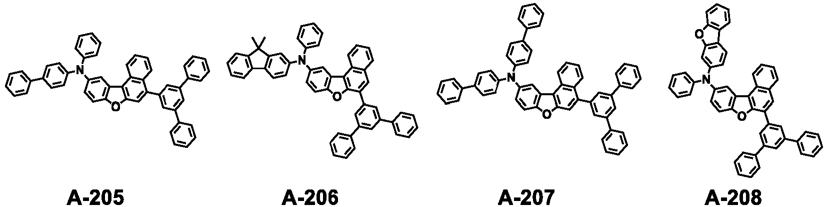

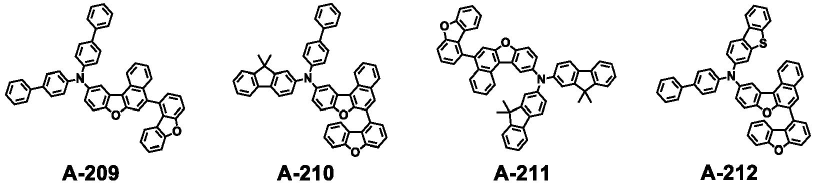

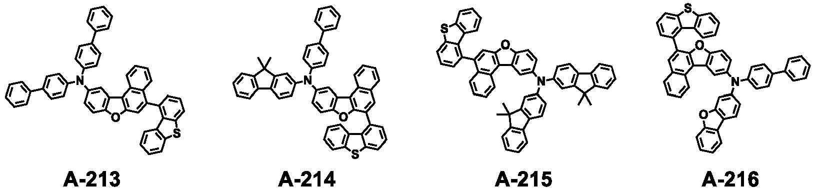

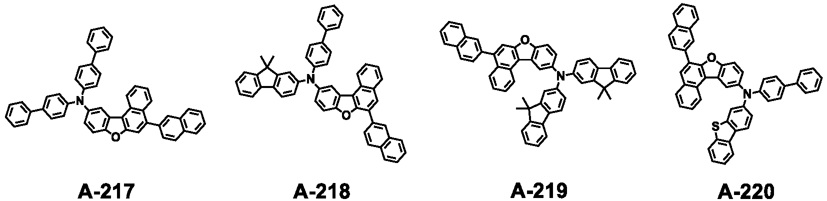

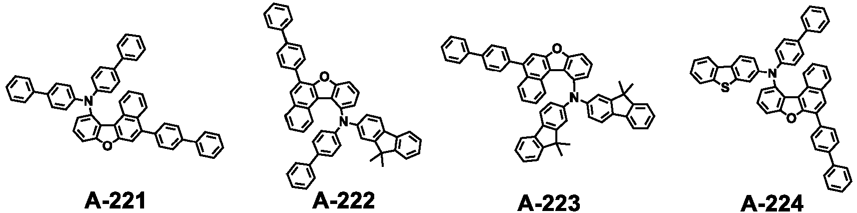

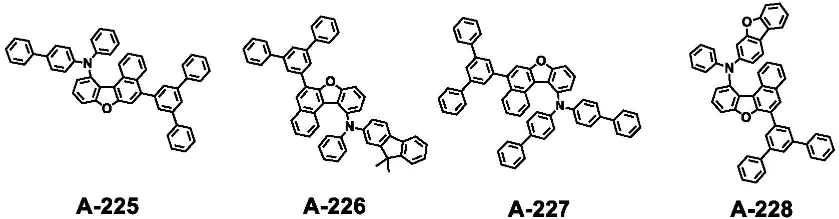

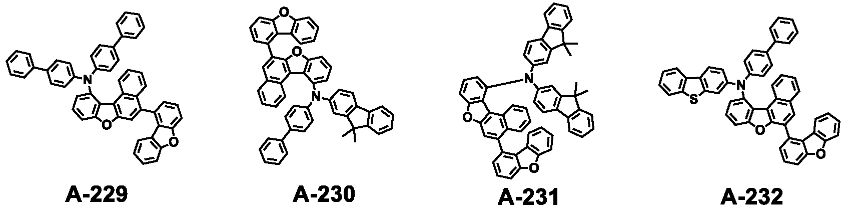

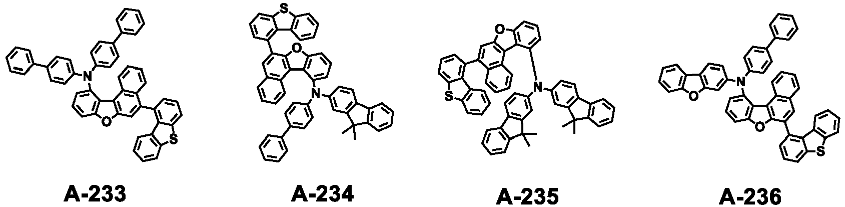

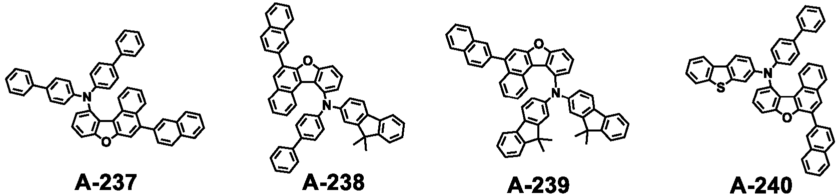

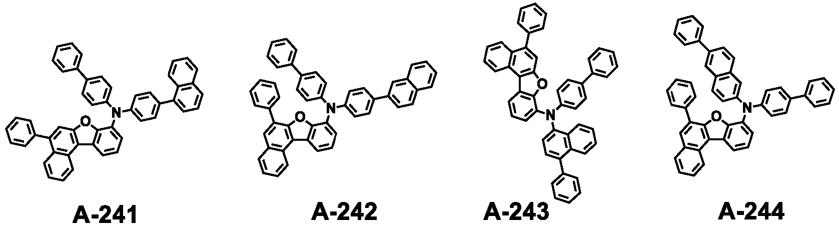

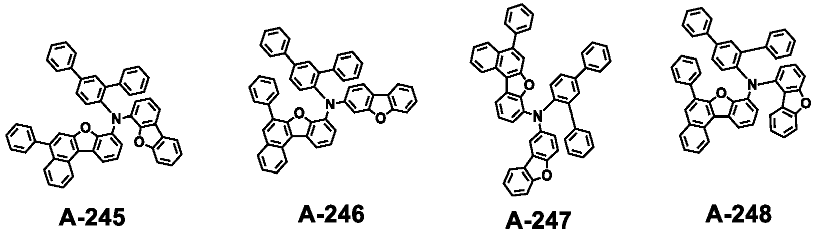

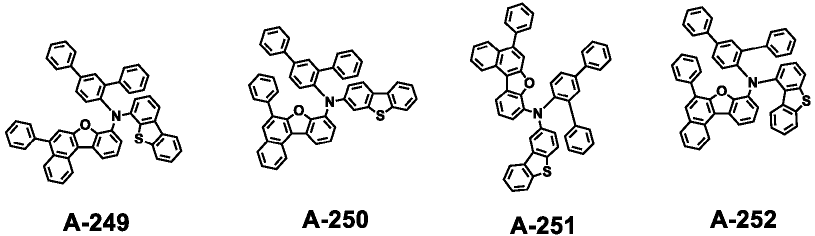

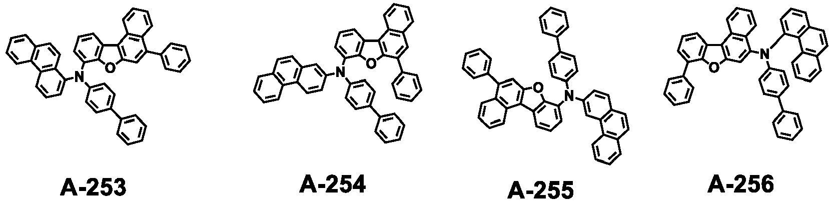

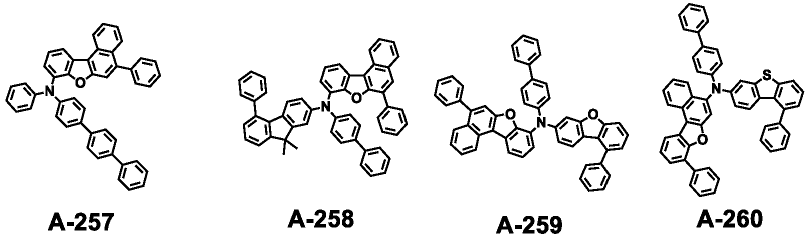

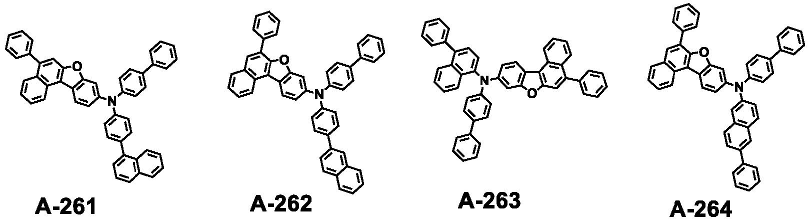

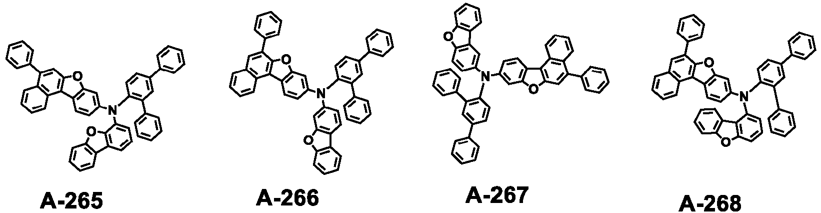

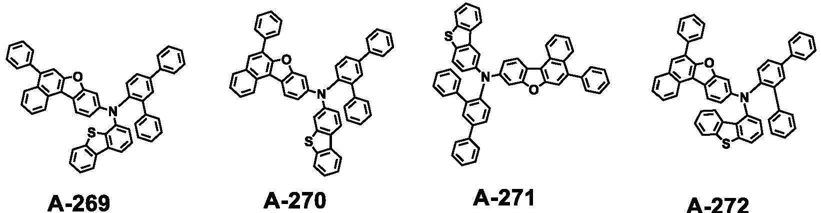

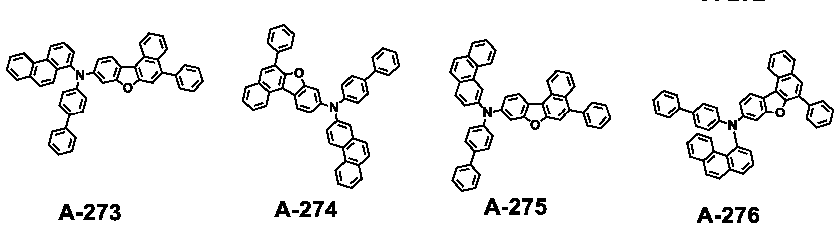

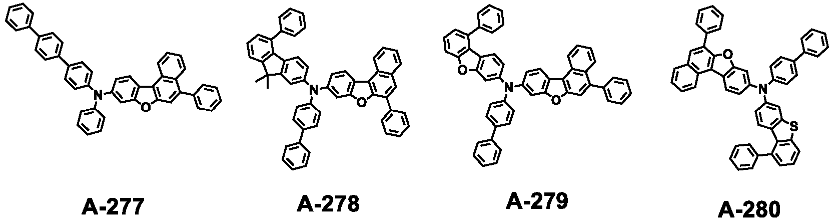

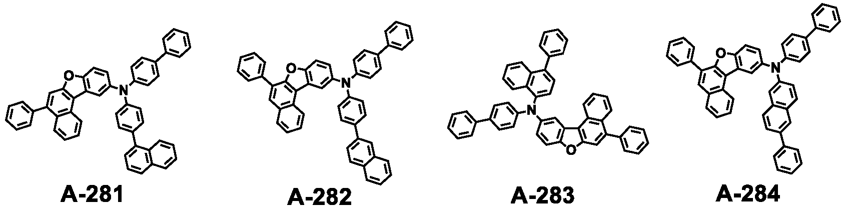

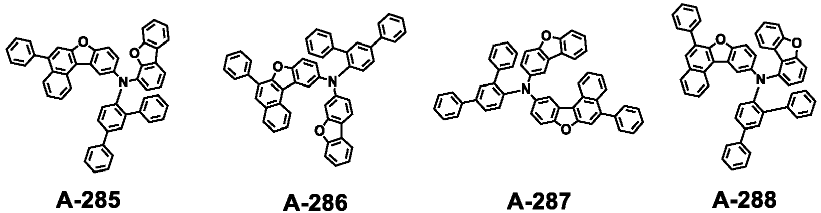

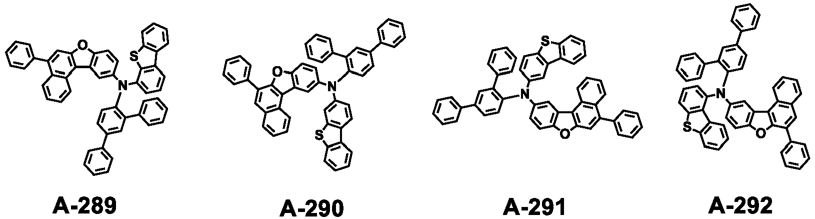

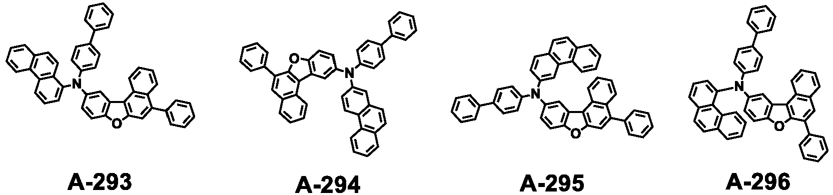

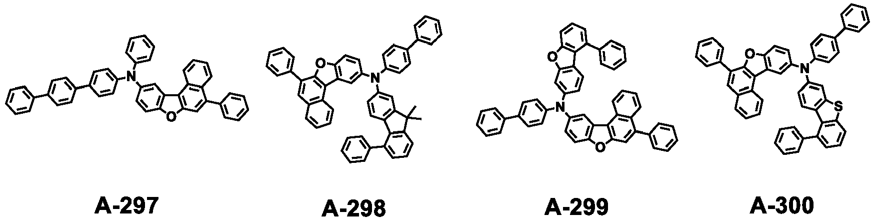

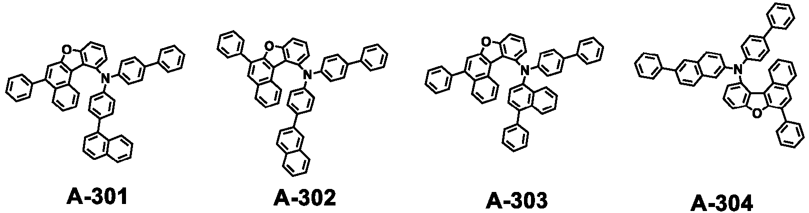

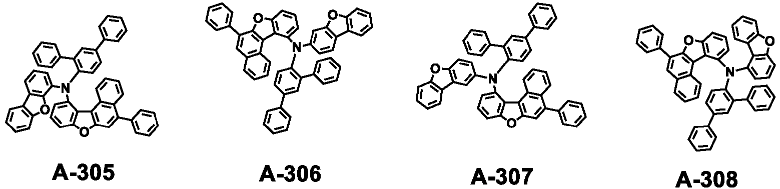

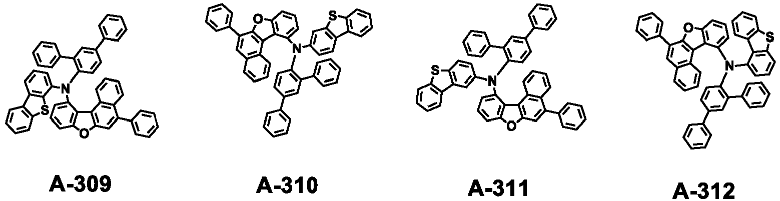

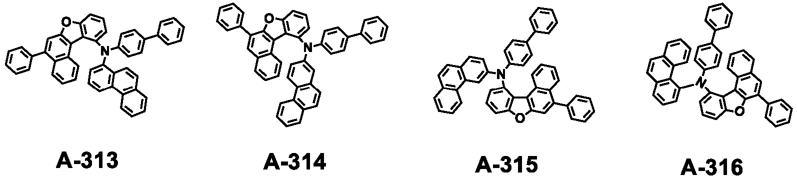

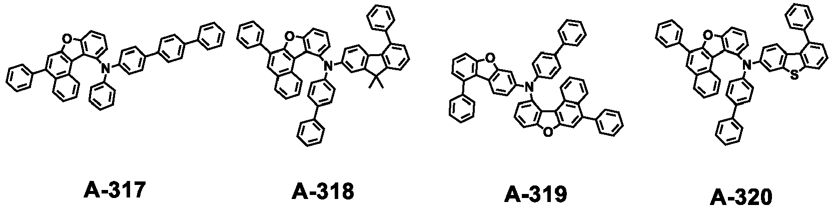

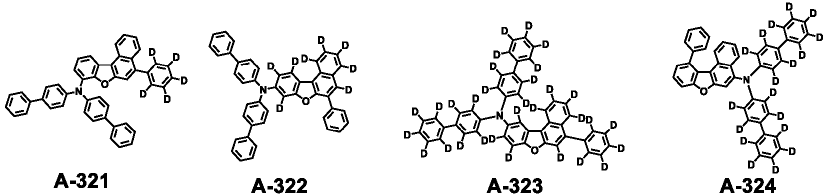

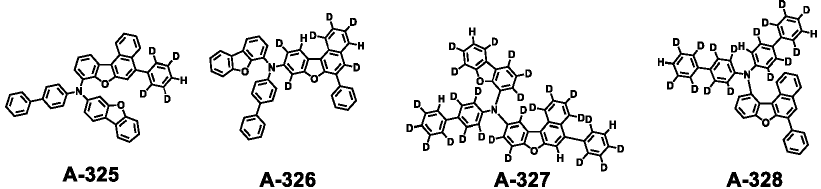

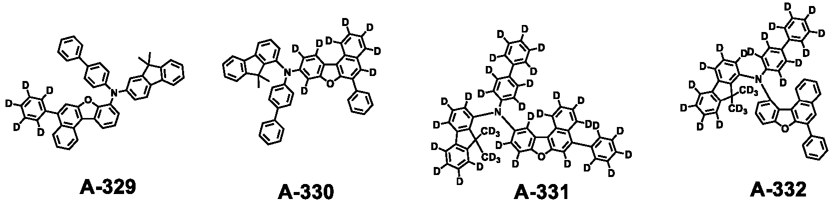

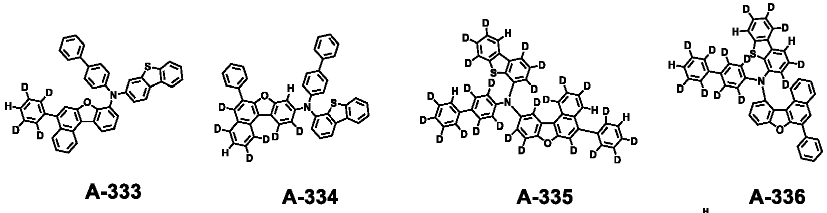

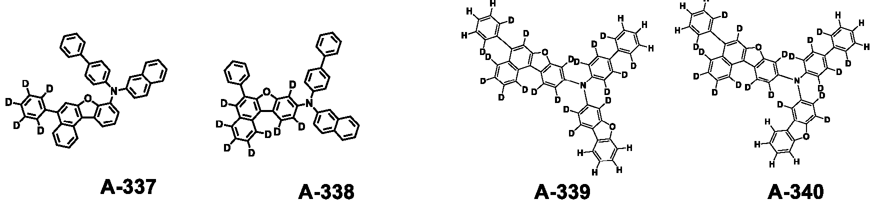

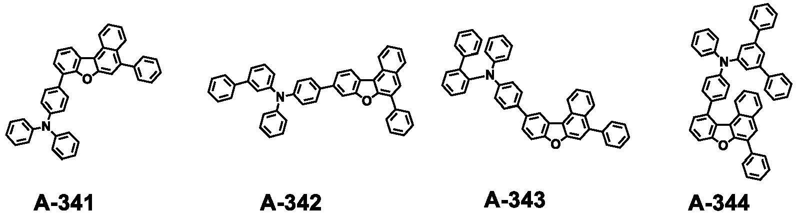

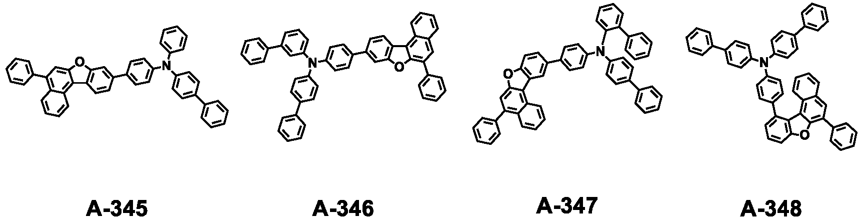

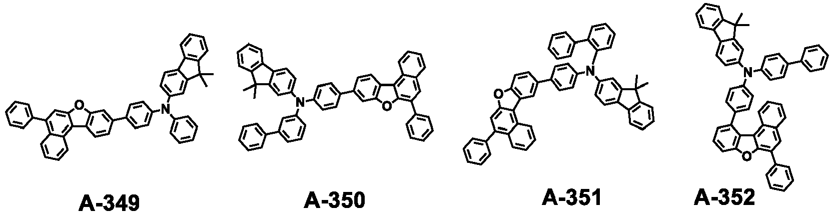

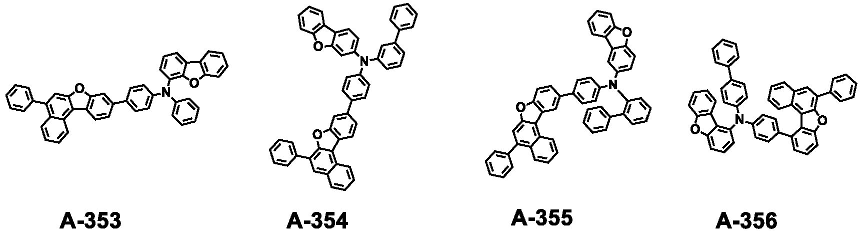

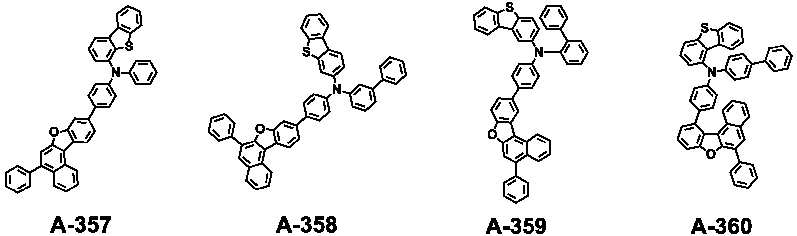

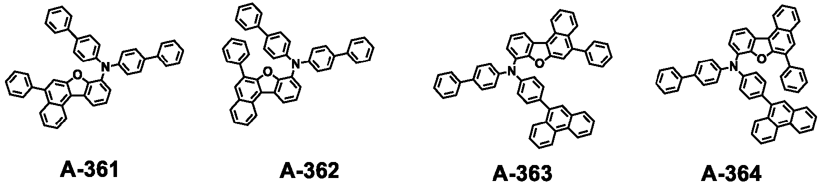

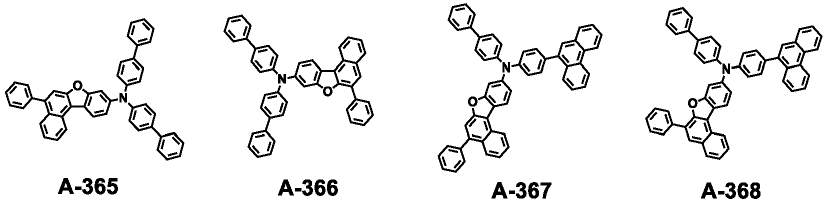

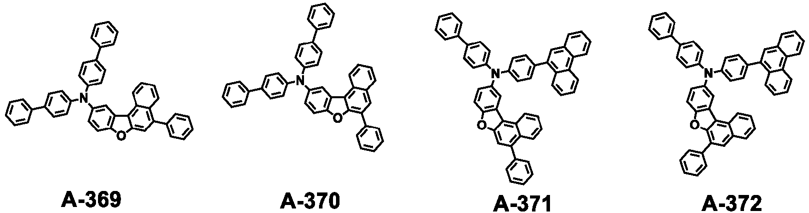

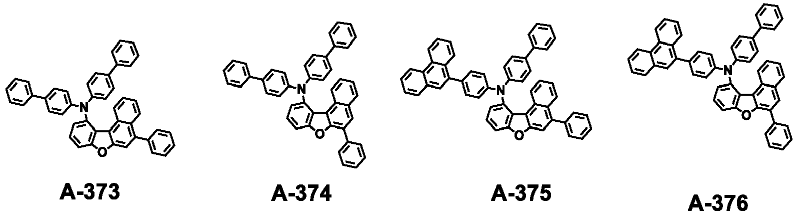

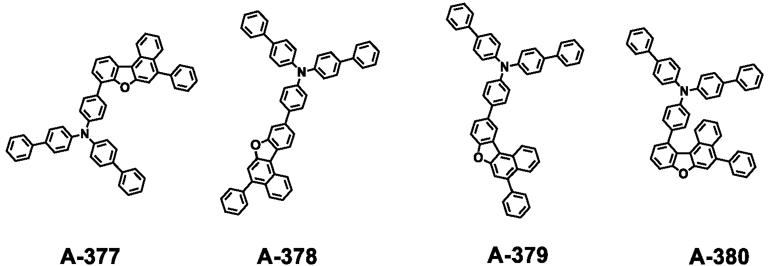

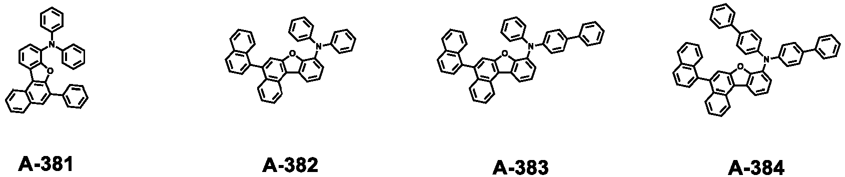

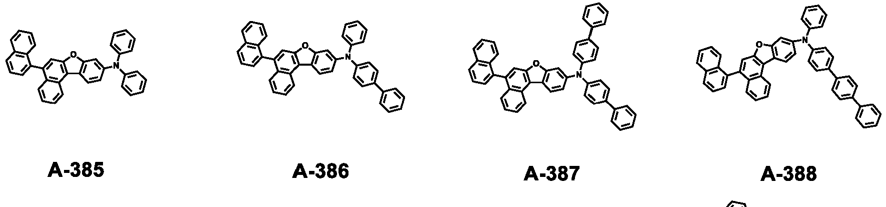

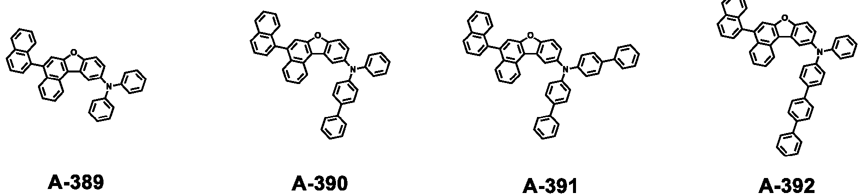

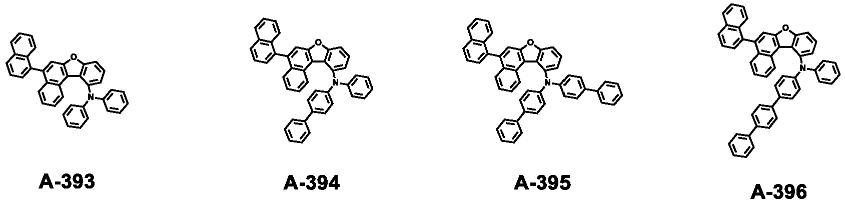

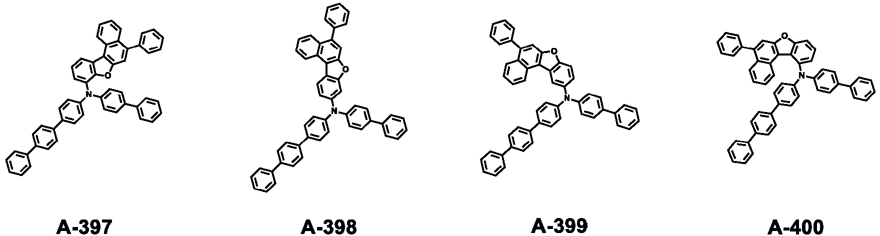

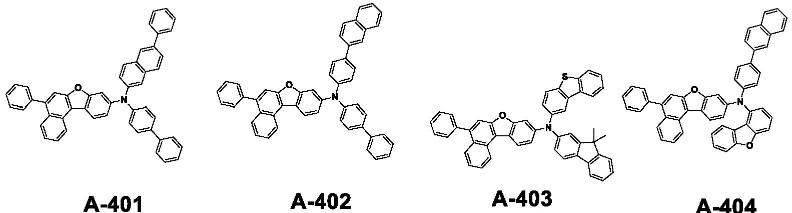

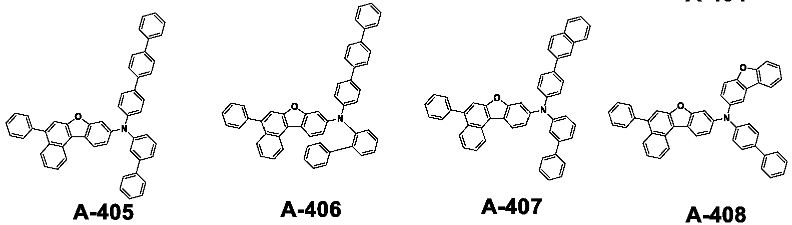

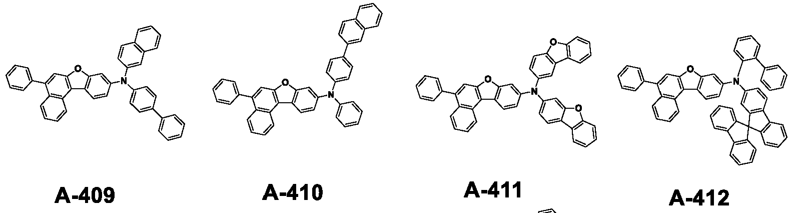

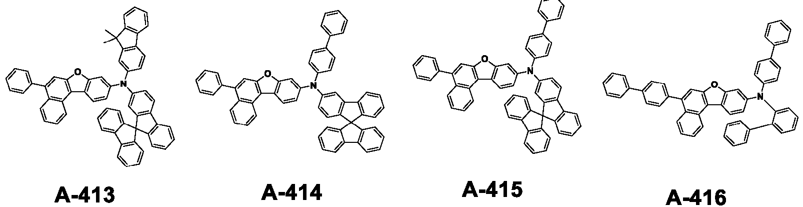

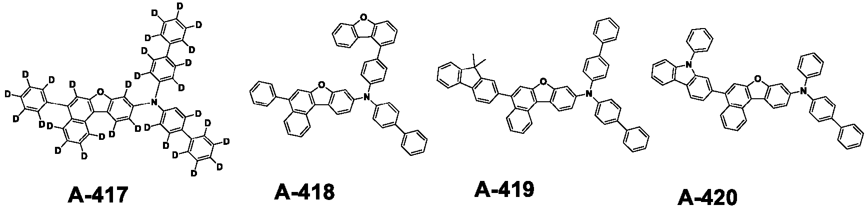

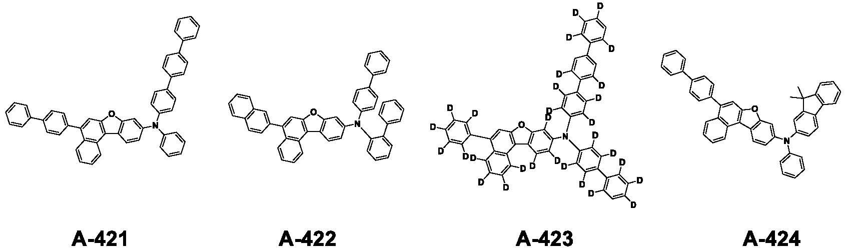

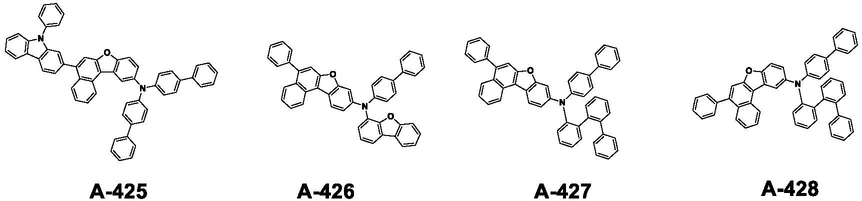

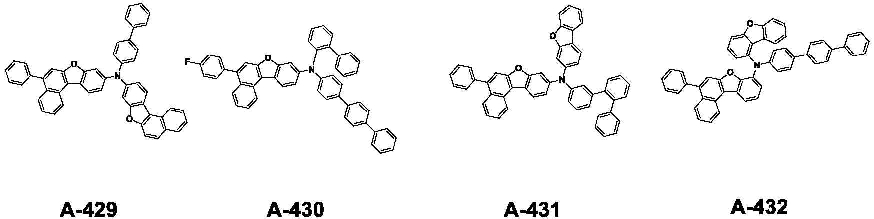

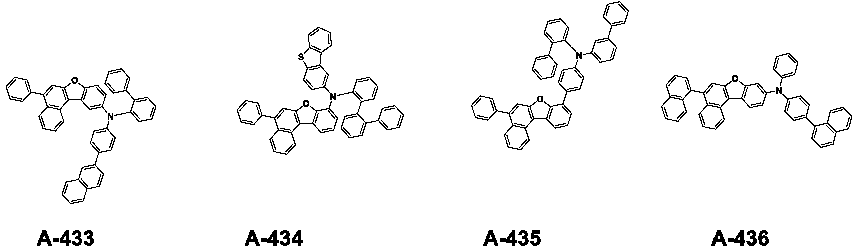

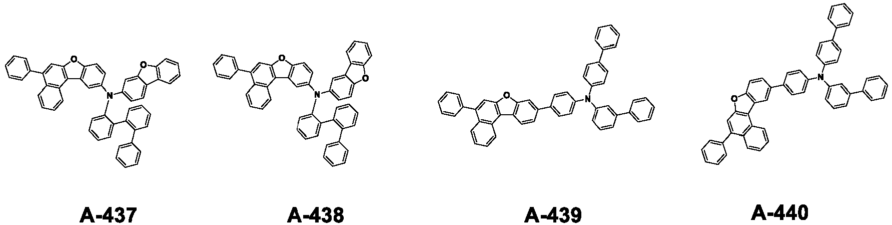

According to an exemplary embodiment of the present specification, Chemical Formula B may be represented by any one of the following heterocyclic compounds.

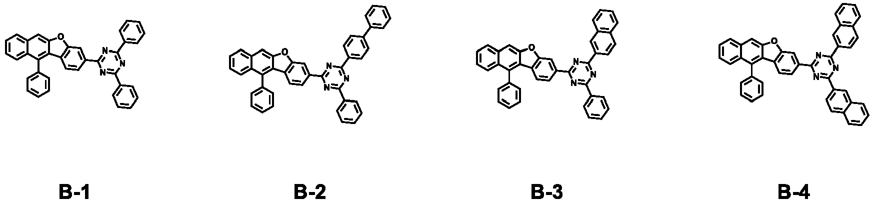

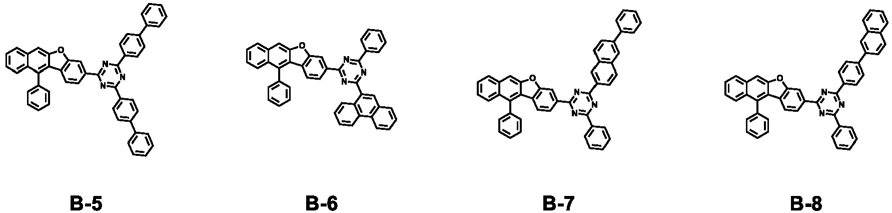

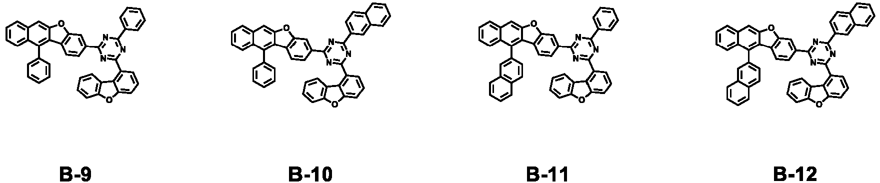

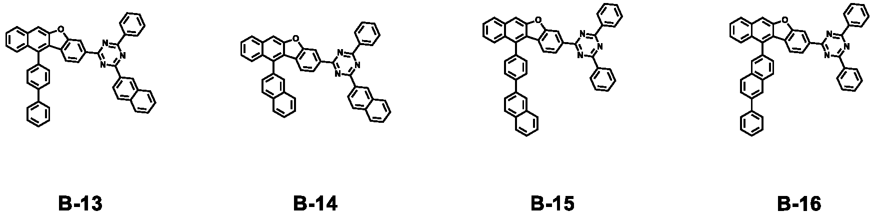

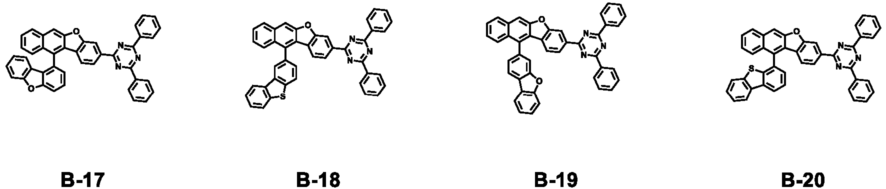

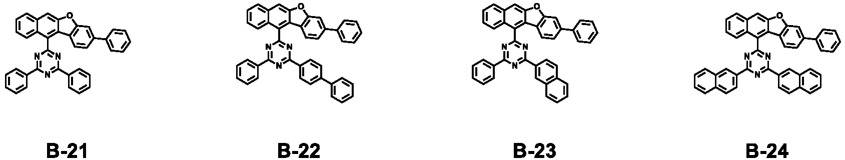

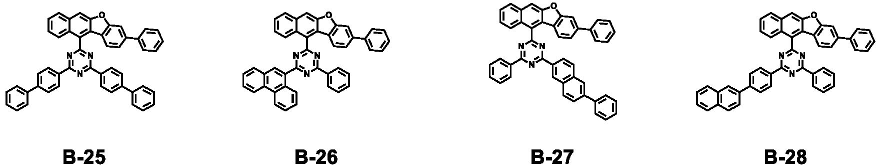

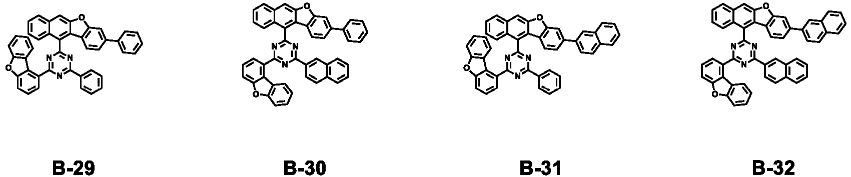

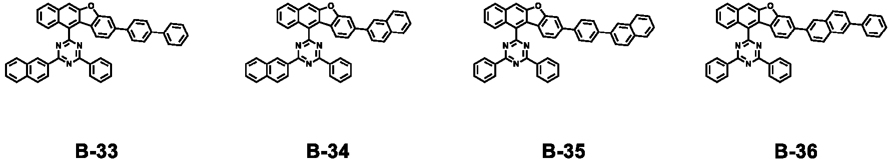

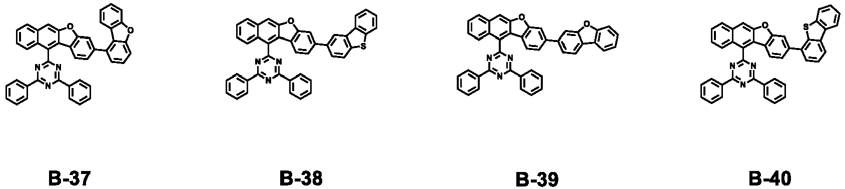

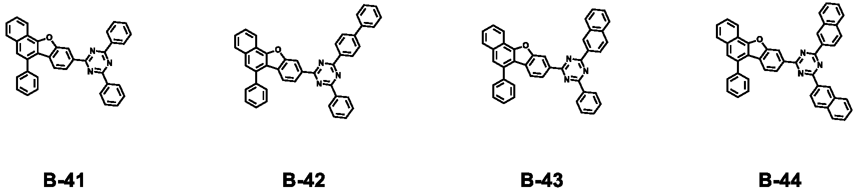

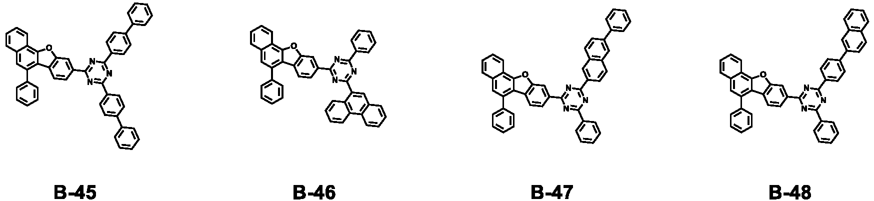

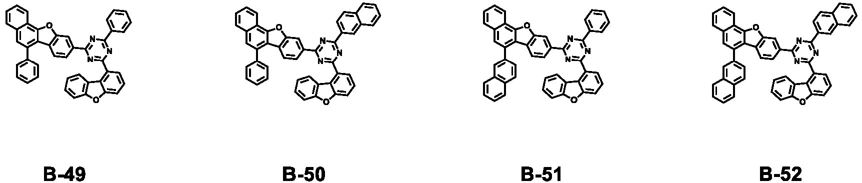

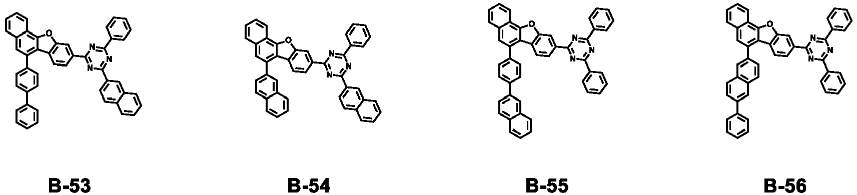

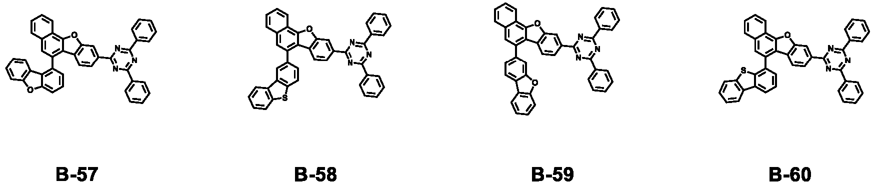

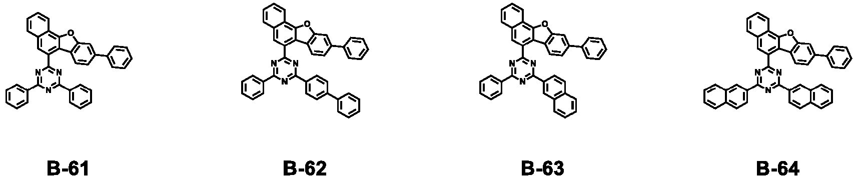

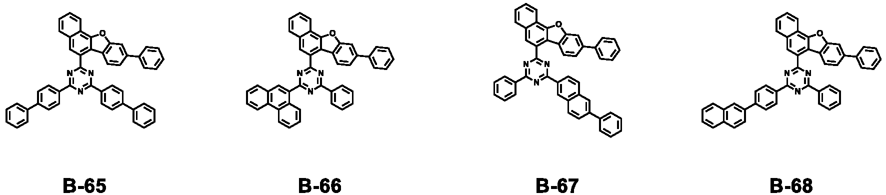

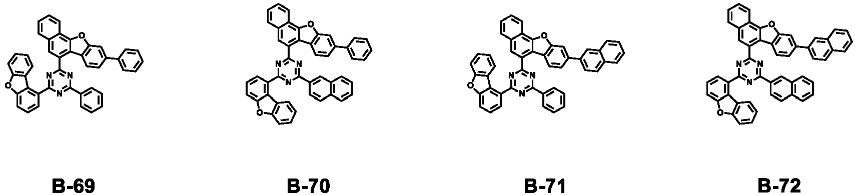

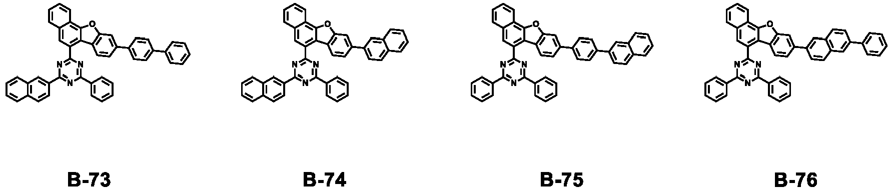

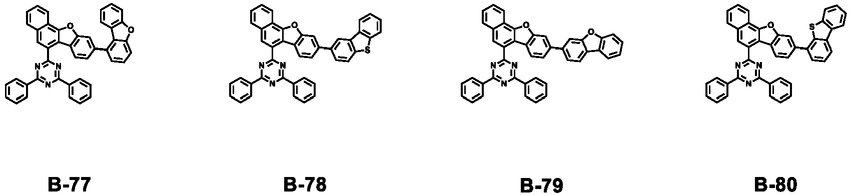

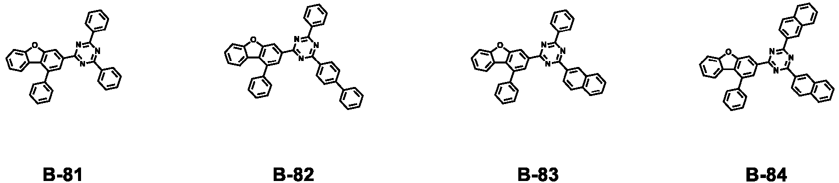

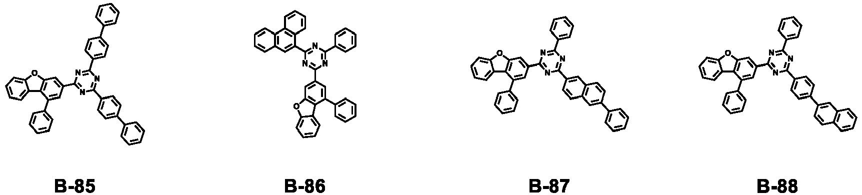

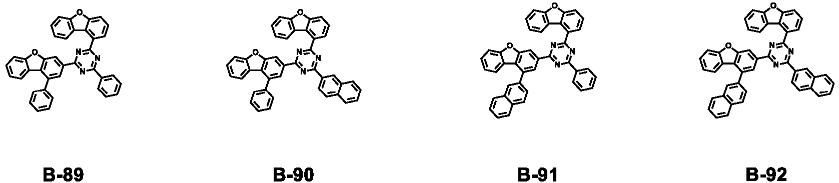

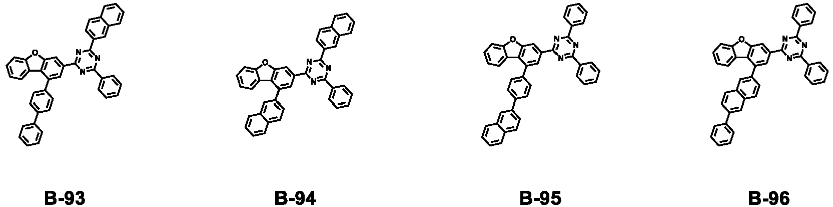

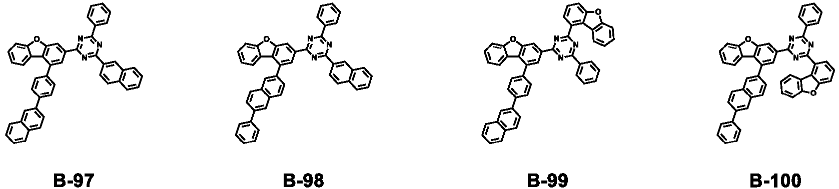

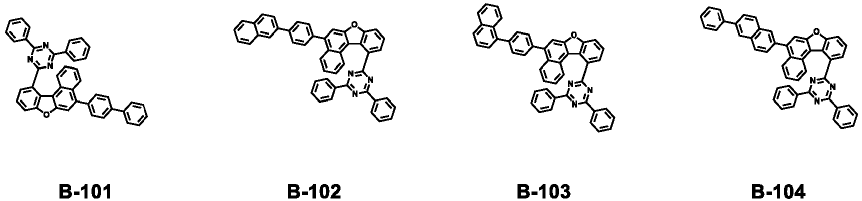

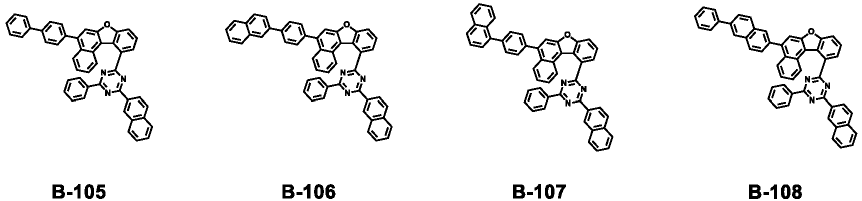

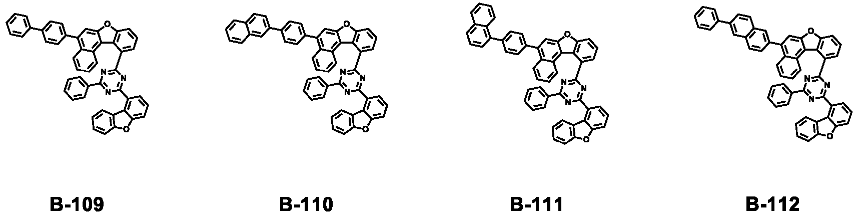

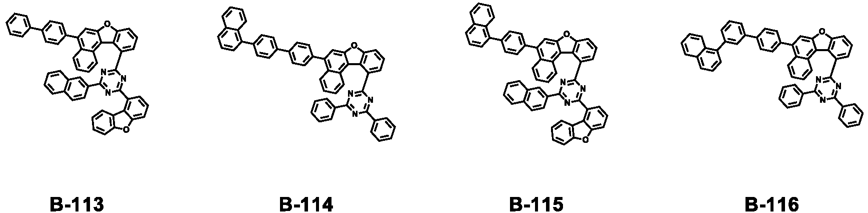

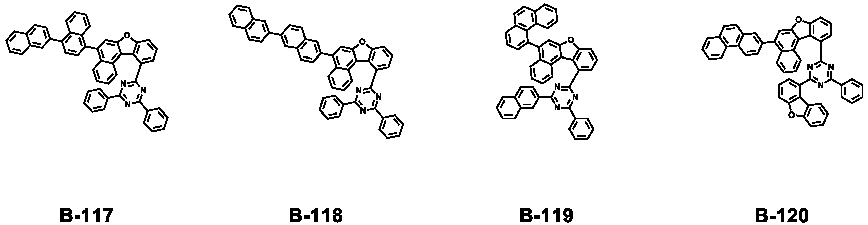

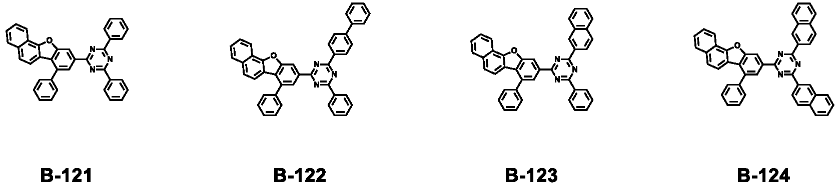

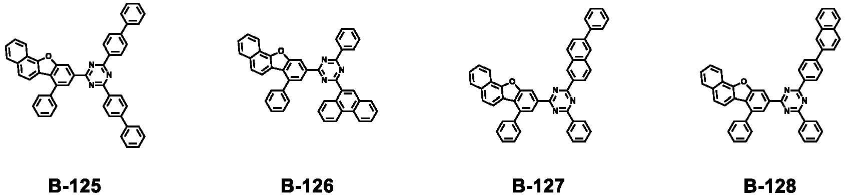

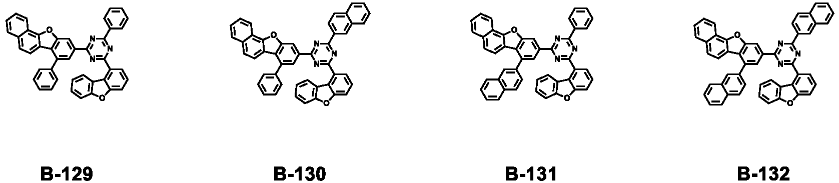

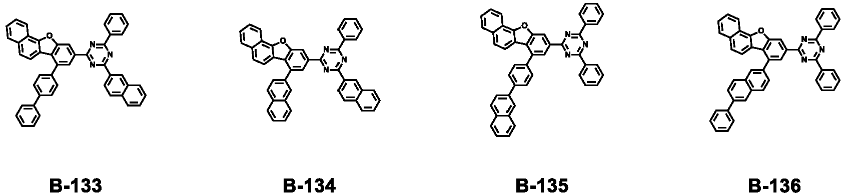

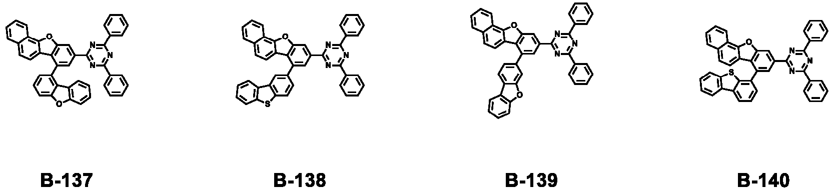

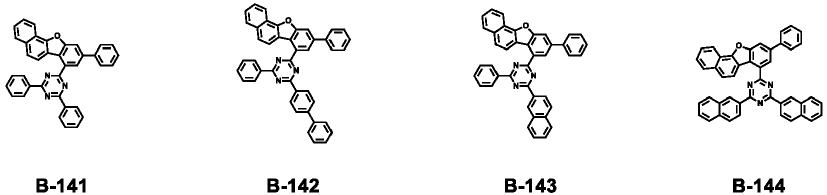

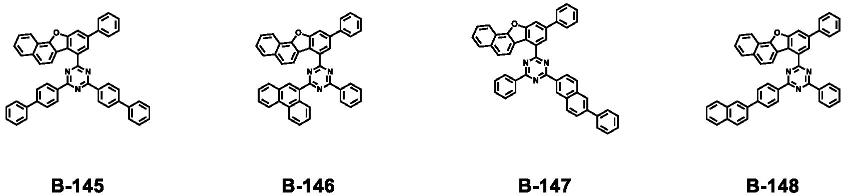

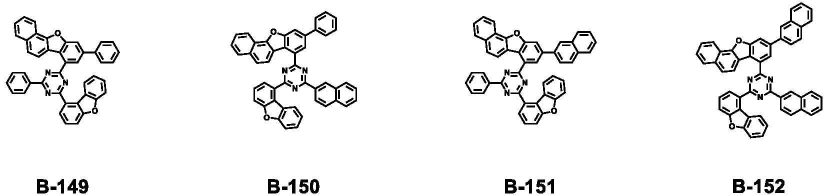

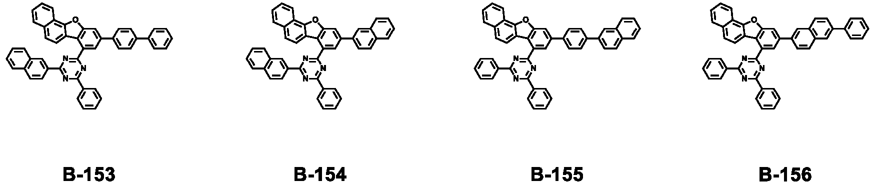

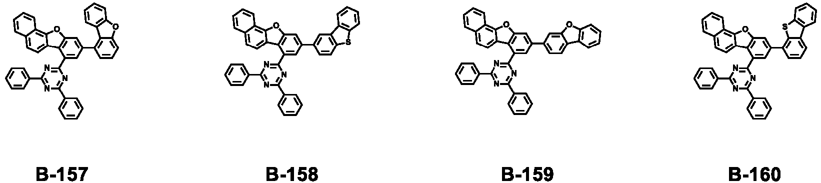

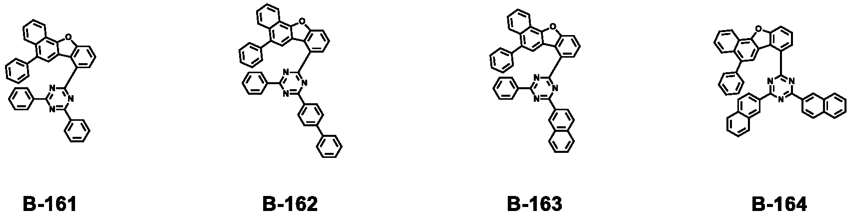

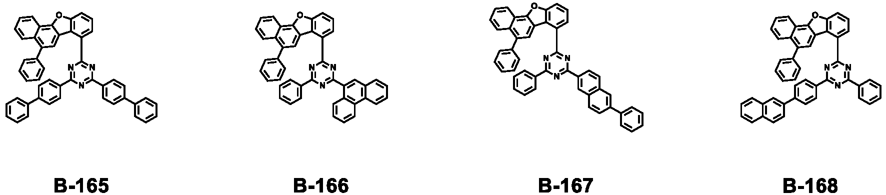

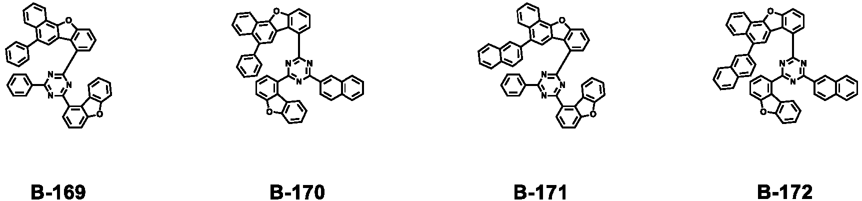

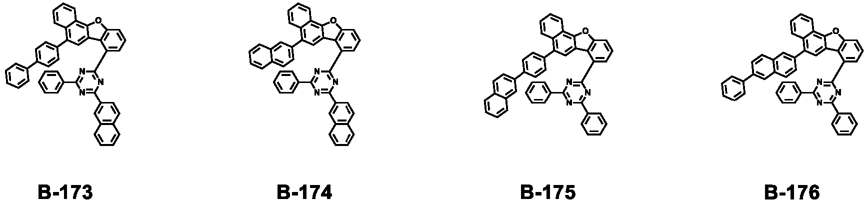

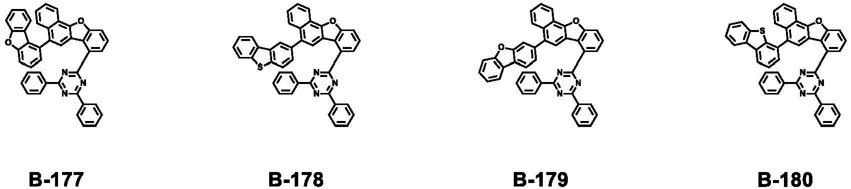

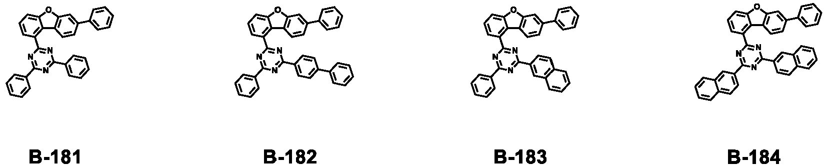

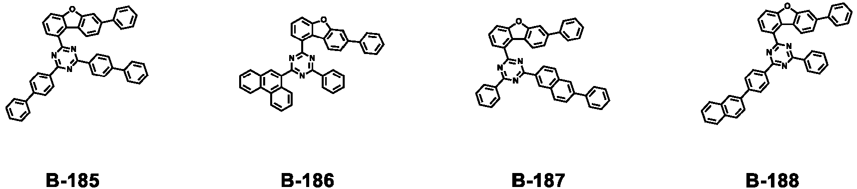

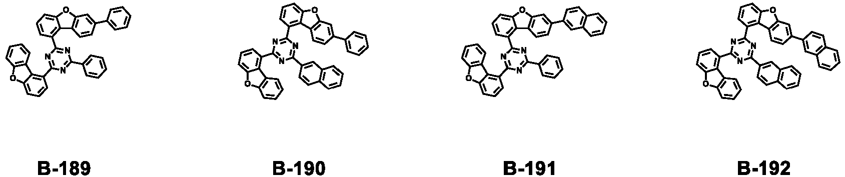

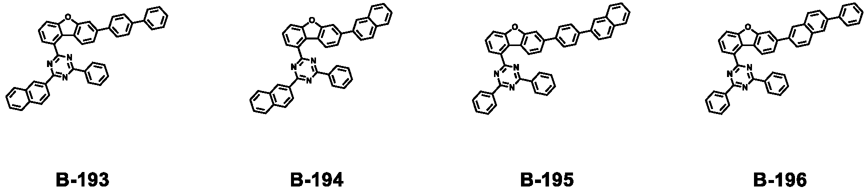

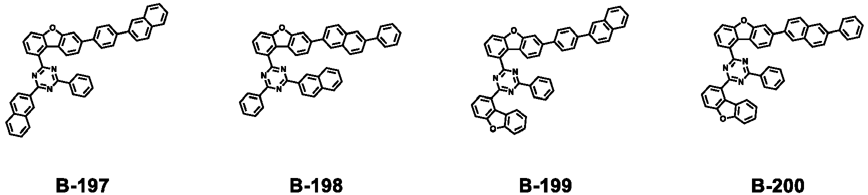

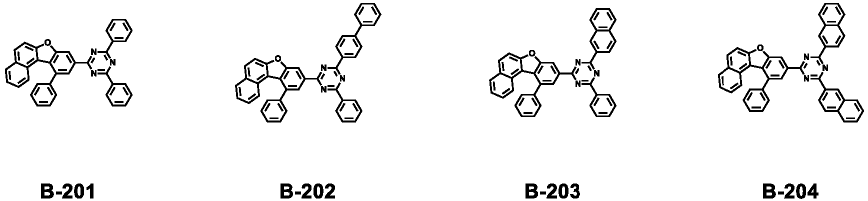

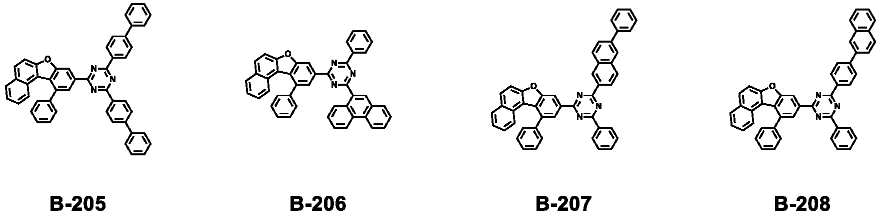

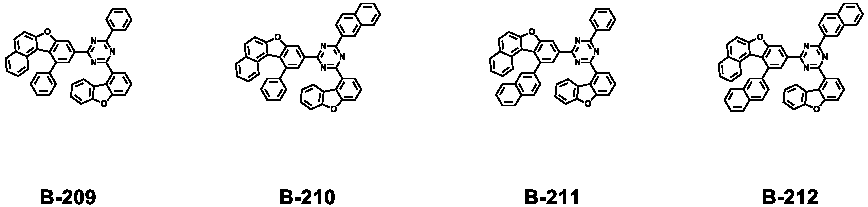

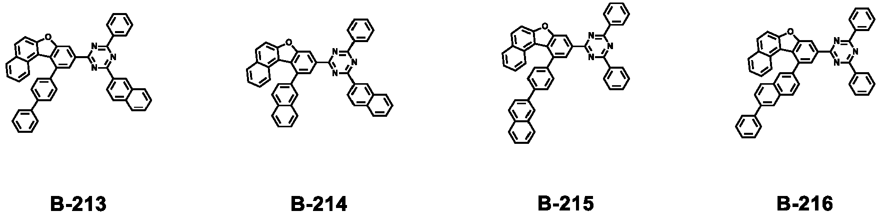

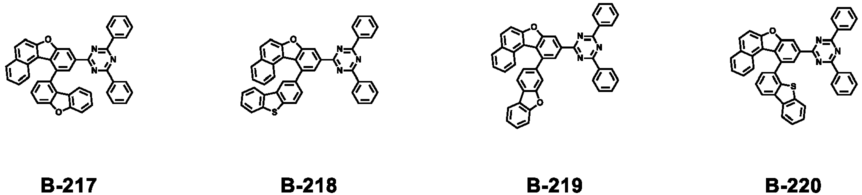

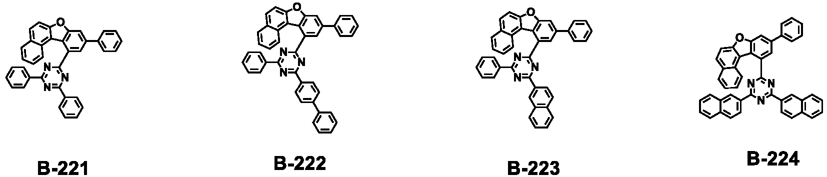

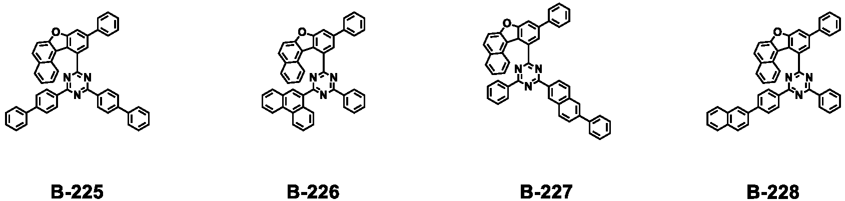

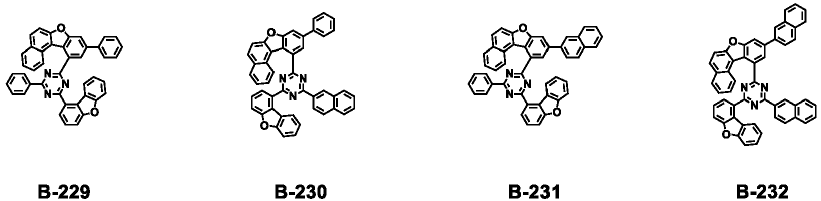

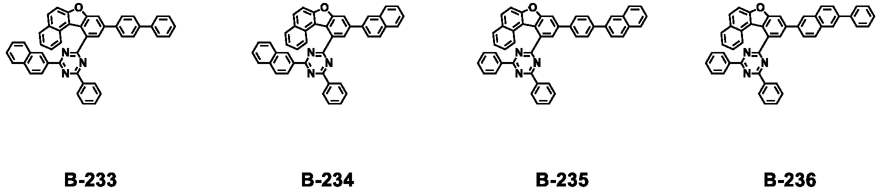

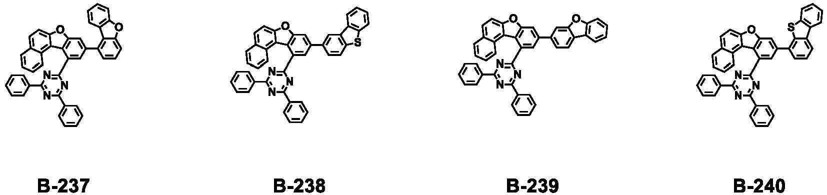

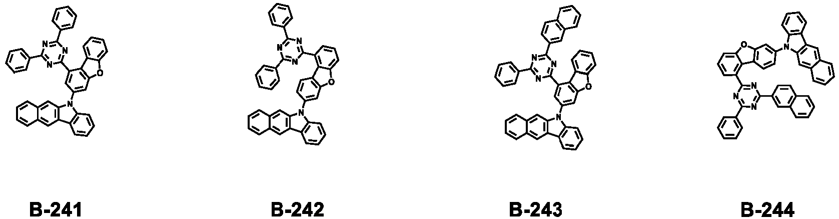

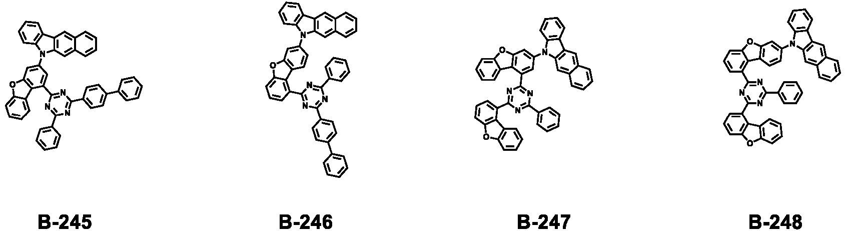

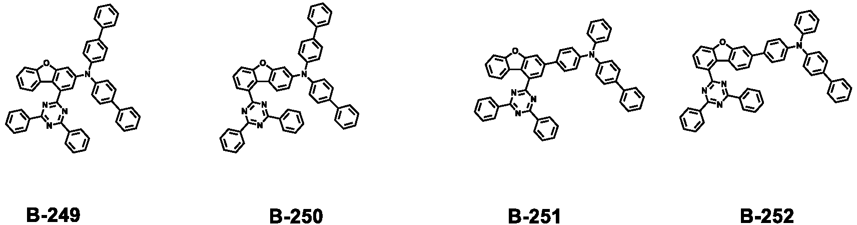

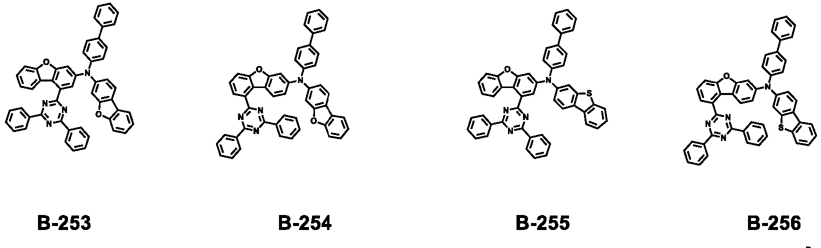

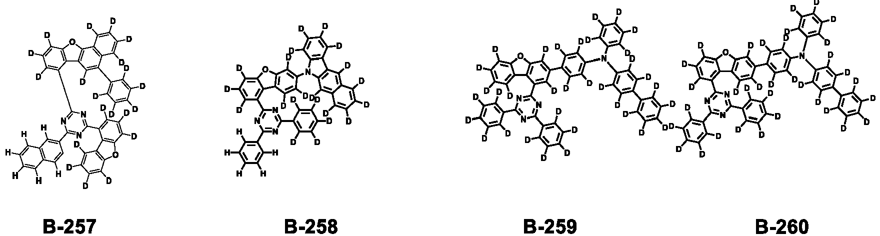

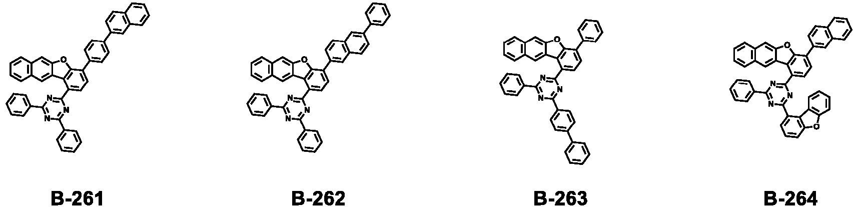

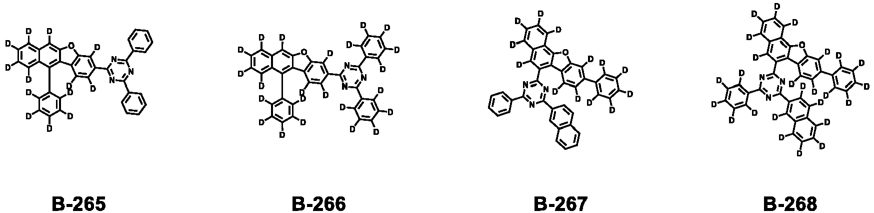

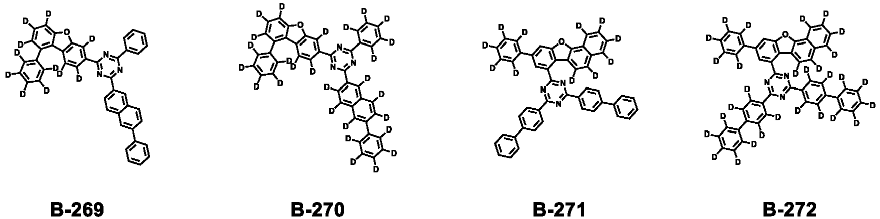

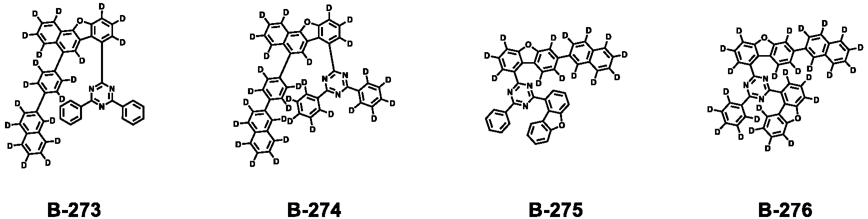

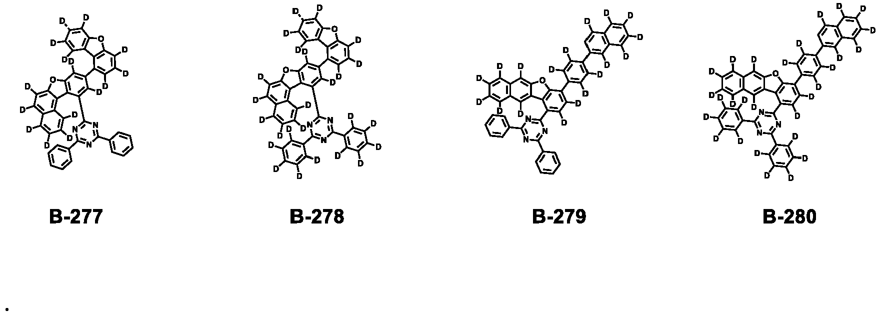

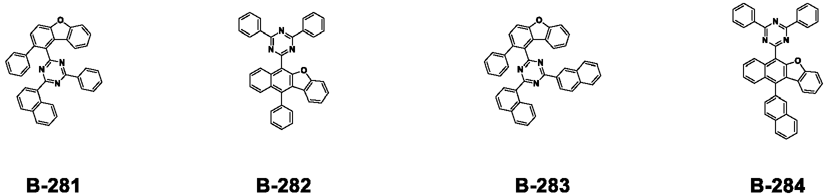

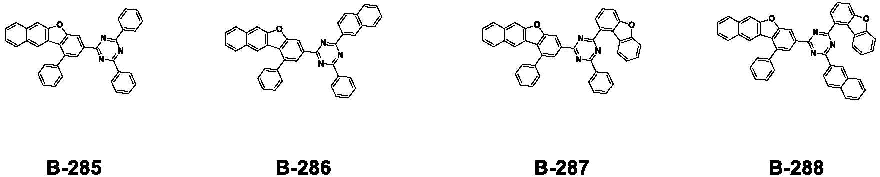

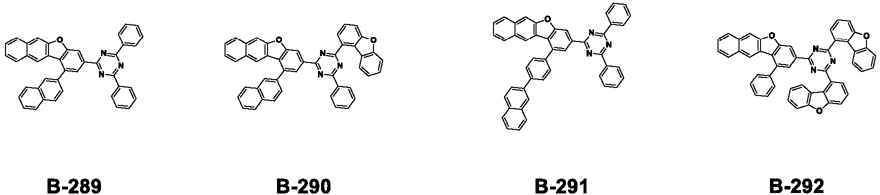

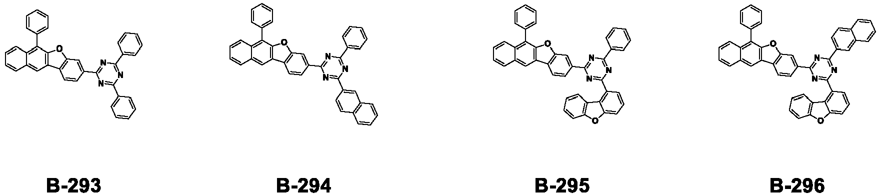

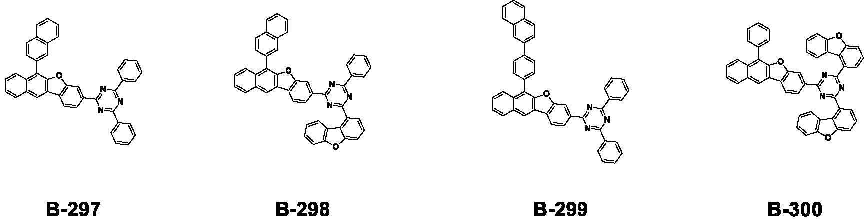

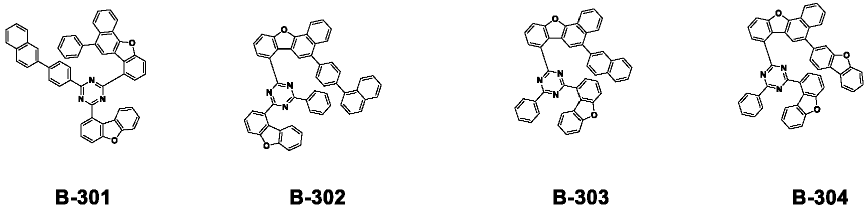

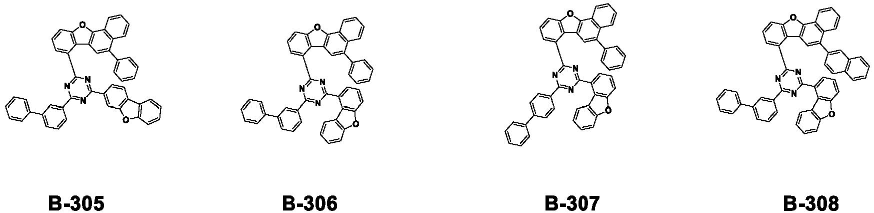

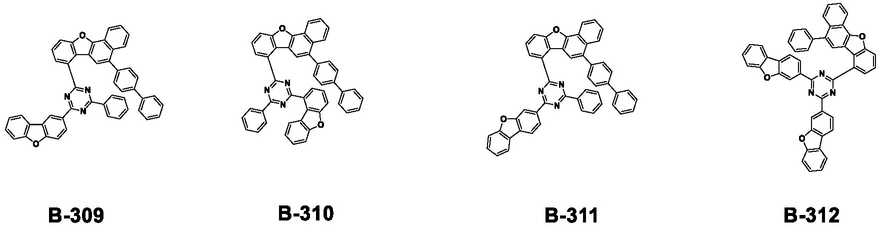

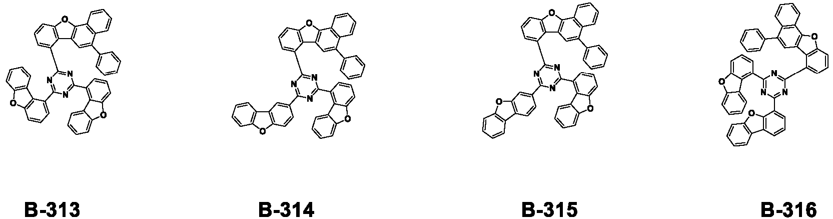

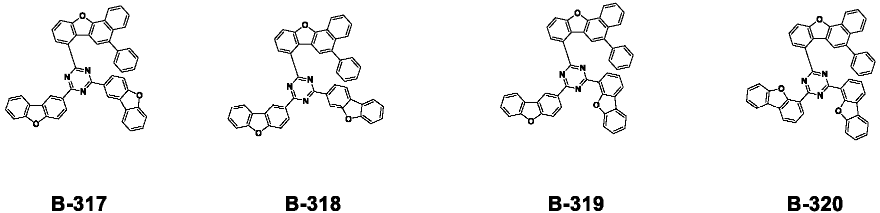

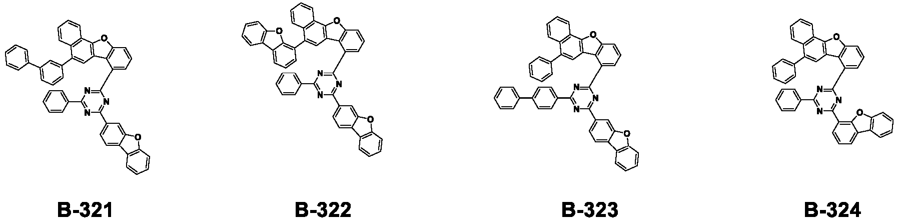

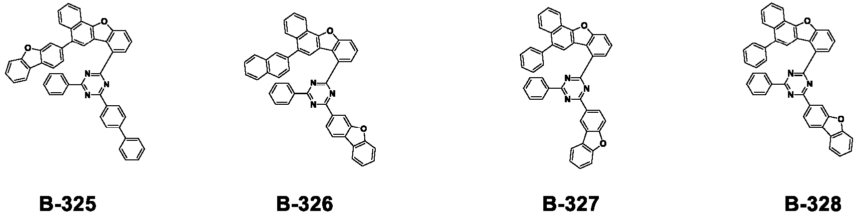

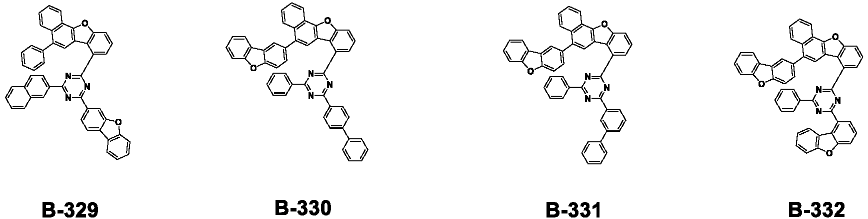

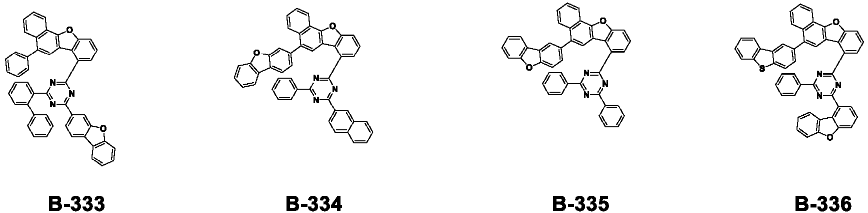

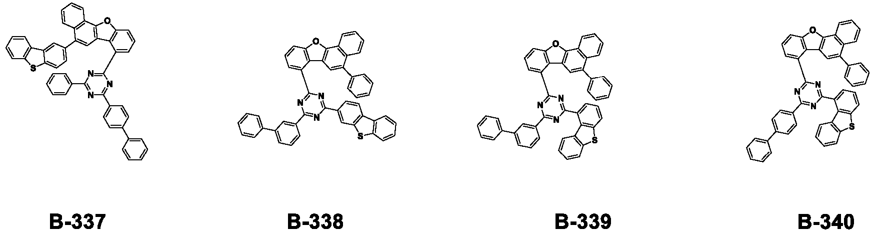

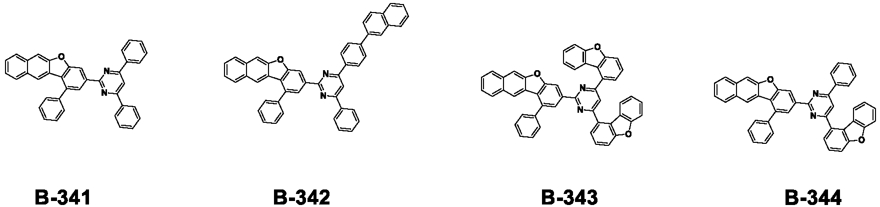

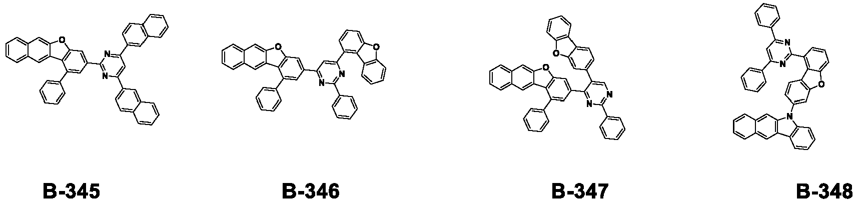

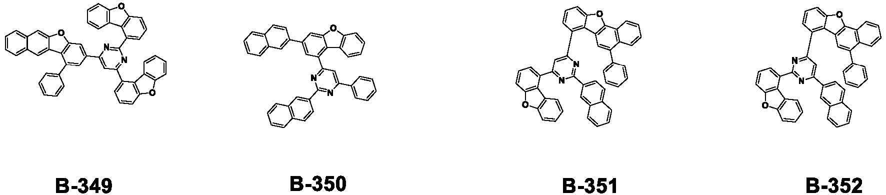

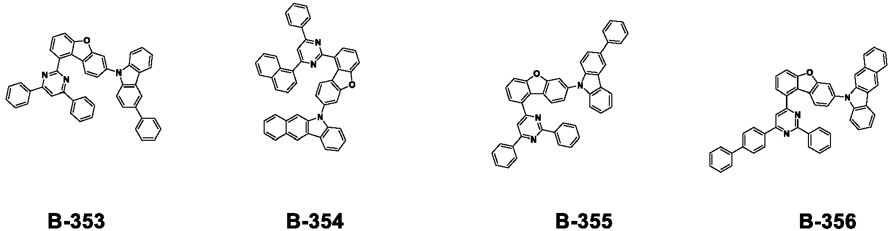

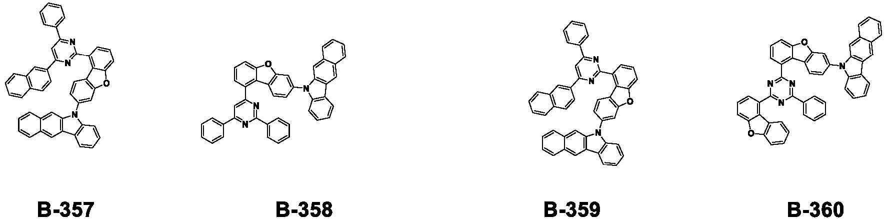

It is possible to synthesize a compound having inherent characteristics of a substituent introduced by introducing various substituents into the structure(s) represented by Chemical Formulae A and/or B. For example, it is possible to synthesize a material which satisfies conditions required for each organic material layer by introducing a substituent usually used for a hole injection layer material, a hole transport layer material, a hole transport auxiliary layer material, an emission layer material, an electron transport layer material, an electron transport auxiliary layer material, and a charge generation layer material used during the manufacture of an organic light emitting device into the core structure.

In addition, it is possible to finely adjust an energy band gap by introducing various substituents into the structures of Chemical Formulae A and/or B, and meanwhile, it is possible to improve characteristics at the interface between organic materials and diversify the use of material.

According to an exemplary embodiment of the present specification, the organic material layer further includes an emission layer, and the emission layer may include the heterocyclic compound represented by Chemical Formula A; and the heterocyclic compound represented by Chemical Formula B.

In another exemplary embodiment of the present specification, the emission layer may include each of the heterocyclic compound represented by Chemical Formula A; and the heterocyclic compound represented by Chemical Formula B as a host.

According to an exemplary embodiment of the present specification, the emission layer may include each of the heterocyclic compound represented by Chemical Formula A; and the heterocyclic compound represented by Chemical Formula B as a red host.

According to an exemplary embodiment of the present specification, the emission layer may include each of the heterocyclic compound represented by Chemical Formula A; and the heterocyclic compound represented by Chemical Formula B as a green host.

According to an exemplary embodiment of the present specification, the emission layer may include each of the heterocyclic compound represented by Chemical Formula A; and the heterocyclic compound represented by Chemical Formula B as a blue host.

According to an exemplary embodiment of the present specification, the first electrode may be a positive electrode, and the second electrode may be a negative electrode.

According to an exemplary embodiment of the present specification, the first electrode may be a negative electrode, and the second electrode may be a positive electrode.

According to an exemplary embodiment of the present specification, the organic light emitting device may be a blue organic light emitting device, and each of the heterocyclic compound represented by Chemical Formula A; and the heterocyclic compound represented by Chemical Formula B may be used as a material for a blue organic light emitting device.

According to an exemplary embodiment of the present specification, the organic light emitting device may be a green organic light emitting device, and each of the heterocyclic compound represented by Chemical Formula A; and the heterocyclic compound represented by Chemical Formula B may be used as a material for a green organic light emitting device.

According to an exemplary embodiment of the present specification, the organic light emitting device may be a red organic light emitting device, and each of the heterocyclic compound represented by Chemical Formula A; and the heterocyclic compound represented by Chemical Formula B may be used as a material for a red organic light emitting device.

The organic material layer of the organic light emitting device of the present specification may also have a single-layered structure, but may have a multi-layered structure in which two or more organic material layers are stacked. For example, the organic light emitting device of the present specification may have a structure including a hole injection layer, a hole transport layer, an emission layer, an electron transport layer, an electron injection layer, and the like as organic material layers. However, the structure of the organic light emitting device is not limited thereto, and may include less or more numbers of organic material layers.

According to an exemplary embodiment of the present specification, the organic material layer may include an iridium-based dopant.

According to an exemplary embodiment of the present specification, as the iridium-based dopant, Ir(ppy)₃, which is a green phosphorescent dopant, may be used, but the iridium-based dopant is not limited thereto.

According to an exemplary embodiment of the present specification, as the iridium-based dopant, (piq)₂(Ir)(acac), which is a red phosphorescent dopant, may be used, but the iridium-based dopant is not limited thereto.

In the organic light emitting device of the present specification, as a positive electrode material, materials having a relatively high work function may be used, and a transparent conductive oxide, a metal or a conductive polymer, and the like may be used. Specific examples of the positive electrode material include: a metal such as vanadium, chromium, copper, zinc, and gold, or an alloy thereof; a metal oxide such as zinc oxide, indium oxide, indium tin oxide (ITO), and indium zinc oxide (IZO); a combination of a metal and an oxide, such as ZnO:Al or SnO₂:Sb; a conductive polymer such as poly(3-methylthiophene), poly[3,4-(ethylene-1,2-dioxy)thiophene] (PEDOT), polypyrrole, and polyaniline; and the like, but are not limited thereto.

In the organic light emitting device of the present specification, as a negative electrode material, materials having a relatively low work function may be used, and a metal, a metal oxide, or a conductive polymer, and the like may be used. Specific examples of the negative electrode material include: a metal such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

In the organic light emitting device of the present specification, as a hole injection material, a publicly-known hole injection material may also be used, and it is possible to use, for example, a phthalocyanine compound such as copper phthalocyanine disclosed in US Patent No. 4,356,429 or starburst-type amine derivatives described in the document [Advanced Material, 6, p. 677 (1994)], for example, tris(4-carbazoyl-9-ylphenyl)amine (TCTA), 4,4',4"-tri[phenyl(m-tolyl)amino]triphenylamine (m-MTDATA), 1,3,5-tris[4-(3-methylphenylphenylamino)phenyl]benzene (m-MTDAPB), polyaniline/dodecylbenzenesulfonic acid or poly(3,4-ethylenedioxythiophene)/poly(4-styrenesulfonate), which is a soluble conductive polymer, polyaniline/camphor sulfonic acid or polyaniline/poly(4-styrene-sulfonate), and the like.

In the organic light emitting device of the present specification, as a hole transport material, a pyrazoline derivative, an arylamine-based derivative, a stilbene derivative, a triphenyldiamine derivative, and the like may be used, and a low-molecular weight or polymer material may also be used.

In the organic light emitting device of the present specification, as an electron transport material, it is possible to use an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, a metal complex of 8-hydroxyquinoline and a derivative thereof, and the like, and a low-molecular weight material and a polymer material may also be used.

In the organic light emitting device of the present specification, as an electron injection material, for example, LiF is representatively used in the art, but the present specification is not limited thereto.

In the organic light emitting device of the present specification, as a light emitting material, a red, green, or blue light emitting material may be further used, and if necessary, two or more light emitting materials may be mixed and used. In this case, two or more light emitting materials may be deposited or used as an individual supply source, or pre-mixed to be deposited and used as one supply source. Further, a fluorescent material may also be used as the light emitting material, but may also be used as a phosphorescent material. As the light emitting material, it is also possible to use alone a material which emits light by combining holes and electrons each injected from a positive electrode and a negative electrode, but materials in which a host material and a dopant material are involved in light emission together may also be used.

When hosts of the light emitting material are mixed and used, the same series of hosts may also be mixed and used, and different series of hosts may also be mixed and used. For example, two or more types of materials selected from N-type host materials or P-type host materials may be used as a host material for an emission layer.

The organic light emitting device according to an exemplary embodiment of the present specification may be a top emission type, a bottom emission type, or a dual emission type according to the material to be used.

The heterocyclic compound according to an exemplary embodiment of the present specification may act even in organic electronic devices including organic solar cells, organic photoconductors, organic transistors, and the like, based on the principle similar to those applied to organic light emitting devices.

The organic light emitting device of the present specification may further include one or two or more layers selected from the group consisting of an emission layer, a hole injection layer, a hole transport layer, a hole transport auxiliary layer, an electron injection layer, an electron transport layer, an electron blocking layer, and a hole blocking layer.

FIGS. 1 to 3 exemplify the stacking sequence of the electrodes and the organic material layer of the organic light emitting device according to an exemplary embodiment of the present specification. However, the scope of the present application is not intended to be limited by these drawings, and the structure of the organic light emitting device known in the art may also be applied to the present application.

According to FIG. 1, an organic light emitting device in which a positive electrode 200, an organic material layer 300, and a negative electrode 400 are sequentially stacked on a substrate 100 is illustrated. However, the organic light emitting device is not limited only to such a structure, and as illustrated in FIG. 2, an organic light emitting device in which a negative electrode, an organic material layer, and a positive electrode are sequentially stacked on a substrate may also be implemented. The composition for an organic light emitting device may be included in the organic material layer 300, and the organic material layer 300 may be one or more layers.

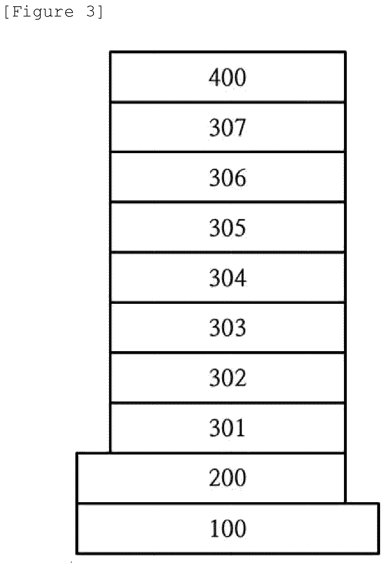

FIG. 3 exemplifies a case where an organic material layer is a multilayer. The organic light emitting device according to FIG. 3 includes a hole injection layer 301, a hole transport layer 302, an electron blocking layer 303, an emission layer 304, a hole blocking layer 305, an electron transport layer 306, and an electron injection layer 307. The composition for an organic light emitting device may be included in the emission layer 304. However, the scope of the present application is not limited by the stacking structure as described above, and if necessary, the other layers except for the emission layer may be omitted, and another necessary functional layer may be further added.

The organic light emitting device according to an exemplary embodiment of the present specification includes a first electrode; a first stack provided on the first electrode and including a first emission layer; a charge generation layer provided on the first stack; a second stack provided on the charge generation layer and including a second emission layer; and a second electrode provided on the second stack.

When the organic light emitting device according to an exemplary embodiment of the present specification has a two-stack structure as described above, one or more layers of the first emission layer (first stack emission layer) and the second emission layer (second stack emission layer) may include the heterocyclic compound represented by Chemical Formula A; and the heterocyclic compound represented by Chemical Formula B.

Furthermore, the first stack and the second stack may each independently further include one or more of the above-described hole injection layer, hole transport layer, hole blocking layer, electron transport layer, electron injection layer, and the like.

The heterocyclic compound represented by Chemical Formula A and the heterocyclic compound represented by Chemical Formula B may be used during the formation of an organic material layer of an organic light emitting device, and may be particularly more preferably used as a material for an emission layer.

The heterocyclic compound represented by Chemical Formula A; and the heterocyclic compound represented by Chemical Formula B may be in the form of a premix of the compounds, may be mixed with a material in a powder state before the organic material layer of the organic light emitting device is formed, and may be mixed with a compound in a liquid state at a suitable temperature or higher. The composition is in a solid state at a temperature which is equal to or less than the melting point of each material, and may be maintained as a liquid phase when the temperature is adjusted.

The heterocyclic compound represented by Chemical Formula A and the heterocyclic compound represented by Chemical Formula B may further include materials publicly-known in the art, such as solvents and additives.

### <Composition for organic material layer of organic light emitting device>

Hereinafter, the composition for an organic material layer of an organic light emitting device according to the present specification will be described.

Another exemplary embodiment of the present specification is a composition for an organic material layer of an organic light emitting device that is characterized by including the heterocyclic compound represented by Chemical Formula A and the heterocyclic compound represented by Chemical Formula B. In addition, the description on each of the compounds of Chemical Formula A and Chemical Formula B included in the composition for an organic material layer of an organic light emitting device is the same as those described above.

According to an exemplary embodiment of the present specification, the weight ratio of the heterocyclic compound represented by Chemical Formula A to the heterocyclic compound represented by Chemical Formula B may be 1:10 to 10:1.

According to an exemplary embodiment of the present specification, the weight ratio of the heterocyclic compound represented by Chemical Formula A to the heterocyclic compound represented by Chemical Formula B may be 1:5 to 5:1.

According to an exemplary embodiment of the present specification, the weight ratio of the heterocyclic compound represented by Chemical Formula A to the heterocyclic compound represented by Chemical Formula B may be 1:3 to 3:1.

In addition, the composition for an organic material layer including the heterocyclic compound of Chemical Formula A and the heterocyclic compound of Chemical Formula B provides excellent thermal stability when used in an organic light emitting device, and such thermal stability may provide driving stability to organic light emitting devices in the future as well as improve service life characteristics.

### <Method for manufacturing organic light emitting device>

An exemplary embodiment of the present specification provides a method for manufacturing an organic light emitting device, the method including: preparing a substrate; forming a first electrode on the substrate; forming an organic material layer having one or more layers on the first electrode; and forming a second electrode on the organic material layer, in which the forming of the organic material layer includes forming the organic material layer having one or more layers by using the above-described composition for an organic material layer of an organic light emitting device.

In an exemplary embodiment of the present specification, in the forming of the organic material layer, the organic material layer may be formed by pre-mixing the heterocyclic compound of Chemical Formula A and the heterocyclic compound of Chemical Formula B, and using a thermal vacuum deposition method.

The pre-mixing means that before the heterocyclic compound of Chemical Formula 1 and the heterocyclic compound of Chemical Formula 2 are deposited onto an organic material layer, the materials are first mixed and the mixture is contained in one common container and mixed.
The pre-mixed material may be referred to as a composition for an organic material layer according to an exemplary embodiment of the present application.

The organic light emitting device according to an exemplary embodiment of the present specification may be manufactured by typical manufacturing methods and materials of the organic light emitting device, except that the above-described composition for an organic material layer of an organic light emitting device is used to form an organic material layer.

Specifically, in the method of forming an organic material layer, when an organic light emitting device is manufactured, the organic material layer may be formed not only by a vacuum deposition method, but also by a solution coating method using the heterocyclic compound of Chemical Formula A and the heterocyclic compound of Chemical Formula B. Herein, the solution coating method means spin coating, dip coating, inkjet printing, screen printing, a spray method, roll coating, and the like, but is not limited thereto.

Hereinafter, the present specification will be described in more detail through Examples, but these Examples are provided only for exemplifying the present application, and are not intended to limit the scope of the present application.

### Preparation Examples.

### [Preparation Example 1] Preparation of Compound A-5

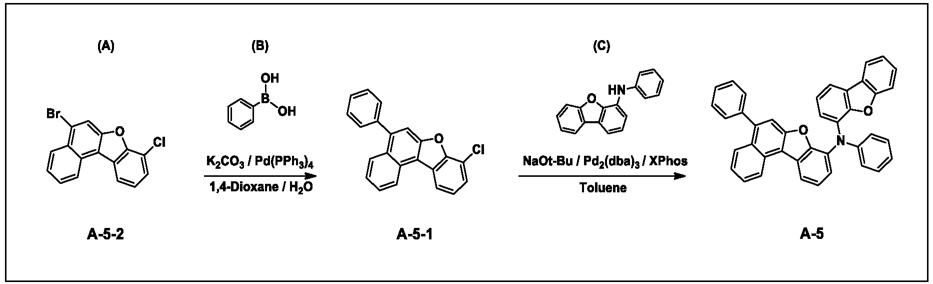

### 1) Preparation of Compound A-5-1

1,4-Dioxane (250 ml) and water (50 ml) were put into A-5-2(A) (20 g, 0.060 mol, 1 eq), phenylboronic acid (B) (8.04 g, 0.066 mol, 1.1 eq), K₂CO₃ (20.8 g, 0.151 mol, 2.5 eq), and Pd(PPh₃)₄ (3.38 g, 0.003 mol, 0.05 eq), and the resulting mixture was stirred at 100°C for 6 h (hours). After the reaction was terminated by adding water thereto, extraction was performed using methylene chloride (MC) and water. Thereafter, moisture was removed with MgSO₄. The residue was separated by silica gel column to obtain 15.8 g of Compound A-5-1 with a yield of 80%.

### 2) Preparation of Compound A-5

Toluene (120 ml) was put into A-5-1 (6 g, 0.018 mol, 1 eq), N-phenyldibenzo[b,d]furan-4-amine (C) (6.5 g, 0.020 mol, 1.1 eq), NaOt-Bu (2.6 g, 0.028 mol, 1.5 eq), Pd₂(dba)₃ (0.84 g, 0.0009 mol, 0.05 eq), and XPhos (0.84 g, 0.0018 mol, 0.1 eq), and the resulting mixture was stirred at 100°C for 8 h. After the reaction was terminated by adding water, extraction was performed using MC and water. Thereafter, moisture was removed with MgSO₄. The residue was separated by silica gel column to obtain 7 g of Compound A-5 with a yield of 79%.

### [Preparation Example 2] Preparation of Compound A-341

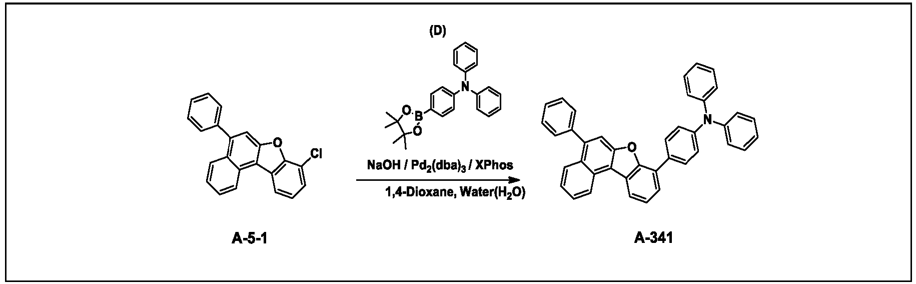

### 1) Preparation of Compound A-341

1,4-Dioxane (50 ml) and water (10 mL) were put into A-5-1 (5 g, 0.015 mol, 1 eq) in Preparation Example 1, N,N-diphenyl-4-(4,4,5,5-tetramethyl-1,3,2-dioxaborolan-2-yl)aniline (D) (6.8 g, 0.018 mol, 1.2 eq), NaOH (1.5 g, 0.038 mol, 2.5 eq), Pd₂(dba)₃ (0.7 g, 0.0008 mol, 0.05 eq), and XPhos (0.7 g, 0.0015 mol, 0.1 eq), and the resulting mixture was stirred at 100°C for 8 h. After the reaction was terminated by adding water, extraction was performed using MC and water. Thereafter, moisture was removed with MgSO₄. The residue was separated by silica gel column to obtain 5.5 g of Compound A-341 with a yield of 67%.

### [Preparation Example 3] Preparation of other Compound A

Compound A was synthesized in the same manner as in Preparation Example 1 or 2 using Intermediates A, B, C, and D in the following Table 1 instead of Intermediates (A), (B), (C), and (D) described in Preparation Example 1 or 2.

**[Table 1]**

| Compound No. | Intermediat e A | Intermediat e B | Intermediat e C | Intermediat e D |
|---|---|---|---|---|
| A-1 | 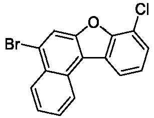 | 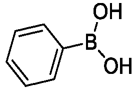 | 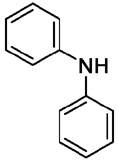 | - |
| A-34 | 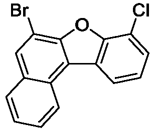 | 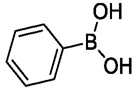 | 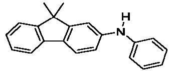 | - |
| A-45 | 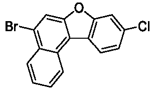 | 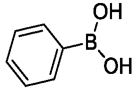 | 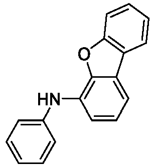 | - |
| A-46 | 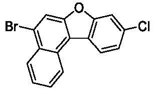 | 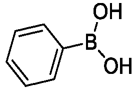 | 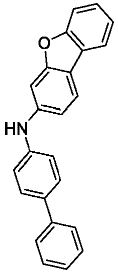 | - |
| A-64 | 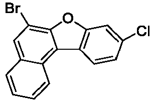 | 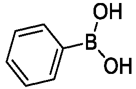 | 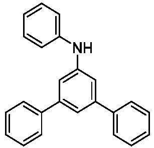 | - |
| A-90 | 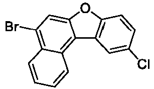 | 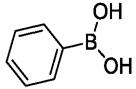 | 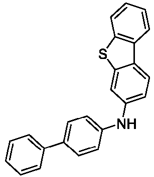 | - |
| A-116 | 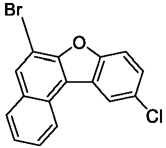 | 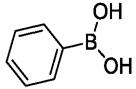 | 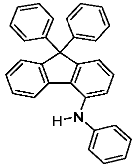 | - |
| A-123 | 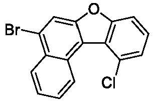 | 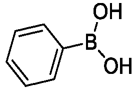 | 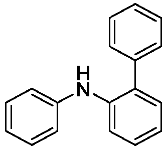 | - |
| A-150 | 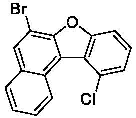 | 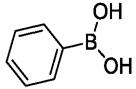 | 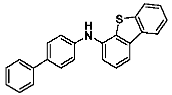 | - |
| A-161 | 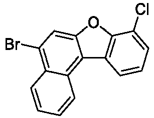 | 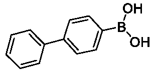 | 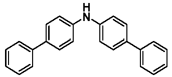 | - |
| A-183 | 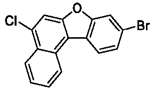 | 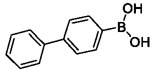 | 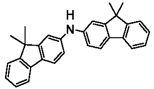 | - |
| A-214 | 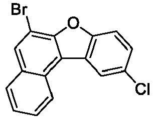 | 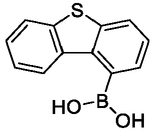 | 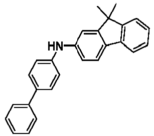 | - |
| A-227 | 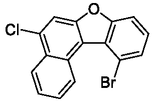 | 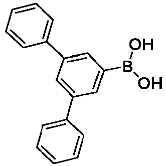 | 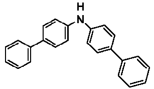 | - |
| A-253 | 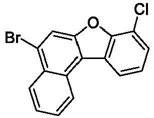 | 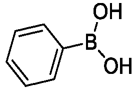 | 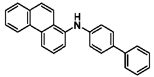 | - |
| A-263 | 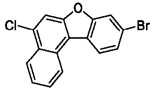 | 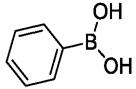 | 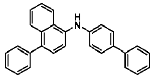 | - |
| A-289 | 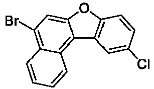 | 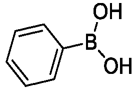 | 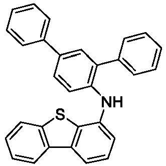 | - |
| A-308 | 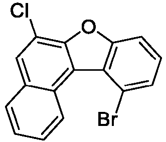 | 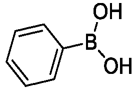 | 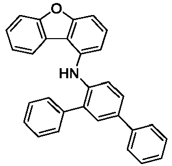 | - |
| A-355 | 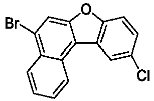 | 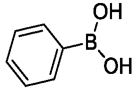 | - | 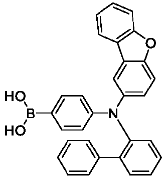 |
| A-365 | 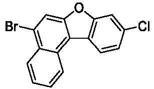 | 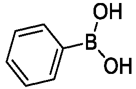 | 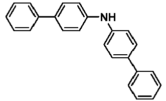 | - |
| A-369 | 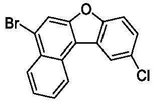 | 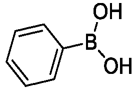 | 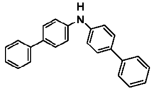 | - |
| A-381 | 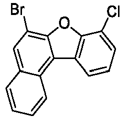 | 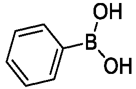 | 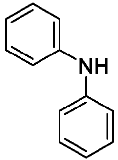 | - |
| A-383 | 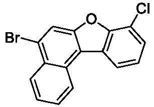 | 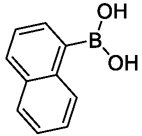 | 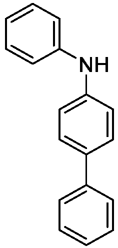 | - |
| A-402 | 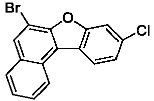 | 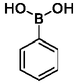 | 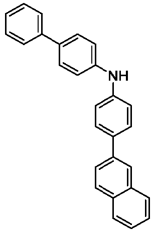 | - |
| A-432 | 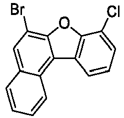 | 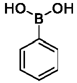 | 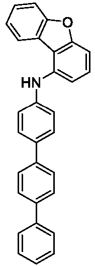 | - |

### [Preparation Example 4] Preparation of Compound B-1

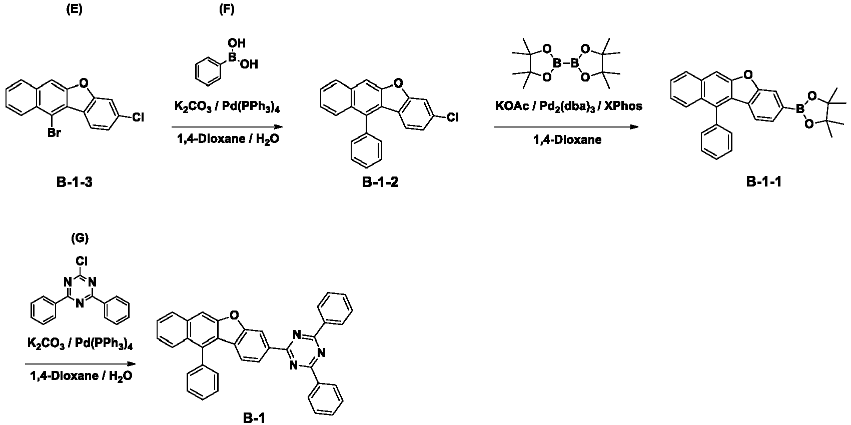

### 1) Preparation of Compound B-1-2

1,4-Dioxane (250 ml) and water (50 ml) were put into B-1-3 (E) (20 g, 0.060 mol, 1 eq), phenylboronic acid (F) (8.09 g, 0.066 mol, 1.1 eq), K₂CO₃ (20.8 g, 0.151 mol, 2.5 eq), and Pd(PPh₃)₄ (3.38 g, 0.003 mol, 0.05 eq), and the resulting mixture was stirred at 100°C for 6 h. After the reaction was terminated by adding water, extraction was performed using MC and water. Thereafter, moisture was removed with MgSO₄. The residue was separated by silica gel column to obtain 17 g of Compound B-1-2 with a yield of 86%.

### 2) Preparation of Compound B-1-1

1,4-Dioxane (200 ml) was put into B-1-2 (17 g, 0.052 mol, 1 eq), 4,4,5,5-tetramethyl-2-(4,4,5,5-tetramethyl-1,3,2-dioxaborolan-2-yl)-1,3,2-dioxaborolane (26 g, 0.103 mol, 2 eq), KOAc (15 g, 0.155 mol, 3 eq), Pd₂(dba)₃ (2.37 g, 0.0026 mol, 0.05 eq), and XPhos (2.46 g, 0.0052 mol, 0.1 eq), and the resulting mixture was stirred at 100°C for 8 h. After the reaction was terminated by adding water, extraction was performed using MC and water. Thereafter, moisture was removed with MgSO₄. The residue was separated by silica gel column to obtain 15 g of Compound B-1-1 with a yield of 69%.

### 3) Preparation of Compound B-1

1,4-Dioxane (100 ml) and water (20 mL) were put into B-1-1 (10 g, 0.024 mol, 1.05 eq), 2-chloro-4,6-diphenyl-1,3,5-triazine(G) (6.1 g, 0.023 mol, 1 eq), K₂CO₃ (6.27 g, 0.045 mol, 2 eq), and Pd(PPh₃)₄ (1.3 g, 0.001 mol, 0.05 eq), and the resulting mixture was stirred at 100°C for 8 h. After the reaction was terminated by adding water, extraction was performed using MC and water. Thereafter, moisture was removed with MgSO₄. The residue was separated by silica gel column to obtain 9 g of Compound B-1 with a yield of 75%.

### [Preparation Example 5] Preparation of other Compound B

Compound B was synthesized in the same manner as in Preparation Example 4 using Intermediates E, F, and G in the following Table 2 instead of Intermediates (E), (F), and (G) described in Preparation Example 4.

**[Table 2]**

| Compound No. | Intermediate E | Intermediate F | Intermediate G |
|---|---|---|---|
| B-21 | 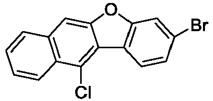 | 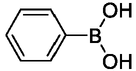 | 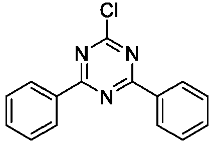 |
| B-45 | 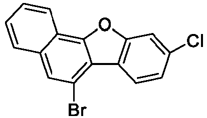 | 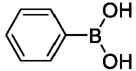 | 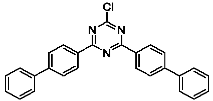 |
| B-62 | 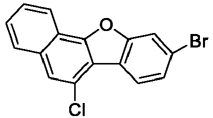 | 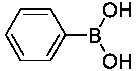 | 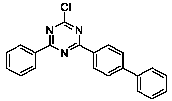 |
| B-86 | 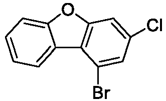 | 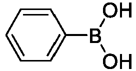 | 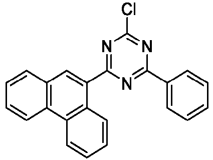 |
| B-114 | 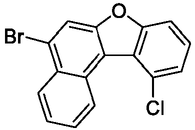 | 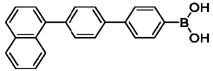 | 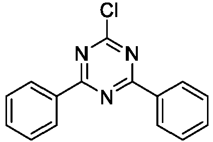 |
| B-134 | 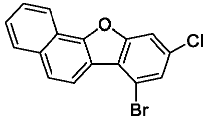 | 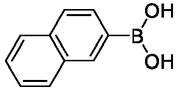 | 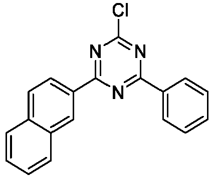 |
| B-150 | 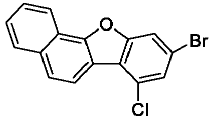 | 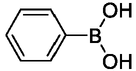 | 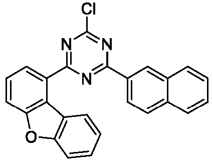 |
| B-170 | 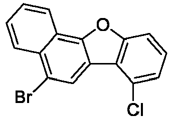 | 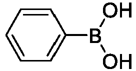 | 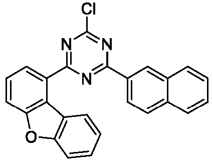 |
| B-172 | 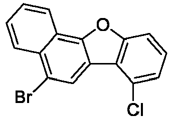 | 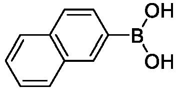 | 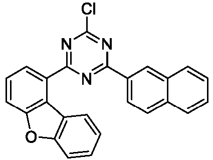 |
| B-176 | 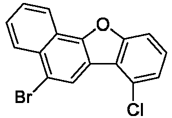 | 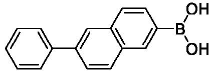 | 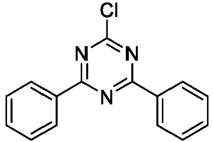 |
| B-199 | 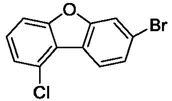 | 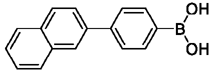 | 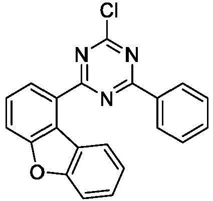 |
| B-217 | 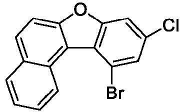 | 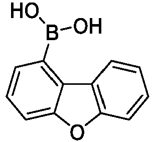 | 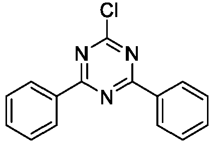 |
| B-225 | 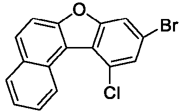 | 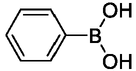 | 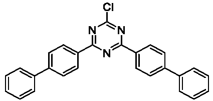 |
| B-281 | 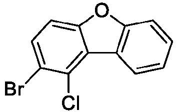 | 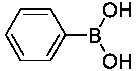 | 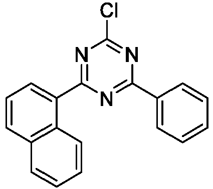 |
| B-282 | 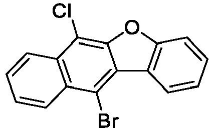 | 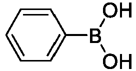 | 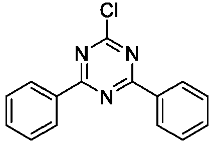 |
| B-287 | 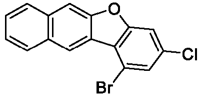 | 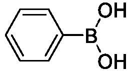 | 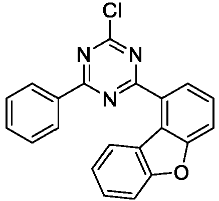 |
| B-307 | 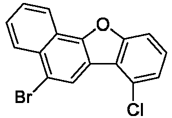 | 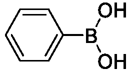 | 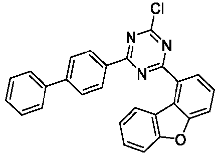 |
| B-313 | 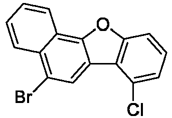 | 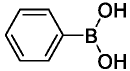 | 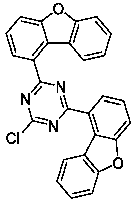 |
| B-346 | 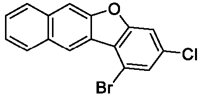 | 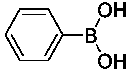 | 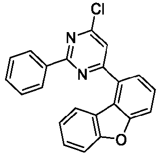 |

### [Preparation Example 6] Preparation of Compound A-323

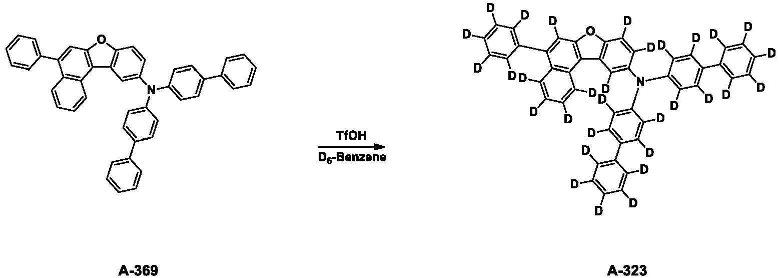

### 1) Preparation of Compound A-323

After Compound A-369 (10 g, 0.016 mol, 1 eq), TfOH (3.7 g, 0.024 mol, 1.5 eq), and D₆-benzene (100 ml) were put into a container, the resulting mixture was stirred at 100°C for 8 hours. After the reaction was terminated by adding water, extraction was performed using MC and water. Thereafter, moisture was removed with MgSO₄. The residue was separated by silica gel column to obtain 8.2 g of Compound A-323 with a yield of 78%.

### [Preparation Example 7] Preparation of Compound B-242

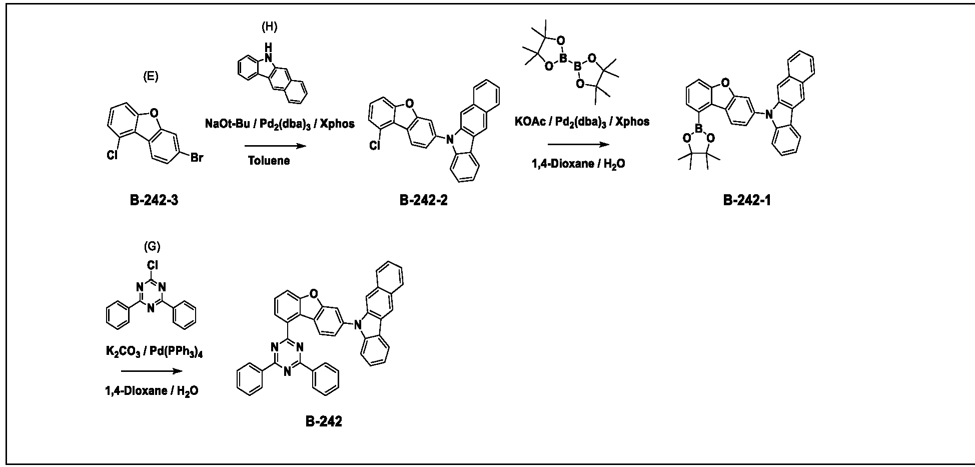

### 1) Preparation of Compound B-242-2

Toluene (100 mL) was put into B-242-3 (E) (10 g, 0.035 mmol, 1 eq), 5H-Benzo[b]carbazole (H) (7.72 g, 0.035 mmol, 1 eq), NaOt-Bu (6.83 g, 0.071 mmol, 2 eq), Xphos (1.69 g, 0.0035 mmol, 0.1 eq), and Pd₂(dba)₃ (1.3 g, 0.0014 mmol, 0.04 eq), and the resulting mixture was stirred at 100°C for 3 h. After the reaction was terminated by adding water, extraction was performed using MC and water. Thereafter, moisture was removed with MgSO₄. The residue was separated by silica gel column to obtain 14 g of Compound B-242-2 with a yield of 94%.

### 2) Preparation of Compound B-242-1

1,4-Dioxane (150 ml) was put into B-242-2 (14 g, 0.034 mol, 1 eq), 4,4,5,5-tetramethyl-2-(4,4,5,5-tetramethyl-1,3,2-dioxaborolan-2-yl)-1,3,2-dioxaborolane (17 g, 0.067 mol, 2 eq), KOAc (9.66 g, 0.100 mol, 3 eq), Pd₂(dba)₃ (1.53 g, 0.0017 mol, 0.05 eq), and XPhos (1.6 g, 0.0034 mol, 0.1 eq), and the resulting mixture was stirred at 100°C for 8 h. After the reaction was terminated by adding water, extraction was performed using MC and water. Thereafter, moisture was removed with MgSO₄. The residue was separated by silica gel column to obtain 15 g of Compound B-242-1 with a yield of 87%.

### 3) Preparation of Compound B-242

1,4-Dioxane (150 ml) and water (30 mL) were put into B-242-1 (15 g, 0.029 mol, 1.05 eq), 2-chloro-4,6-diphenyl-1,3,5-triazine(G) (7.51 g, 0.028 mol, 1 eq), K₂CO₃ (5.95 g, 0.056 mol, 2 eq), and Pd(PPh₃)₄ (1.62 g, 0.0014 mol, 0.05 eq), and the resulting mixture was stirred at 100°C for 8 h. After the reaction was terminated by adding water, extraction was performed using MC and water. Thereafter, moisture was removed with MgSO₄. The residue was separated by silica gel column to obtain 15 g of Compound B-242 with a yield of 86%.

Compounds were prepared in the same manner as in the Preparation Examples, and the synthesis confirmation results thereof are each shown in the following Tables 3 and 4. The following Table 3 shows the measured values of ¹H NMR(CDCl₃, 200 MHz), and the following Table 4 shows the measured values of field desorption mass spectrometry (FD-MS).

**[Table 3]**

| Compound No. | ¹H NMR(CDCl₃, 200MHz) |
|---|---|
| A-1 | δ= 8.97(2H, m), 7.79(2H, m), 7.64~7.59(3H, m), 7.46~7.41(3H, m), 7.31~7.24(6H, m), 7.08~6.97(7H, m) |
| A-34 | δ= 8.02~7.98(2H, m), 7.90(1H, d), 7.64~7.38(13H, m), 7.28~7.24(4H, m), 7.08~6.97(5H,m), 1.69(6H, s) |
| A-45 | δ= 8.97(2H, m), 8.03-7.98(2H, m), 7.80~7.79(3H, m), 7.64~7.24(13H, m), 7.08~6.91(5H, m) |
| A-46 | δ= 8.97(2H, d), 8.03 (2H, s), 7.98(1H, d), 7.80~7.75(6H, m), 7.59~7.31(16H, m), 6.91(2H, d) |
| A-64 | δ= 8.03~7.98(3H, m), 7.80~7.75(5H, m), 7.60~7.37(17H, m), 7.24(2H, m), 7.08~7.00(3H, m), 6.91(1H, d) |
| A-90 | δ= 8.97(2H, m), 8.45(1H, d), 8.22(1H, s), 8.01(1H, d), 7.93(1H, d), 7.79~7.75(4H, m), 7.64~7.31(18H, m) 6.97(1H, d) |
| A-116 | δ= 8.22(1H, s), 8.02~7.98(2H, m), 7.90(1H, d), 7.59~7.38(11H, m), 7.26~6.97(20H, m) |
| A-123 | δ= 8.97 (2H, m), 8.10 (1H, d), 7.79 (2H, m), 7.59(2H, m) 7.46~7.00(19H, m), 6.91(1H, d) |
| A-150 | δ= 8.45(1H, d), 8.02~7.93(4H, m), 7.59~7.24(16H, m), 7.08~6.91(4H, m) |
| A-161 | δ= 8.97(2H, m), 7.75 (6H, m), 7.64~7.25(26H, m), 6.97(1H, d) |
| A-183 | δ= 8.97(2H, m), 8.04(1H, s), 7.90~7.75(7H, m), 7.59~7.25(18H, m), 7.16(2H, m) 6.91(1H, d), 1.69(12H, s) |
| A-214 | δ= 8.45(1H, d), 8.22(1H, s), 8.03~7.86(7H, m), 7.75~7.28(20H, m), 7.16(1H, d), 6.97(1H,d), 1.69(6H, s) |
| A-227 | δ= 8.97(2H, m), 8.04(3H, s), 7.75(8H, m), 7.59~7.31(24H, m), 7.25(1H, m), 6.91(1H, d) |
| A-253 | δ= 8.97(2H, m), 8.84(1H, m), 8.64(1H, m), 7.92~7.90(2H, m), 7.79~7.28(24H, m), 6.97(1H, m) |
| A-263 | δ= 8.97~8.95(3H, m), 8.27(1H, m), 8.03(1H, m), 7.79~7.80(7H, m), 7.61~7.31(20H, m), 6.91(1H, d) |
| A-289 | δ= 8.97(2H, m), 8.45(1H, d), 8.22(1H, s), 8.11(1H, d), 7.93~7.90(2H, m), 7.79~7.75(4H, m), 7.65~7.41(18H, m), 7.08(2H, m), 6.97(1H, d) |
| A-308 | δ= 8.02~7.98(3H, m), 7.90(1H, s), 7.65~7.25(23H, m), 7.08(2H, m), 6.91(2H, m) |
| A-339 | δ= 7.98(1H, d), 7.54~7.31(9H, m) |
| A-340 | δ= 7.98(1H, d), 7.54~7.31(9H, m) |
| A-355 | δ= 8.97(2H, m), 8.22(1H, s), 8.10(1H, d), 7.98(1H, d), 7.88~7.79(5H, m), 7.59~7.31(19H, m), 7.14~7.08(3H, m), 6.97(1H, d) |
| A-365 | δ= 8.97(2H, d, 8.03(1H, s), 7.80~7.75(7H, m), 7.59~7.31(20H, m), 6.91(1H, d) |
| A-369 | δ= 8.97(2H, m), 8.22(1H, s), 7.79~7.75(6H, m), 7.59~7.37(2H, m), 6.97(1H, m) |
| A-381 | δ= 8.02~7.98(2H, m), 7.64~7.39(9H, m), 7.28~7.24(5H, m), 7.08~6.97(7H, m) |
| A-383 | δ= 8.97-8.95 (3H, m), 8.50(1H, d), 8.20(1H, d), 8.09(1H, d), 7.77~7.75(3H, m), 7.59~7.24(16H, m), 7.08~6.97(4H, m) |
| A-402 | δ= 8.97(2H, d), 8.09~7.99(4H, d), 7.80~7.75(5H, d), 7.63~7.31(21H, m), 6.91(1H, d) |
| A-408 | δ= 8.97(2H, d), 8.22(1H, s), 8.03(1H, s), 7.98(1H, d), 7.80~7.75(5H, m), 7.59~7.31(17H, m), 6.97~6.91(2H, m) |
| A-432 | δ= 8.97(2H, d), 7.79~7.75(4H, d), 7.64~7.25(24H, m), 6.97~6.91(2H, d) |
| B-1 | δ= 8.97(1H, d), 8.36(4H, m), 8.03(1H, d), 7.76(2H, m), 7.65~7.36(14H, m) |
| B-21 | δ= 8.97(1H, d), 8.36(4H, m), 8.15(1H, d), 8.03(1H, d), 7.76(4H, m), 7.59~7.41(12H, m) |
| B-45 | δ=7.98(7H, m), 7.76(8H, m), 7.59~7.41(12H, m), 7.25(4H, m) |
| B-62 | δ=8.36(2H, m), 7.98(5H, m), 7.76(6H, m), 7.59~7.41(12H, m), 7.25(2H, d) |
| B-86 | δ= 9.08 (1H, d), 8.84 (1H, d), 8.36(2H, m), 8.17(1H, d), 7.98~7.31(20H, m) |
| B-114 | δ=8.97(2H, m), 8.36(4H, m), 8.09~7.97(5H, m), 7.82(1H, m), 7.69~7.50(15H, m), 7.40~7.38(3H, m), 7.31(1H, s) |
| B-134 | δ= 9.09(1H, t), 8.49(1H, t), 8.36(2H, m), 8.09(8H, m), 7.84(3H, m) 7.69~7.48(11H, m), 7.38(1H, t) |
| B-150 | δ=9.09(1H, t), 8.49(1H, t), 8.11(6H, m), 7.86~7.31(19H, m) |
| B-170 | δ= 9.09(1H, s), 8.97(1H, d), 8.49(1H, d), 8.18~7.98(5H, m), 7.82~7.79(4H, m), 7.69~7.31(15H, m) |
| B-172 | δ= 9.09(1H, s), 8.97(1H, d), 8.49(1H, d), 8.18~7.98(8H, m), 7.82(2H, d), 7.63~7.54(12H, m), 7.39~7.31(4H, m) |
| B-176 | δ= 8.97(1H, d), 8.36 (4H, m), 8.18 (1H, d), 7.97(2H, m), 7.82~7.38(21H, m) |
| B-199 | δ= 8.36(2H, m), 8.03(5H, m), 7.82~7.50(15H, m), 7.39~7.25(7H, m) |
| B-217 | δ= 8.54(1H, d), 8.36(4H, m), 7.99(2H, m), 7.82(3H, m), 7.69~7.50(13H, m), 7.31(2H, m) |
| B-225 | δ=8.54(1H, d), 7.96(5H, m), 7.75(8H, m), 7.61~7.41(13H, m), 7.25(4H, m) |
| B-242 | δ= 8.55(1H, d), 8.36~8.28(5H, d), 8.11(1H, d), 7.98~7.94(2H, m), 7.82~7.69(4H, m), 7.57~7.50(9H, m), 7.40~7.35(2H, m), 7.25(1H, d), 7.16(1H, d) |
| B-281 | δ=8.97(1H, d), 8.36 (2H, m), 8.25(1H, d), 8.15~7.98(5H, m), 7.89(1H, d), 7.79(2H, m), 7.59~7.39(11H, m) |
| B-282 | δ=8.97(2H, m), 8.36(4H, m), 7.98(1H, m), 7.65~7.31(16H, m) |
| B-257 | δ=9.09(1H, s), 8.43(1H, d), 8.16~8.08(3H, m), 7.61~7.59(2H, m) |
| B-258 | δ=8.36(2H, d), 7.50(3H, m) |
| B-287 | δ= 8.36~8.28(3H, d), 8.11(1H, d), 7.98(1H, d), 7.86~7.69(8H, m), 7.57~7.31(12H, m) |
| B-307 | δ= 8.97(1H, d), 8.18(1H, d), 7.98~7.96(3H, m), 7.82~7.25(24H, m) |
| B-313 | δ= 8.97(1H, d), 8.18(1H, d), 7.98(2H, d), 7.82~7.31(23H, d) |
| B-346 | δ= 8.35~8.23(4H, m), 8.11(1H, d), 7.98(1H, d), 7.86~7.69(8H,m), 7.57~7.31(12H, m) |

**[Table 4]**

| Compound No. | FD-MS | Compound No. | FD-MS |
|---|---|---|---|
| A-1 | m/z=461.18 | B-1 | m/z=525.18 |
| A-34 | m/z=577.24 | B-21 | m/z=525.18 |
| A-45 | m/z=551.19 | B-45 | m/z=677.25 |
| A-46 | m/z=627.22 | B-62 | m/z=601.22 |
| A-64 | m/z=613.24 | B-86 | m/z=575.20 |
| A-90 | m/z=643.20 | B-114 | m/z=701.25 |
| A-116 | m/z=701.27 | B-134 | m/z=625.22 |
| A-123 | m/z=537.21 | B-150 | m/z=665.21 |
| A-150 | m/z=567.17 | B-170 | m/z= 665.21 |
| A-161 | m/z=689.27 | B-172 | m/z=715.23 |
| A-183 | m/z=769.33 | B-176 | m/z=651.23 |
| A-214 | m/z=759.26 | B-199 | m/z=691.23 |
| A-227 | m/z=765.30 | B-217 | m/z=615.19 |
| A-253 | m/z=637.24 | B-225 | m/z=677.25 |
| A-263 | m/z=663.26 | B-242 | m/z= 614.21 |
| A-289 | m/z=719.23 | B-257 | m/z=685.34 |
| A-308 | m/z=703.25 | B-258 | m/z=635.34 |
| A-339 | m/z=646.34 | B-281 | m/z=525.18 |
| A-340 | m/z=646.34 | B-282 | m/z=525.18 |
| A-355 | m/z=703.25 | B-287 | m/z=615.19 |
| A-365 | m/z= 613.24 | B-307 | m/z=691.23 |
| A-369 | m/z=613.24 | B-313 | m/z=705.21 |
| A-381 | m/z=461.18 | B-346 | m/z=614.20 |
| A-383 | m/z=587.22 | | |
| A-402 | m/z=663.26 | | |
| A-408 | m/z=627.22 | | |
| A-432 | m/z=703.25 | | |

### Experimental Examples.

### <Experimental Example 1> Manufacture of Organic Light Emitting Device

A glass substrate, in which indium tin oxide (ITO) was thinly coated to have a thickness of 1,500 Å, was ultrasonically washed with distilled water. When the washing with distilled water was finished, the glass substrate was ultrasonically washed with a solvent such as acetone, methanol, and isopropyl alcohol, dried and then subjected to ultraviolet ozone (UVO) treatment for 5 minutes using UV in an ultraviolet (UV) washing machine. Thereafter, the substrate was transferred to a plasma washing machine (PT), and then was subjected to plasma treatment in a vacuum state for an ITO work function and in order to remove a residual film, and was transferred to a thermal deposition apparatus for organic deposition.

A hole injection layer 4,4',4"-tris[2-naphthyl(phenyl)amino]triphenylamine (2-TNATA), a hole transport layer N,N'-di(1-naphthyl)-N,N'-diphenyl-(1,1'-biphenyl)-4,4'-diamine (NPB) and an electron blocking layer cyclohexylidenebis[N,N-bis(4-methylphenyl)benzenamine] (TAPC), which are common layers, were formed on the ITO transparent electrode (positive electrode). An emission layer was thermally vacuum deposited thereon as follows. The emission layer was deposited to have a thickness of 400 Å by depositing a composition of the compounds (two compounds) described in the following Table 5 as a red host from a single supply source and doping the host with an Ir compound at 3 wt% using (piq)₂(Ir)(acac) as a red phosphorescent dopant. Thereafter, bathophenanthroline (Bphen) as a hole blocking layer was deposited to have a thickness of 30 Å, and 2,2',2' '-(1,3,5-benzinetriyl)-tris(1-phenyl-1-H-benzimidazole) (TPBI) as an electron transport layer was deposited to have a thickness of 250 Å thereon. Finally, lithium fluoride (LiF) was deposited to have a thickness of 10 Å on the electron transport layer to form an electron injection layer, and then an aluminum (Al) negative electrode was deposited to have a thickness of 1,200 Å on the electron injection layer to form a negative electrode, thereby manufacturing an organic light emitting device.

Meanwhile, all the organic compounds required for manufacturing an OLED device were subjected to vacuum sublimed purification under 10⁻⁸ to 10⁻⁶ torr for each material, and used for the manufacture of the OLED. For the organic light emitting device manufactured as described above, electroluminescence (EL) characteristics were measured by M7000 manufactured by McScience Inc., and based on the measurement result thereof, the service life (T₉₀) was measured by a service life measurement device (M6000) manufactured by McScience Inc., when the reference luminance was 6,000 cd/m² (cd/A). The results of measuring the driving voltage, light emitting efficiency, color coordinate (CIE), and service life of the organic light emitting device manufactured according to the present invention are shown in the following Table 5.

**[Table 5]**

| No. | Compound composition (P:N) | Weight ratio (P:N) | Driving voltage (V) | Light emitting efficien cy (cd/A) | CIE (x, y) | Service life (T₉₀) |
|---|---|---|---|---|---|---|
| Example 1 | A-123:B-86 | 1:1 | 4.51 | 58.0 | (0.68, 0.32) | 147 |
| Example 2 | A-227:B-176 | 1:1 | 4.52 | 59.2 | (0.68, 0.32) | 142 |
| Example 3 | A-308:B-150 | 1:1 | 4.52 | 60.2 | (0.68, 0.32) | 148 |
| Example 4 | A-1:B-21 | 3:1 | 4.42 | 66.0 | (0.68, 0.32) | 159 |
| Example 5 | A-1:B-21 | 2:1 | 4.41 | 65.8 | (0.68, 0.32) | 151 |
| Example 6 | A-1:B-21 | 1:1 | 4.43 | 64.0 | (0.68, 0.32) | 158 |
| Example 7 | A-1:B-21 | 1:2 | 4.44 | 67.7 | (0.68, 0.32) | 156 |
| Example 8 | A-1:B-21 | 1:3 | 4.41 | 65.6 | (0.68, 0.32) | 158 |
| Example 9 | A-34:B-45 | 1:1 | 4.47 | 64.5 | (0.68, 0.32) | 152 |
| Example 10 | A-161:B-21 | 1:1 | 4.40 | 64.8 | (0.68, 0.32) | 159 |
| Example 11 | A-253:B-62 | 1:1 | 4.40 | 62.9 | (0.68, 0.32) | 155 |
| Example 12 | A-383:B-287 | 1:1 | 4.42 | 65.8 | (0.68, 0.32) | 160 |
| Example 13 | A-432:B-307 | 1:1 | 4.41 | 66.2 | (0.68, 0.32) | 161 |
| Example 14 | A-254:B-313 | 1:1 | 4.41 | 65.8 | (0.68, 0.32) | 161 |
| Example 15 | A-90:B-1 | 1:1 | 4.30 | 71.0 | (0.68, 0.32) | 169 |
| Example 16 | A-116:B-217 | 1:1 | 4.31 | 71.1 | (0.68, 0.32) | 169 |
| Example 17 | A-214:B-217 | 1:1 | 4.30 | 70.5 | (0.68, 0.32) | 169 |
| Example 18 | A-289:B-134 | 1:1 | 4.30 | 72.2 | (0.68, 0.32) | 170 |
| Example 19 | A-355:B-86 | 1:1 | 4.37 | 71.3 | (0.68, 0.32) | 168 |
| Example 20 | A-369:B-176 | 1:1 | 4.31 | 73.2 | (0.68, 0.32) | 170 |
| Example 21 | A-64:B-62 | 1:1 | 4.21 | 77.7 | (0.68, 0.32) | 185 |
| Example 22 | A-45:B-150 | 1:1 | 4.27 | 77.8 | (0.68, 0.32) | 183 |
| Example 23 | A-183:B-114 | 1:1 | 4.27 | 77.7 | (0.68, 0.32) | 181 |
| Example 24 | A-263:B-225 | 1:1 | 4.22 | 77.9 | (0.68, 0.32) | 181 |
| Example 25 | A-365:B-346 | 1:1 | 4.22 | 78.0 | (0.68, 0.32) | 188 |
| Example 26 | A-402:B-172 | 1:1 | 4.19 | 81.0 | (0.68, 0.32) | 195 |
| Example 27 | A-46:B-242 | 1:1 | 4.11 | 81.1 | (0.68, 0.32) | 195 |
| Example 28 | A-408:B-170 | 1:1 | 4.13 | 82.2 | (0.68, 0.32) | 197 |
| Example 29 | A-339:B-258 | 1:1 | 4.05 | 88.3 | (0.68, 0.32) | 208 |
| Example 30 | A-340:B-257 | 1:1 | 4.02 | 88.4 | (0.68, 0.32) | 210 |
| Comparative | A-64 | - | 8.31 | 8.9 | (0.68, 0.32) | 6 |
| Example 1 | | | | | | |
| Comparative Example 2 | B-86 | - | 8.25 | 8.8 | (0.68, 0.32) | 5 |
| Comparative Example 3 | H1 | - | 8.32 | 8.8 | (0.68, 0.32) | 5 |
| Comparative Example 4 | H2 | - | 8.41 | 8.7 | (0.68, 0.32) | 5 |
| Comparative Example 5 | H1:H2 | 1:1 | 5.19 | 47.2 | (0.68, 0.32) | 131 |
| Comparative Example 6 | H1:B-134 | 1:1 | 4.95 | 49.6 | (0.68, 0.32) | 138 |
| Comparative Example 7 | A-289:H2 | 1:1 | 4.84 | 48.0 | (0.68, 0.32) | 134 |
| Comparative Example 8 | H3 | - | 6.50 | 38.3 | (0.68, 0.32) | 115 |
| Comparative Example 9 | B-281 | - | 8.51 | 8.8 | (0.68, 0.32) | 6 |
| Comparative Example 10 | A-381 | - | 8.46 | 8.7 | (0.68, 0.32) | 5 |
| Comparative Example 11 | B-282 | - | 8.57 | 8.6 | (0.68, 0.32) | 5 |

The structures of the compounds used in Comparative Examples 3 to 8 are as follows.

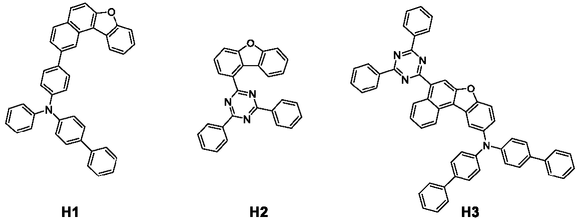

As can be seen from the results in Table 5, it could be confirmed that when the heterocyclic compound of the present invention was used as a P-type host and mixed with an N-type host and the mixture was deposited, the driving, efficiency, and service life of the organic light emitting device were improved. When a donor (p-host, a compound in Group A represented by P above) with good hole transporting ability and an acceptor (n-host, a compound in Group B represented by N above) with good electron transporting ability are used as hosts of the emission layer, the charge balance within the device can be adjusted because holes are injected into the p-host and electrons are injected into the n-host due to the exciplex phenomenon between the N-type host material and the P-type host material. From this, it could be seen that a combination of an N-type host compound with appropriate electron transfer characteristics and a P-type host compound with appropriate hole transfer characteristics at an appropriate ratio can help improve driving efficiency and service life.

In contrast, in the comparative example compounds used in Comparative Examples 3 to 8, H1 is 1-substituted naphthobenzofuran, which is compared to the heterocyclic compound represented by Chemical Formula A, which corresponds to the P-type host compound, H2 is 1-substituted benzofuran, which is compared to the heterocyclic compound represented by Chemical Formula B, which corresponds to the N-type host compound, and H3 simultaneously has the substituents (an amine group and a triazine group) described in the P-type host compound (Chemical Formula A) and the N-type host compound (Chemical Formula B), respectively, and may have a configuration that is compared to the combination of the heterocyclic compound represented by Chemical Formula A and the heterocyclic compound represented by Chemical Formula B.

According to Table 5, it could be confirmed that in Comparative Examples 3 and 4, in which H1 and H2 were used alone, respectively, a very high driving voltage, a very low efficiency, and a very short service were shown, it could be confirmed that in the case of Comparative Example 5 in which H1 and H2 were combined and Comparative Example 8 in which H3 was used alone, some improvement in device characteristics was shown compared to Comparative Examples 1 and 2, but the improvement was weaker than that of the group of the Examples, and it can be seen that in the case of Comparative Examples 6 and 7, in which only some of the conditions of the present invention (including any one of Chemical Formula A or B) are satisfied but the rest does not satisfy the above conditions, there is a difference compared to the group of the Examples even though there is a slight improvement in device characteristics. Additionally, it can be confirmed that Comparative Examples 1, 2, 9, 10, and 11, which are the cases that do not satisfy the above condition (a combination of the heterocyclic compound of Chemical Formula A and the heterocyclic compound of Chemical Formula B) and include one heterocyclic compound of Chemical Formula A or B, had deteriorated device characteristics to the levels that are those of Comparative Examples 3 and 4, so that that it could be confirmed that when the heterocyclic compound represented by Chemical Formula A of the present invention is used as a P-type host and the heterocyclic compound represented by Chemical Formula B is used as an N-type host, followed by mixing and depositing, the driving, efficiency, and service life of the organic light emitting device are improved.

The present invention is not limited to the Examples, but may be prepared in various forms, and a person with ordinary skill in the art to which the present invention pertains will understand that the present invention can be implemented in another specific form without changing the technical spirit or essential feature of the present invention. Therefore, it should be understood that the above-described Examples are illustrative only in all aspects and are not restrictive.

## Claims

1. An organic light emitting device comprising:
a first electrode;
a second electrode provided to face the first electrode; and
an organic material layer having one or more layers provided between the first electrode and the second electrode,
wherein one or more layers of the organic material layer comprise a heterocyclic compound represented by the following Chemical Formula A; and a heterocyclic compound represented by the following Chemical Formula B: 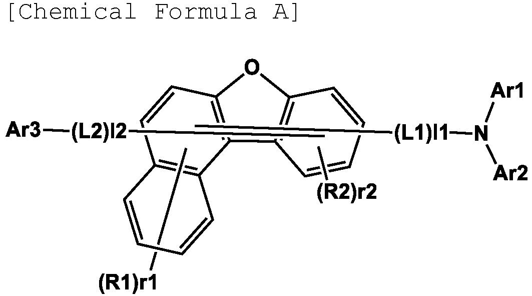 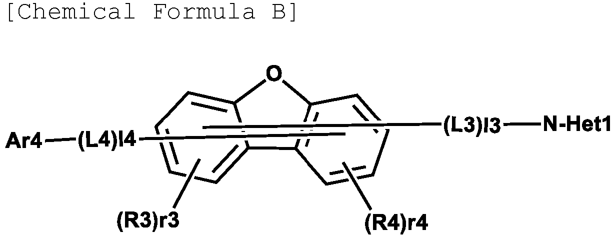
in Chemical Formulae A and B,
L1 to L4 are the same as or different from each other, and are each independently a direct bond; a substituted or unsubstituted arylene group having 6 to 60 carbon atoms; or a substituted or unsubstituted heteroarylene group having 2 to 60 carbon atoms,
Ar1 to Ar3 are the same as or different from each other, and are each independently a substituted or unsubstituted aryl group having 6 to 60 carbon atoms; a substituted or unsubstituted heteroaryl group having 2 to 60 carbon atoms; or a combination thereof,
Ar4 is a substituted or unsubstituted aryl group having 6 to 60 carbon atoms; a substituted or unsubstituted heteroaryl group having 2 to 60 carbon atoms; or a substituted or unsubstituted amine group,
R1 and R2 are the same as or different from each other, and are each independently hydrogen; deuterium; a halogen group; a cyano group; a substituted or unsubstituted alkyl group having 1 to 60 carbon atoms; a substituted or unsubstituted cycloalkyl group having 3 to 60 carbon atoms; a substituted or unsubstituted heterocycloalkyl group having 2 to 60 carbon atoms; a substituted or unsubstituted aryl group having 6 to 60 carbon atoms; or a substituted or unsubstituted heteroaryl group having 2 to 60 carbon atoms,
R3 and R4 are the same as or different from each other, and are each independently hydrogen; deuterium; a halogen group; a cyano group; a substituted or unsubstituted alkyl group having 1 to 60 carbon atoms; a substituted or unsubstituted cycloalkyl group having 3 to 60 carbon atoms; a substituted or unsubstituted heterocycloalkyl group having 2 to 60 carbon atoms; a substituted or unsubstituted aryl group having 6 to 60 carbon atoms; or a substituted or unsubstituted heteroaryl group having 2 to 60 carbon atoms, or two or more adjacent groups are bonded to each other to form a substituted or unsubstituted ring,
l1 to l4 are the same as or different from each other, and are each independently an integer from 1 to 3, and when each of l1 to l4 is an integer of 2 or higher, the types of substituents in the parenthesis are the same as or different from each other,
r1 is an integer from 0 to 6,
each of r2 to r4 is an integer from 0 to 4,
the sum of r1 and r2 is 8,
the sum of r3 and r4 is 6,
when each of l1 to l4 and r1 to r4 is an integer of 2 or higher, substituents in the parenthesis are the same as or different from each other,
N-Het1 is represented by the following Chemical Formula N, 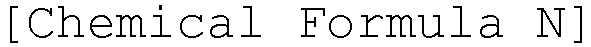 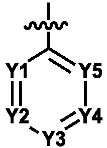
in Chemical Formula N, 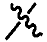
means a moiety linked to L3,
Y1 to Y5 are the same as or different from each other, and are each independently CRa or N, and at least one is N, and
Ra is a substituted or unsubstituted aryl group having 6 to 60 carbon atoms; or a substituted or unsubstituted heteroaryl group having 2 to 60 carbon atoms.

2. The organic light emitting device of claim 1, wherein Chemical Formula A is represented by the following Chemical Formula A-1: 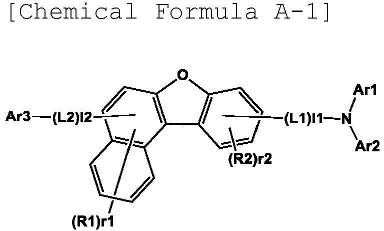
in Chemical Formula A-1,
each of L1, L2, Ar1 to Ar3, R1, R2, l1, l2, r1, and r2 is the same as that defined in Chemical Formula A.

3. The organic light emitting device of claim 1, wherein Chemical Formula B is represented by the following Chemical Formula B-1 or B-2: 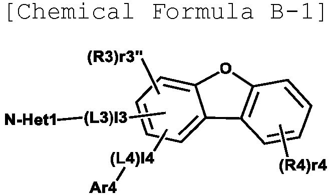 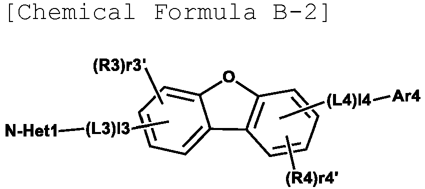
in Chemical Formulae B-1 and B-2,
each of L3, L4, Ar4, N-Het1, R3, R4, l3, l4, and r4 is the same as that defined in Chemical Formula B,
r3' is an integer from 0 to 3, and when r3' is an integer of 2 or higher, R3's are the same as or different from each other,
r3" is an integer from 0 to 2, and when r3" is 2, R3's are the same as or different from each other, and
r4' is an integer from 0 to 3, and when r4' is an integer of 2 or higher, R4's are the same as or different from each other.

4. The organic light emitting device of claim 1, wherein Chemical Formula A is represented by any one of the following Chemical Formulae A-101 to A-108: 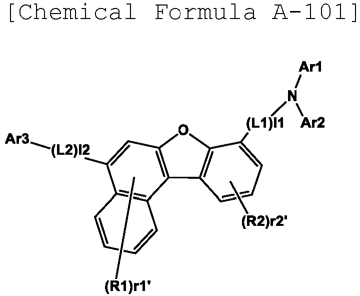 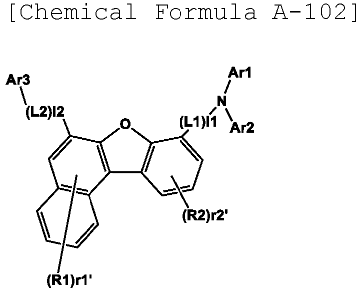 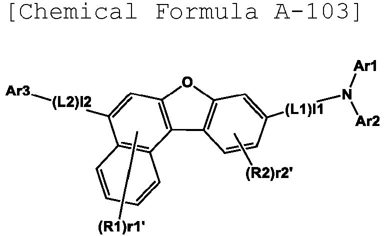 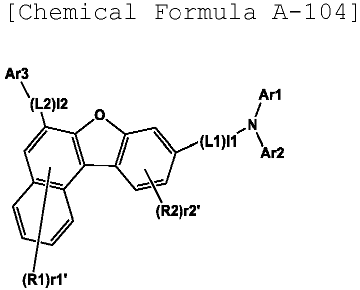 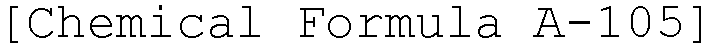 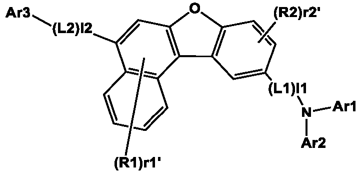 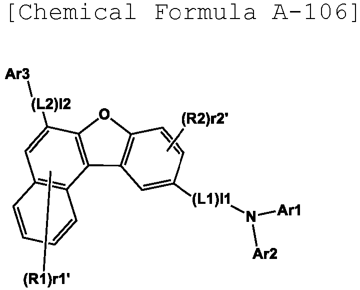 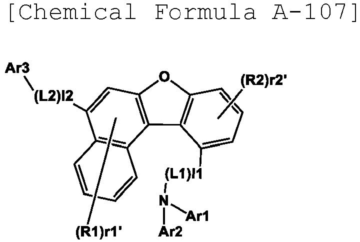 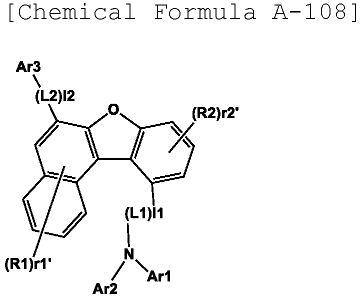
in Chemical Formulae A-101 to A-108,
each of L1, L2, Ar1 to Ar3, R1, R2, l1, l2, r1, and r2 is the same as that defined in Chemical Formula A,
r1' is an integer from 0 to 5,
r2' is an integer from 0 to 3, and
when each of r1' and r2' is an integer of 2 or higher, the types of substituents in the parenthesis are the same as or different from each other.

5. The organic light emitting device of claim 1, wherein Chemical Formula B is represented by any one of the following Chemical Formulae B-101 to B-115: 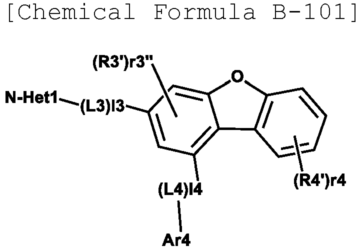 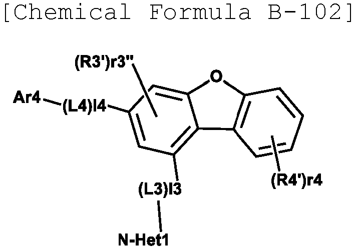 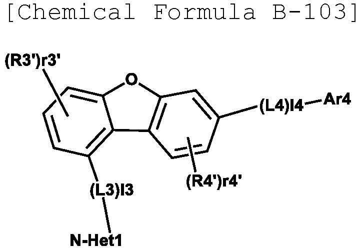 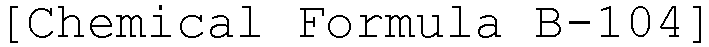 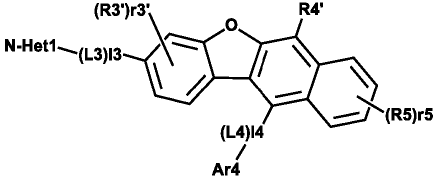 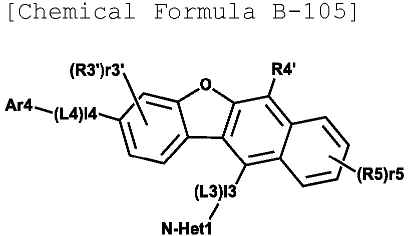 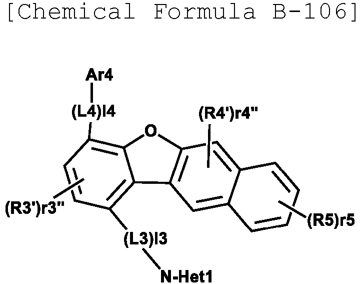 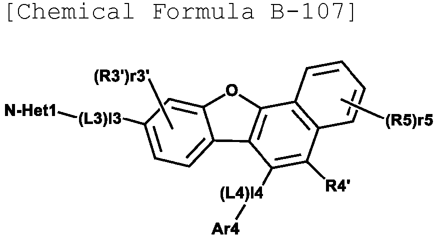 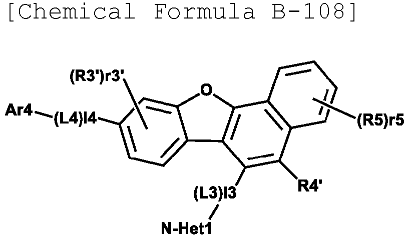 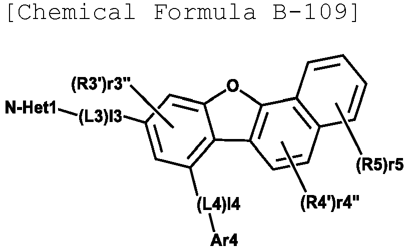 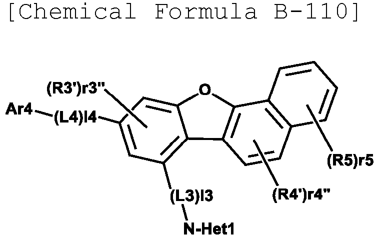 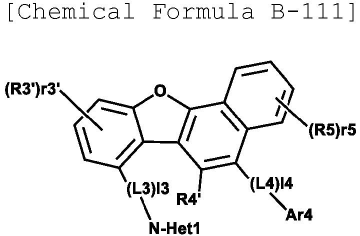 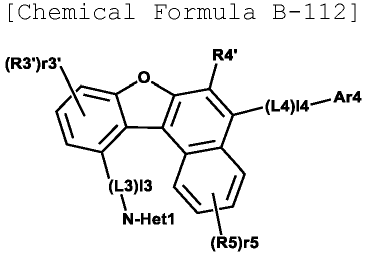 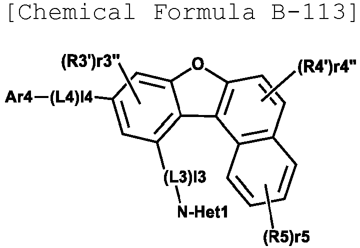 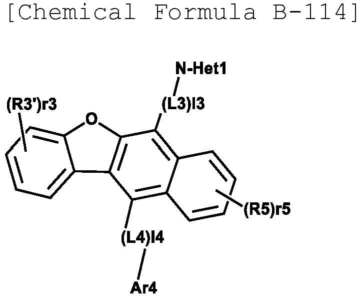 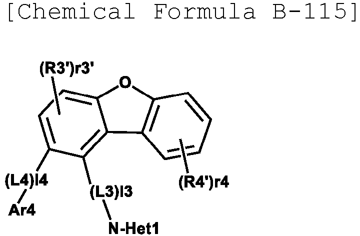
in Chemical Formulae B-101 to B-115,
each of L3, L4, Ar4, N-Het1, r3, r4, l3, and l4 is the same as that defined in Chemical Formula B,
R3', R4', and R5 are the same as or different from each other, and are each independently hydrogen; deuterium; a halogen group; a cyano group; a substituted or unsubstituted alkyl group having 1 to 60 carbon atoms; a substituted or unsubstituted cycloalkyl group having 3 to 60 carbon atoms; a substituted or unsubstituted heterocycloalkyl group having 2 to 60 carbon atoms; a substituted or unsubstituted aryl group having 6 to 60 carbon atoms; or a substituted or unsubstituted heteroaryl group having 2 to 60 carbon atoms,
r3' is an integer from 0 to 3, and when r3' is an integer of 2 or higher, R3''s are the same as or different from each other,
r3" is an integer from 0 to 2, and when r3" is 2, R3"s are the same as or different from each other,
r4' is an integer from 0 to 3, and when r4' is an integer of 2 or higher, R4"s are the same as or different from each other, and
r5 is an integer from 0 to 4, and when r5 is an integer of 2 or higher, R5's are the same as or different from each other.

6. The organic light emitting device of claim 1, wherein Ar1 to Ar3 are the same as or different from each other, and are each independently a substituted or unsubstituted aryl group having 6 to 30 carbon atoms; a substituted or unsubstituted heteroaryl group having 2 to 30 carbon atoms; or a combination thereof.

7. The organic light emitting device of claim 1, wherein Ar4 is a substituted or unsubstituted aryl group having 6 to 30 carbon atoms; a substituted or unsubstituted heteroaryl group having 2 to 30 carbon atoms; or -NRbRc, and
Rb and Rc are the same as or different from each other, and are each independently hydrogen; deuterium; a substituted or unsubstituted alkyl group having 1 to 30 carbon atoms; a substituted or unsubstituted cycloalkyl group having 3 to 30 carbon atoms; a substituted or unsubstituted heterocycloalkyl group having 2 to 30 carbon atoms; a substituted or unsubstituted aryl group having 6 to 30 carbon atoms; or a substituted or unsubstituted heteroaryl group having 2 to 30 carbon atoms.

8. The organic light emitting device of claim 1, wherein the deuterium contents of the heterocyclic compound represented by Chemical Formula A; and the heterocyclic compound represented by Chemical Formula B are the same as or different from each other, and are each independently 0% or 1% to 100%.

9. The organic light emitting device of claim 1, wherein Chemical Formula A is represented by any one of the followings:

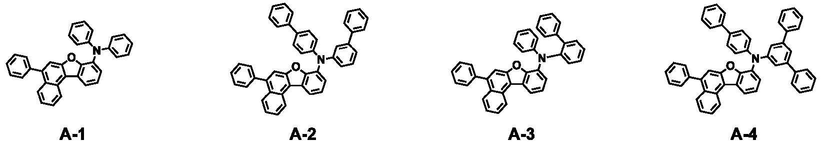

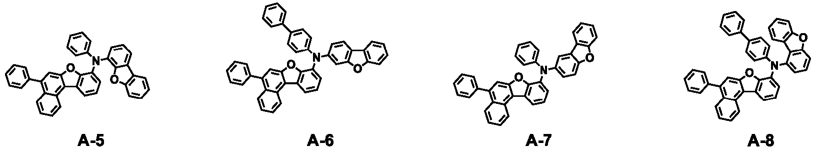

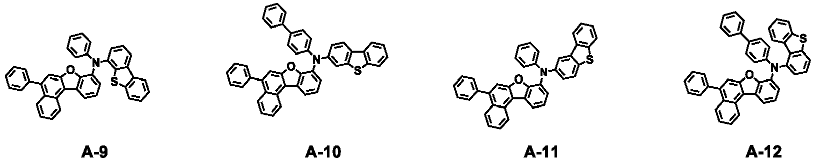

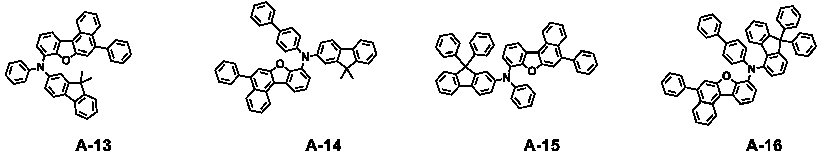

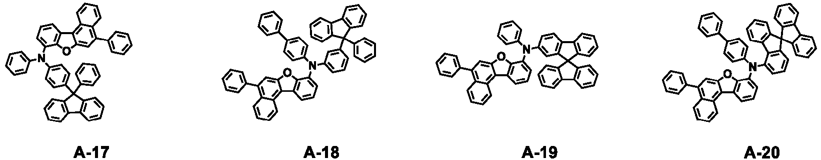

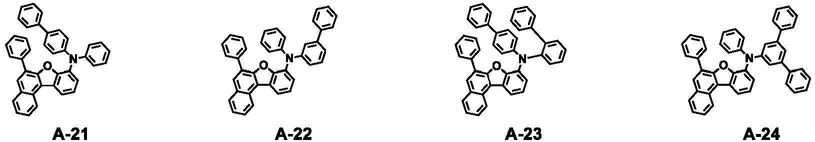

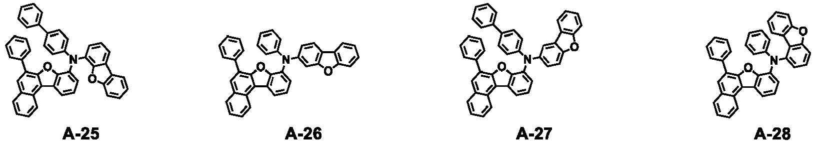

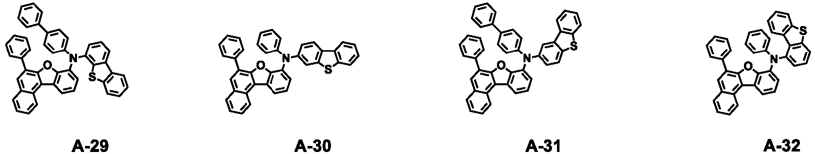

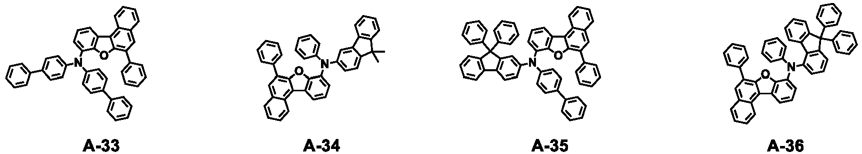

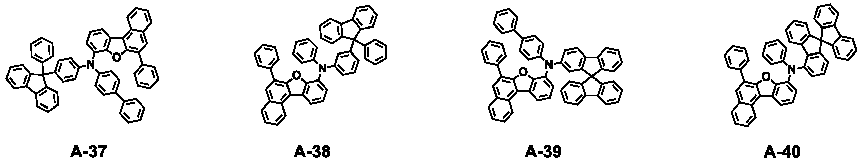

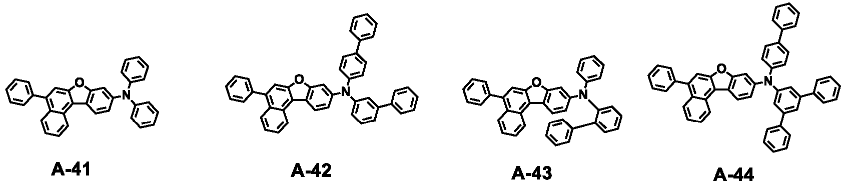

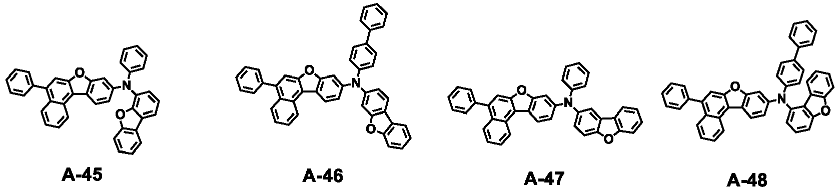

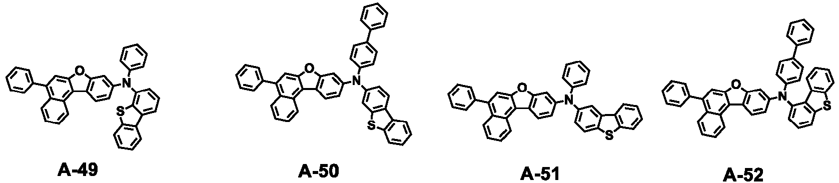

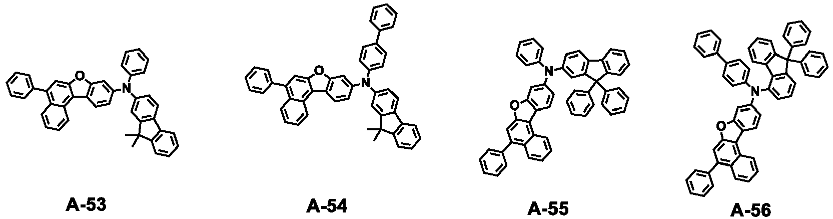

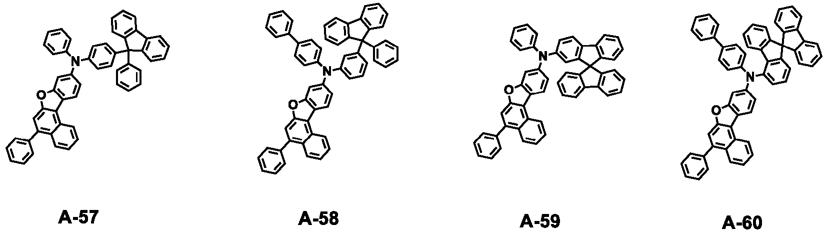

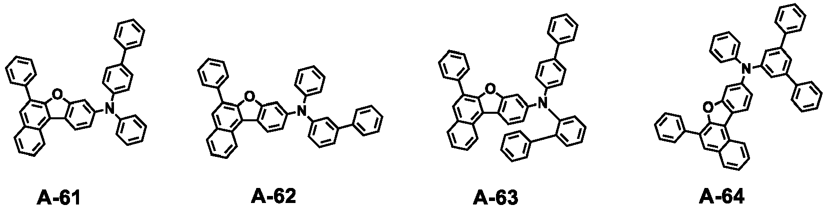

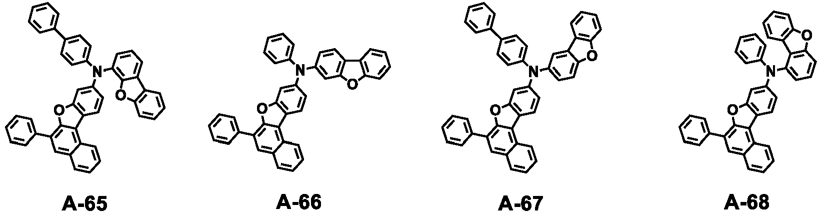

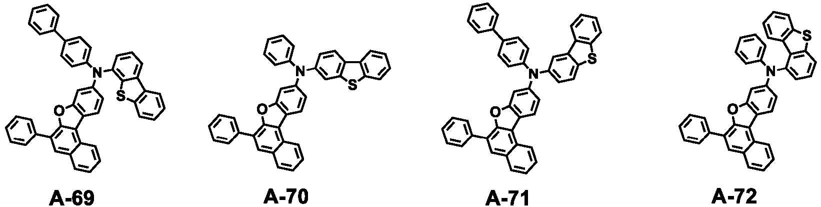

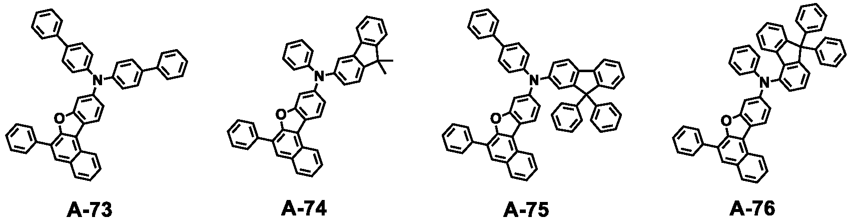

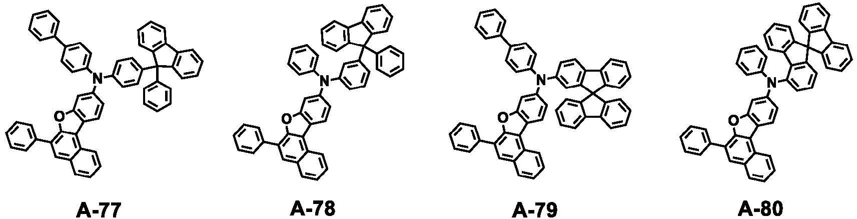

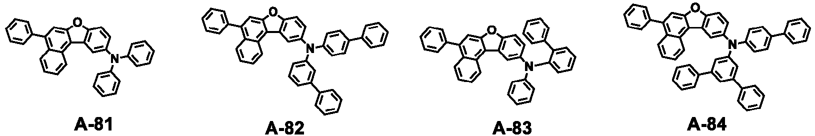

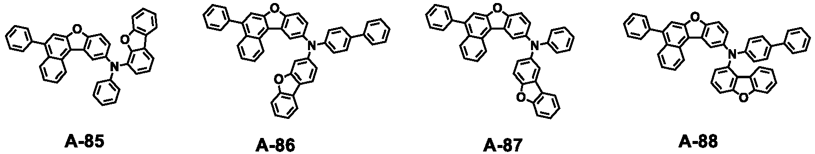

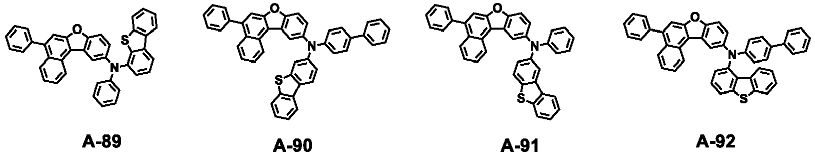

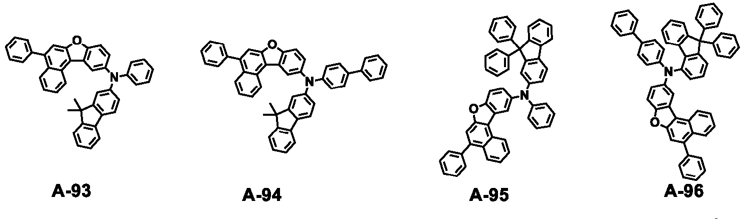

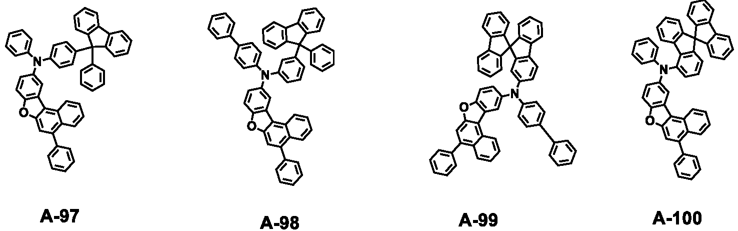

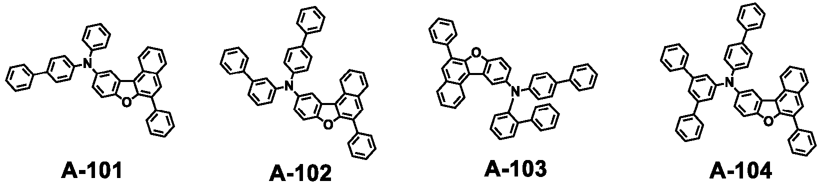

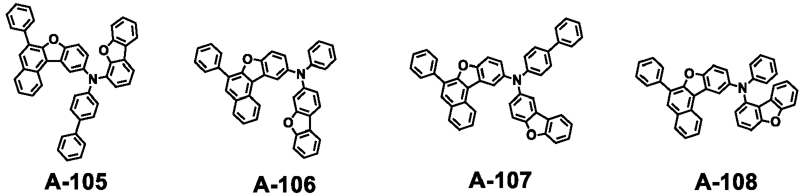

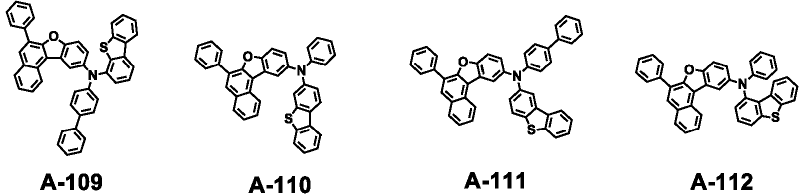

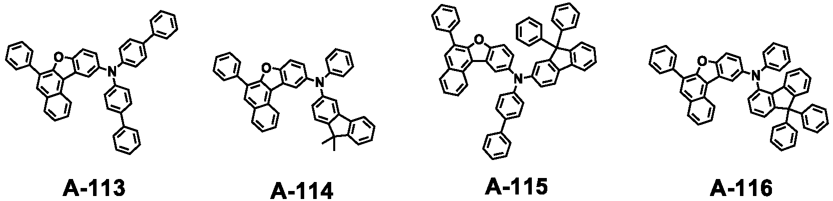

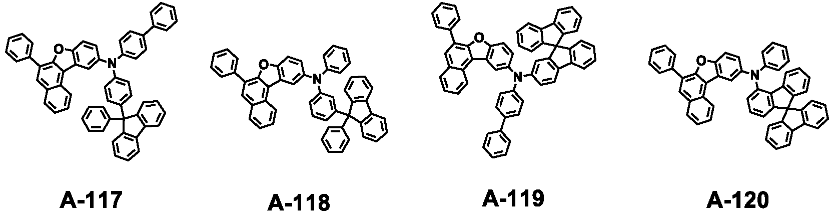

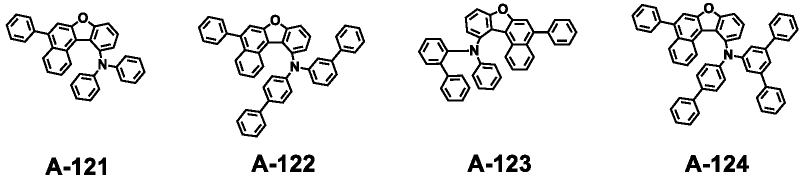

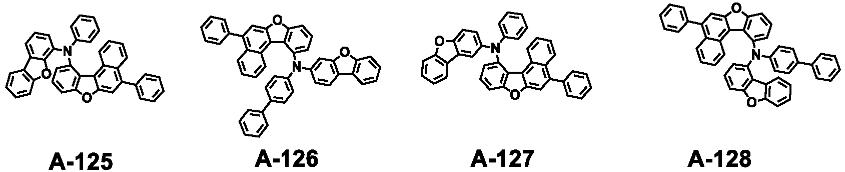

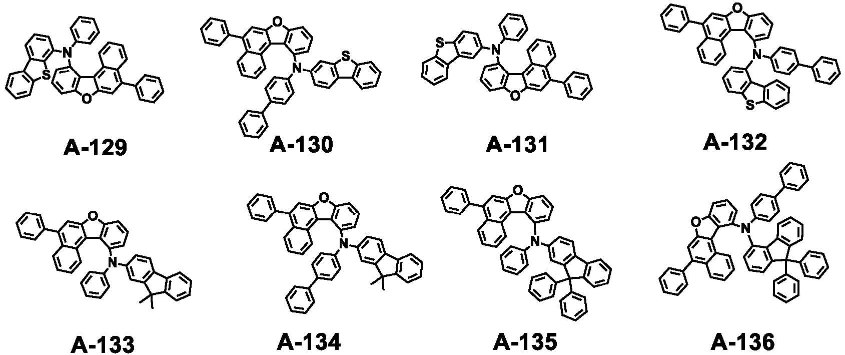

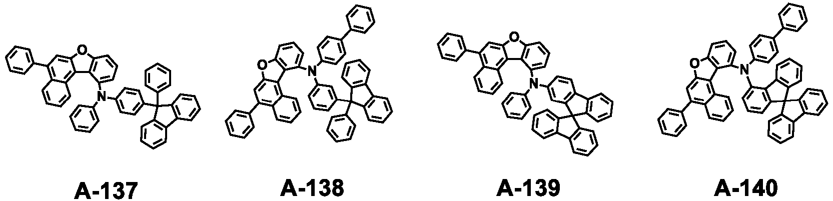

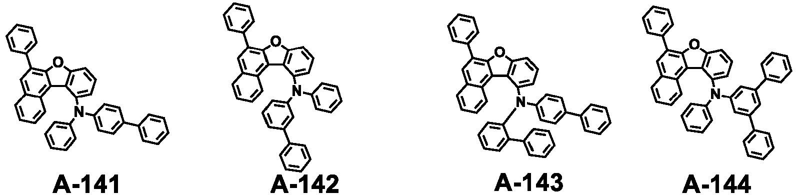

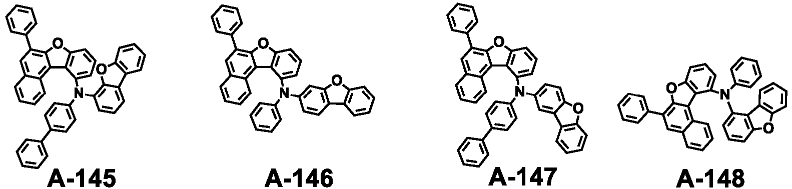

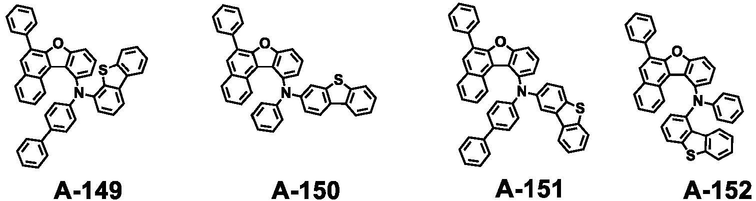

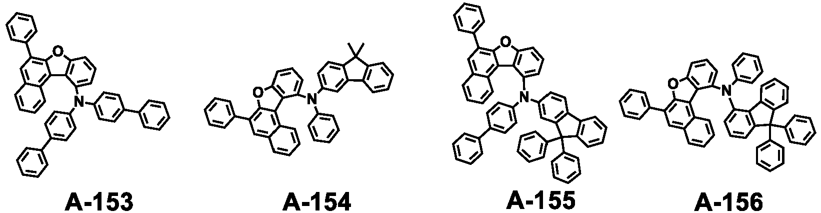

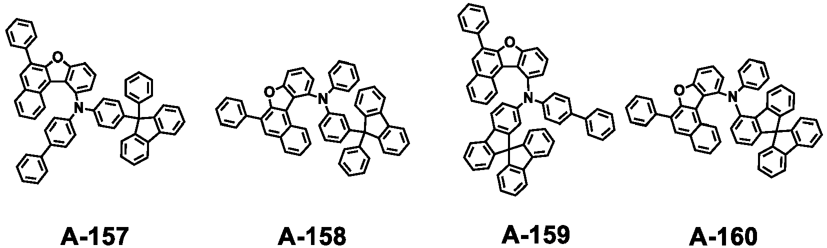

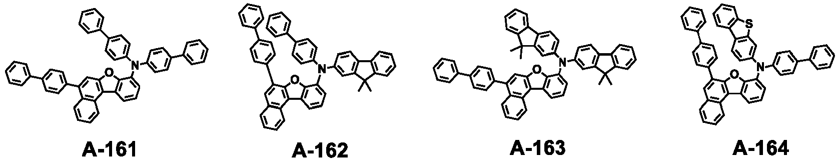

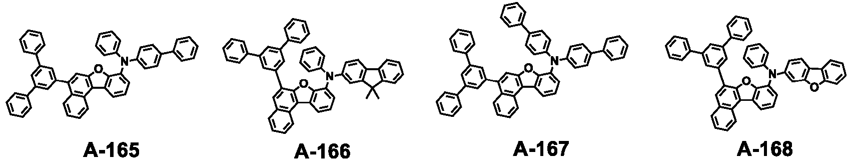

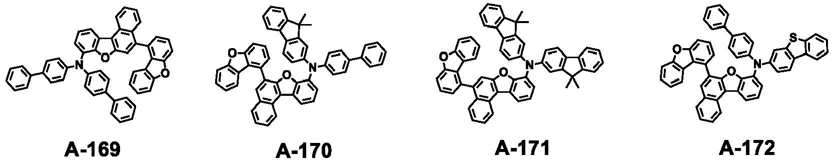

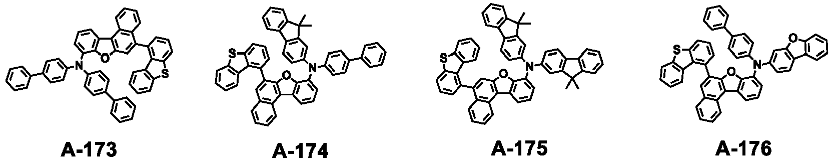

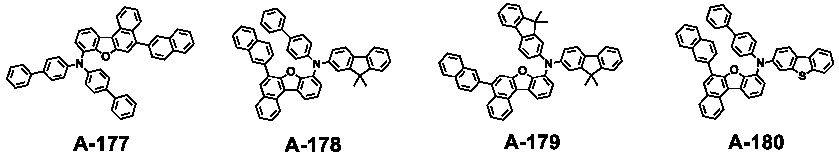

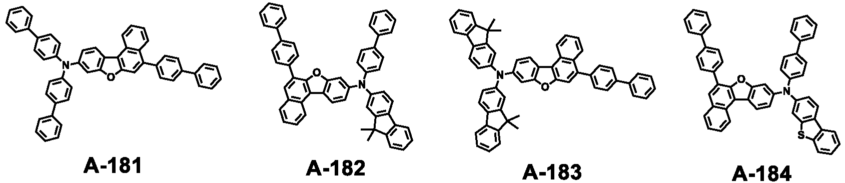

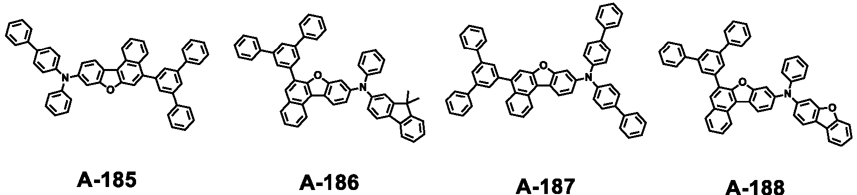

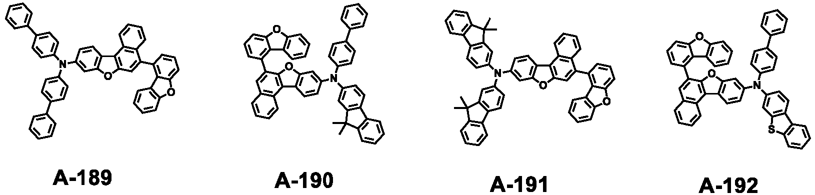

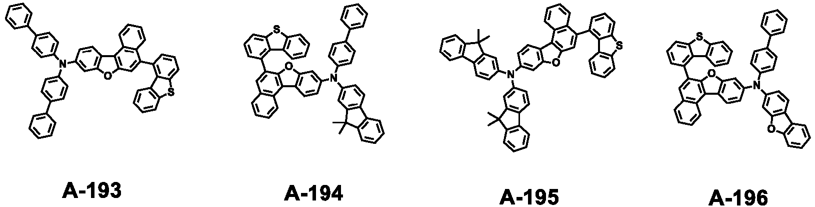

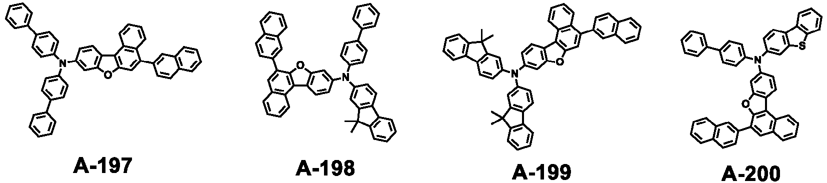

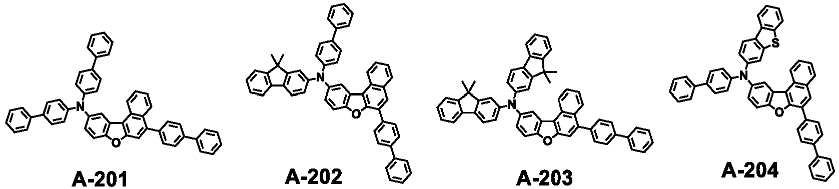

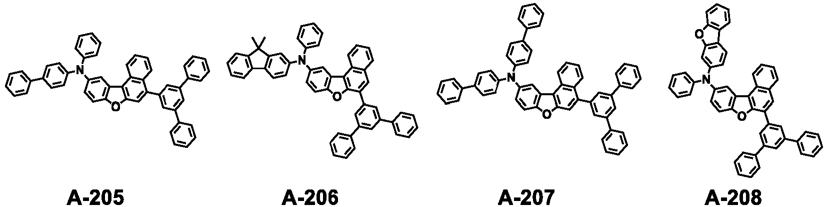

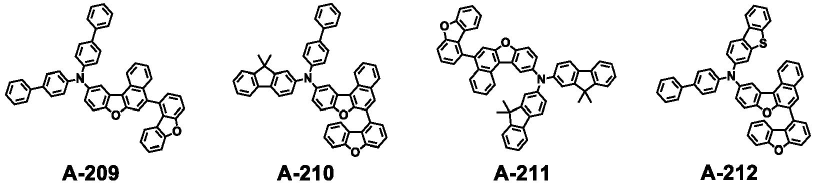

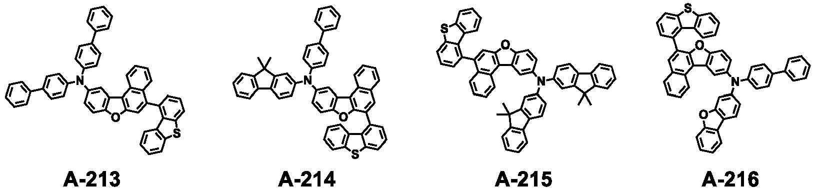

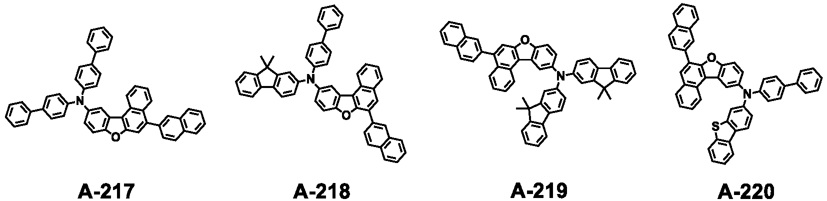

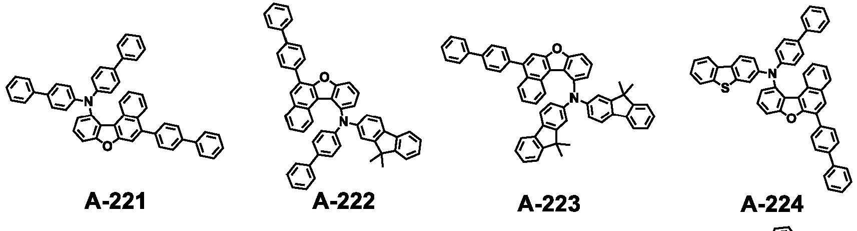

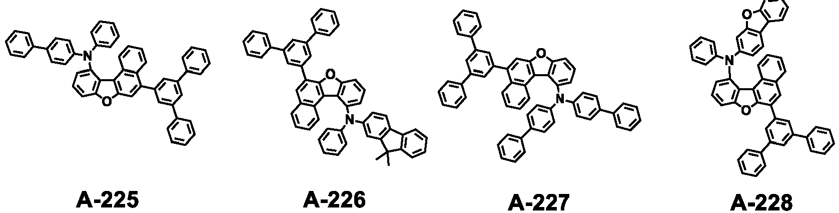

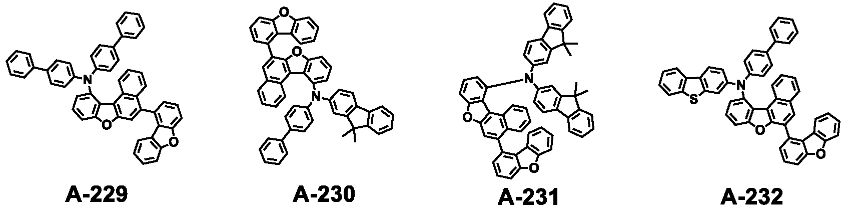

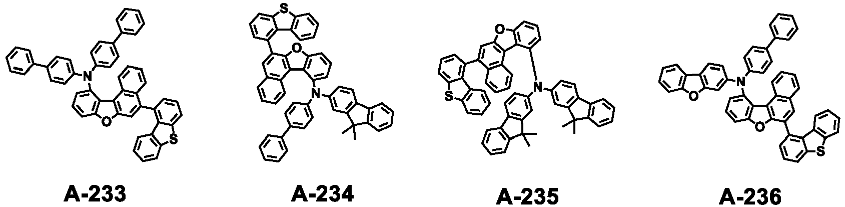

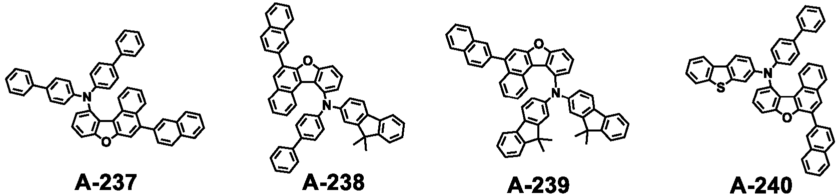

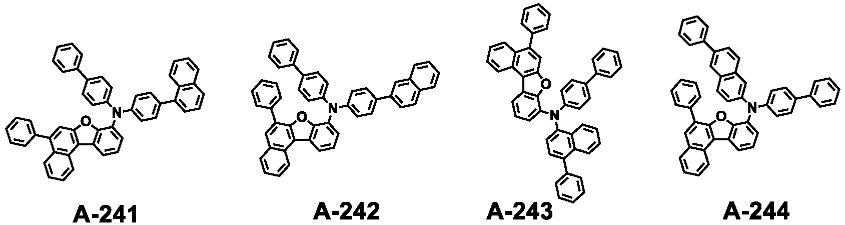

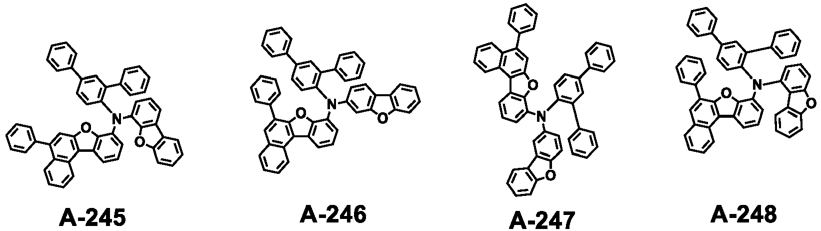

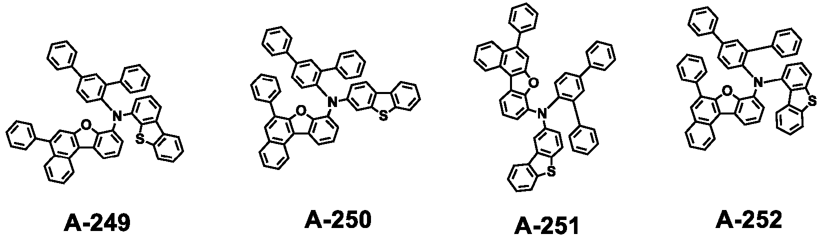

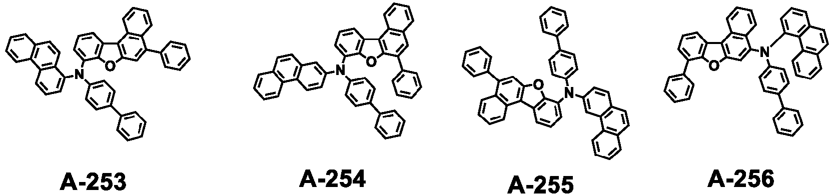

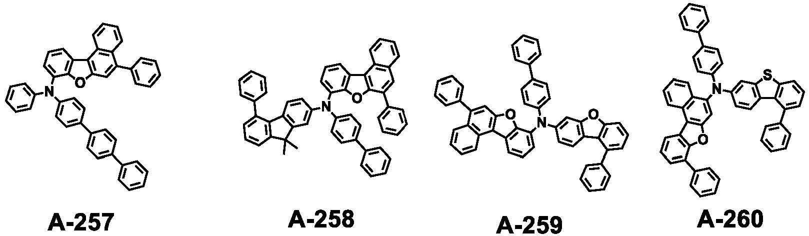

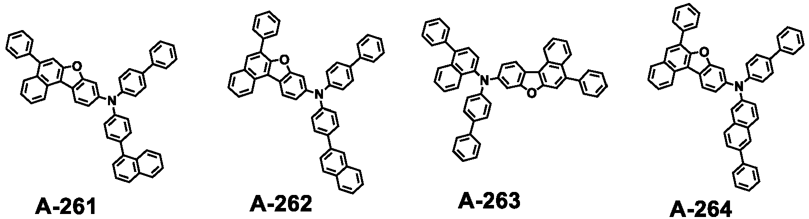

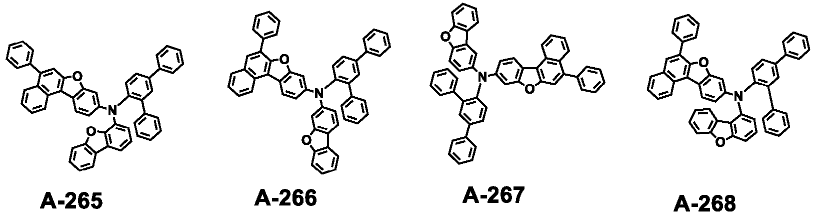

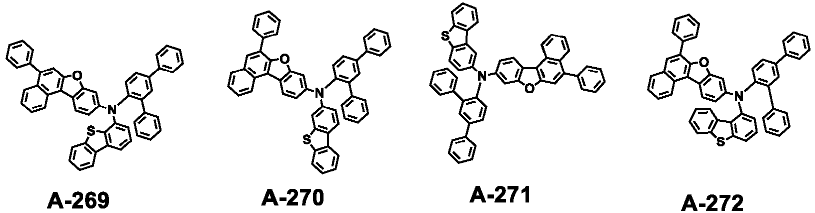

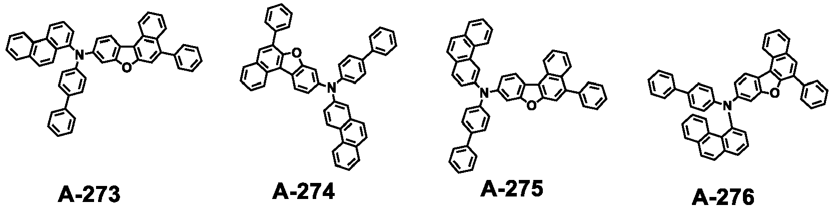

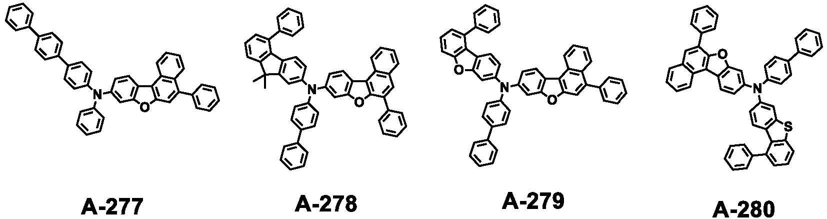

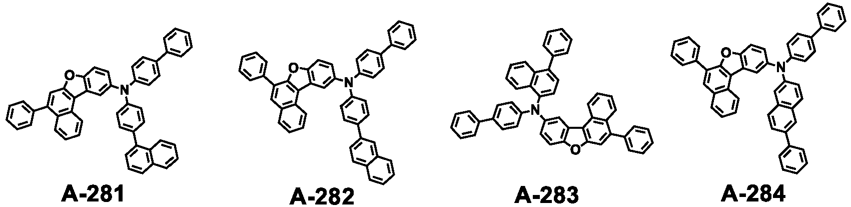

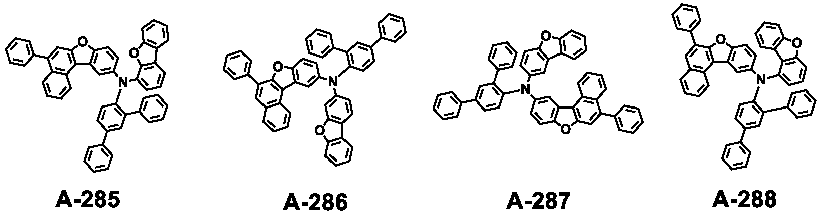

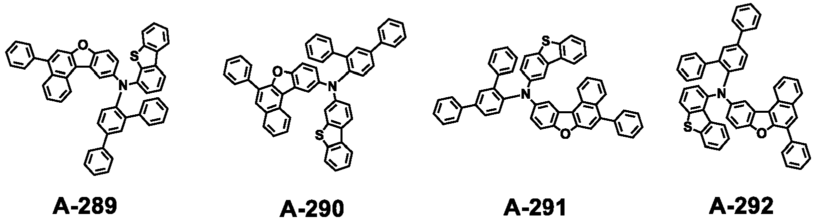

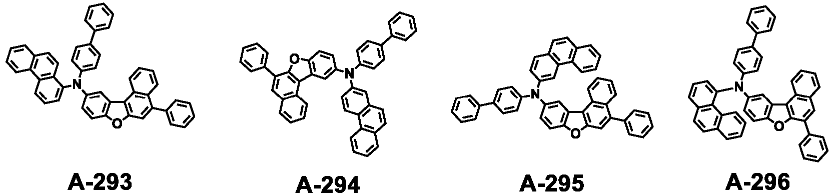

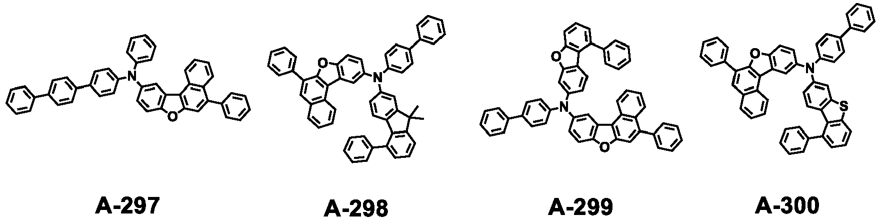

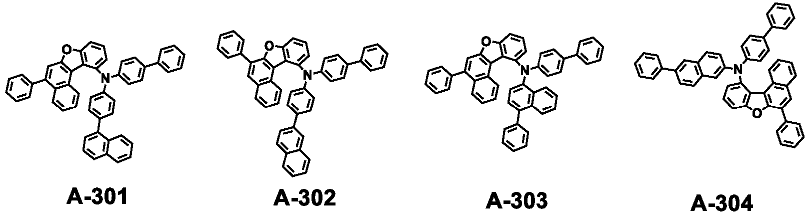

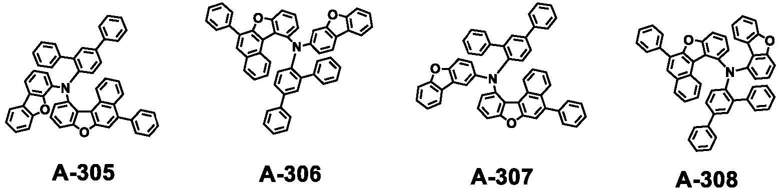

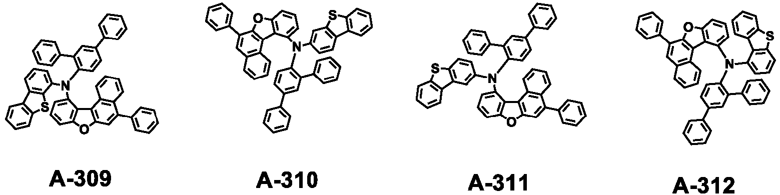

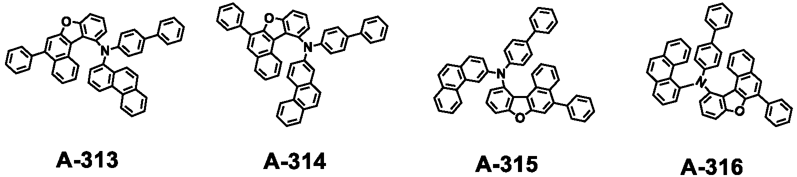

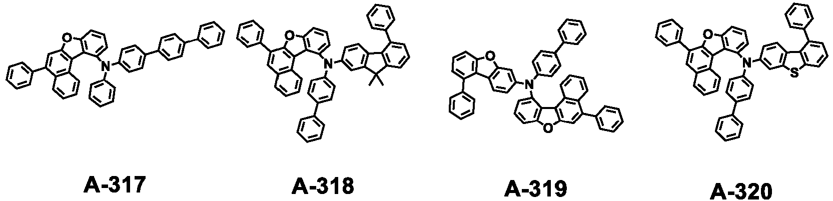

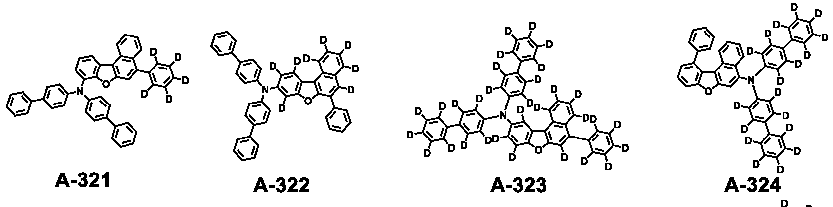

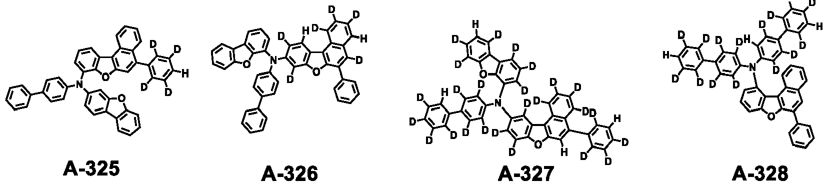

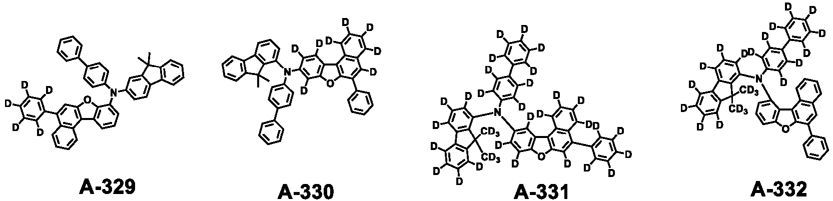

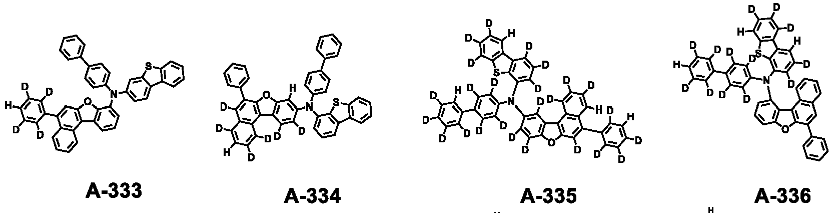

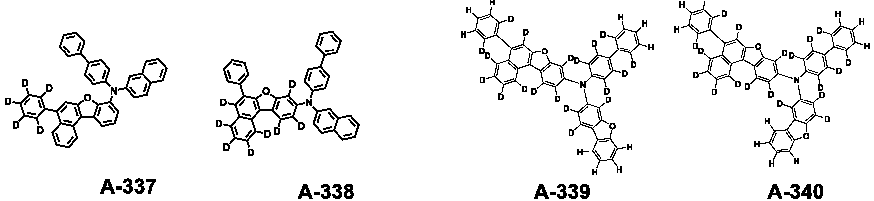

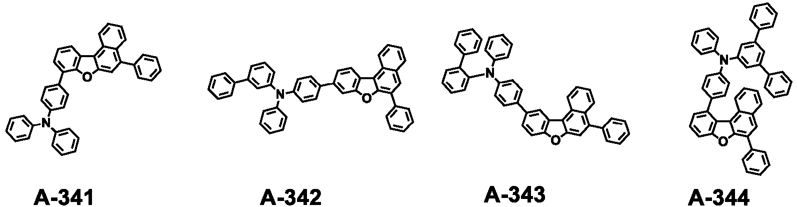

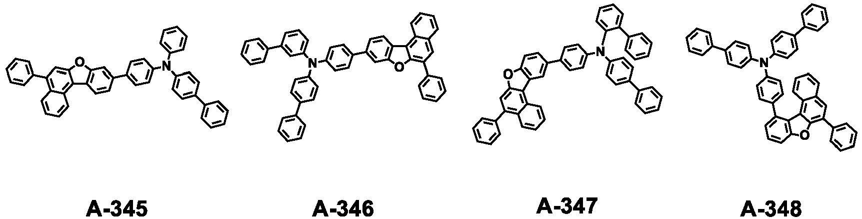

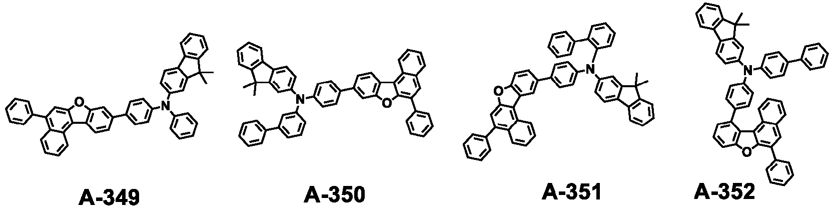

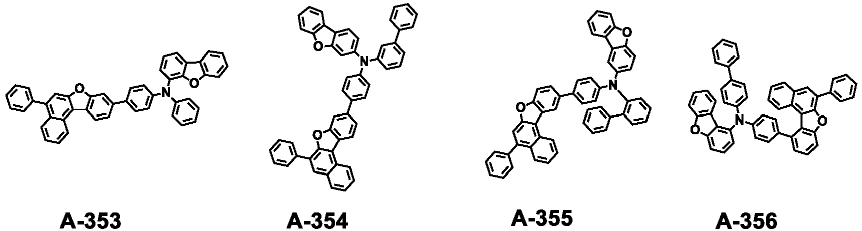

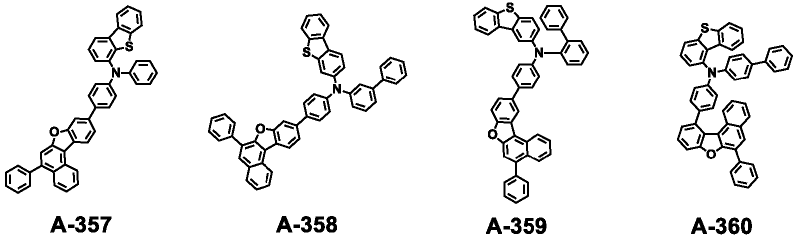

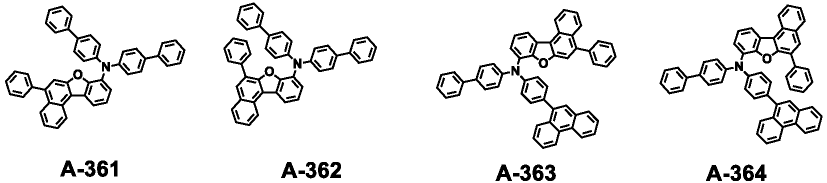

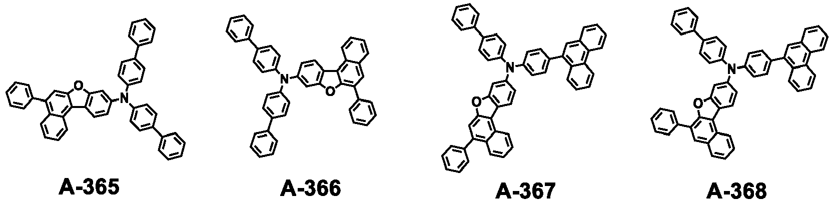

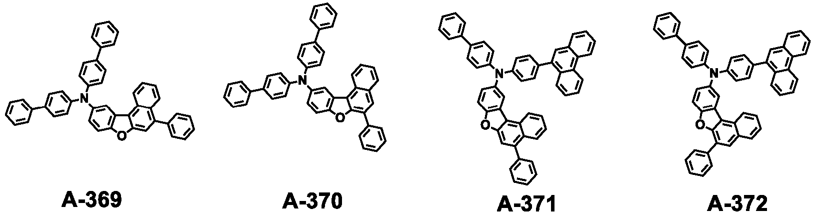

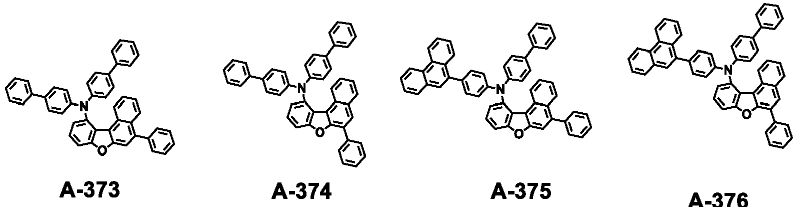

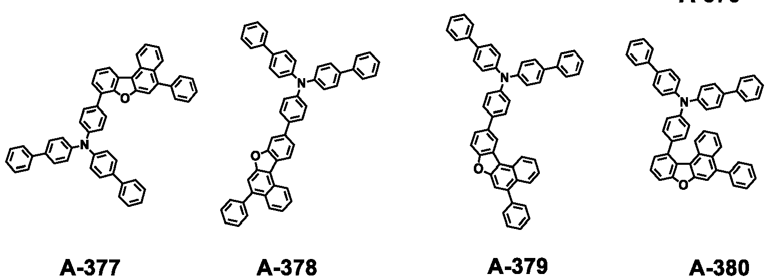

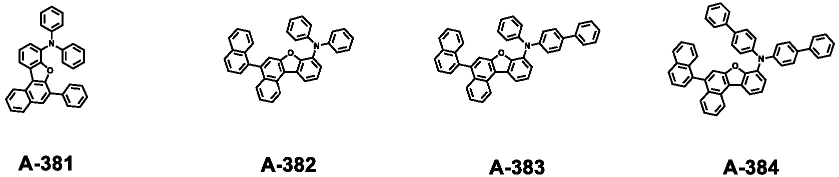

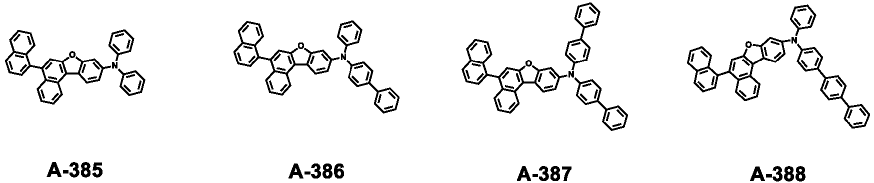

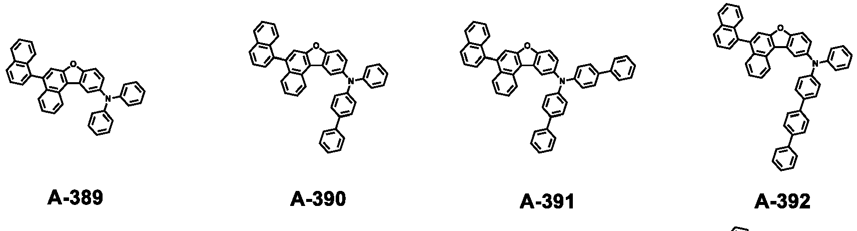

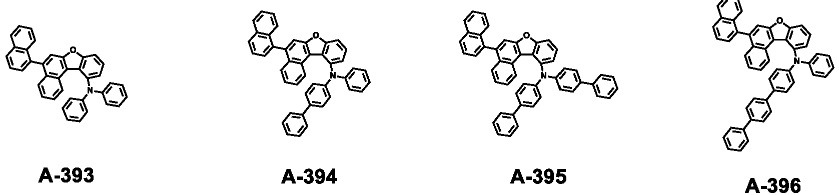

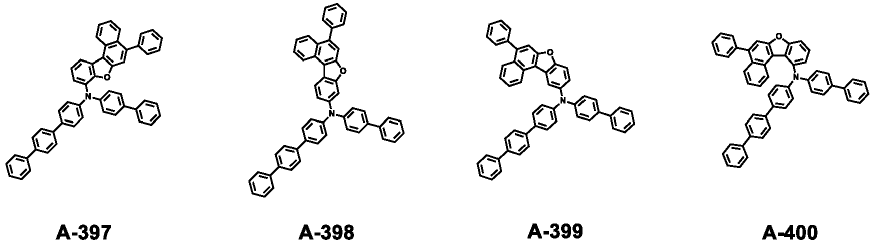

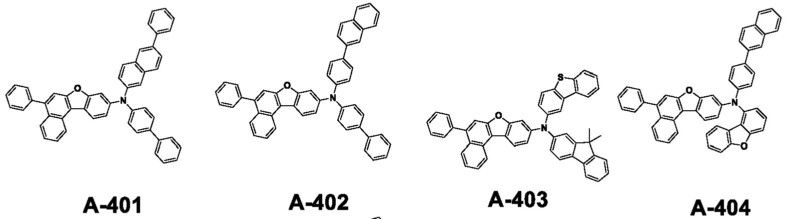

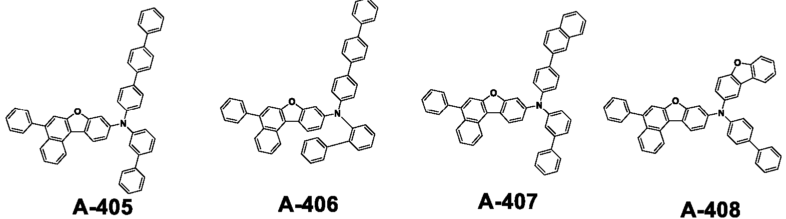

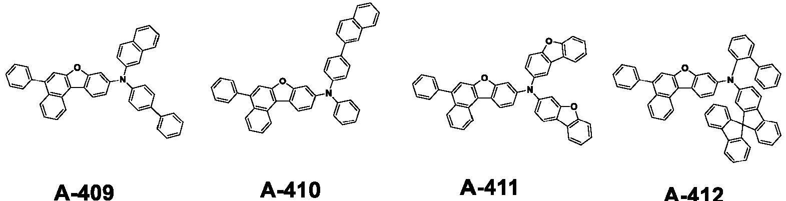

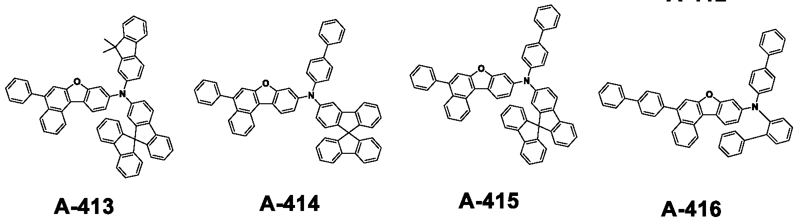

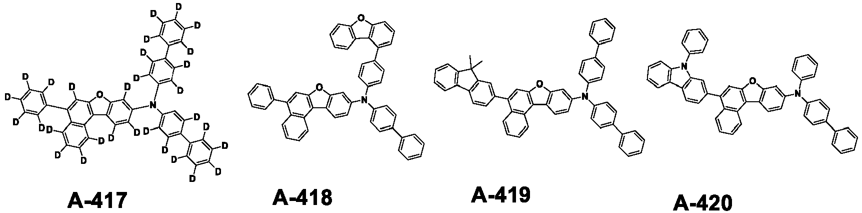

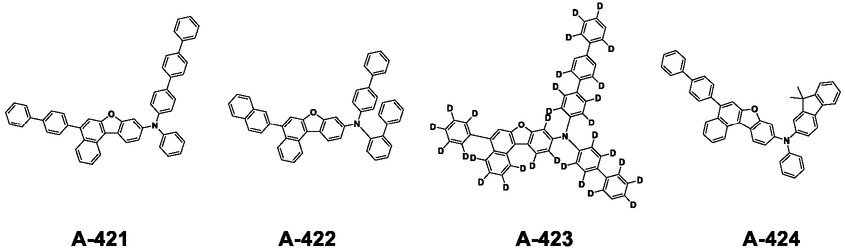

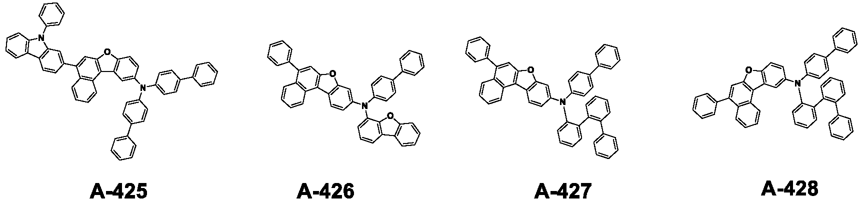

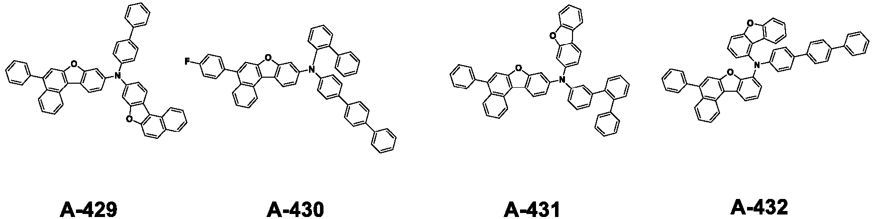

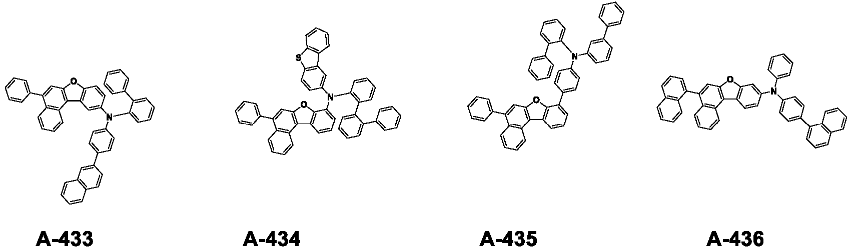

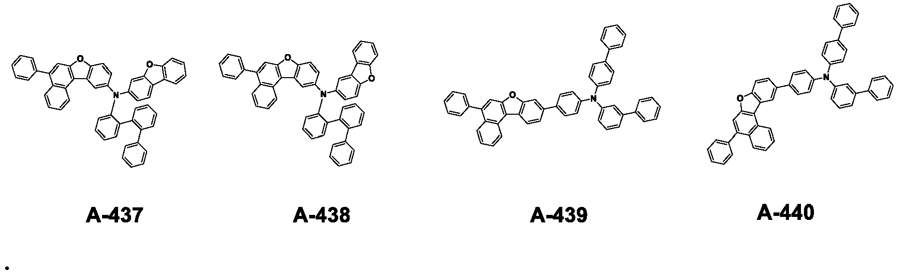

10. The organic light emitting device of claim 1, wherein Chemical Formula B is represented by any one of the followings:

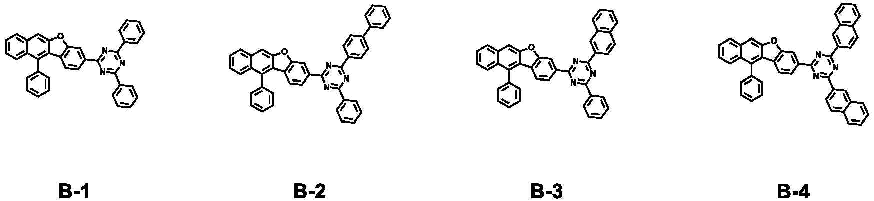

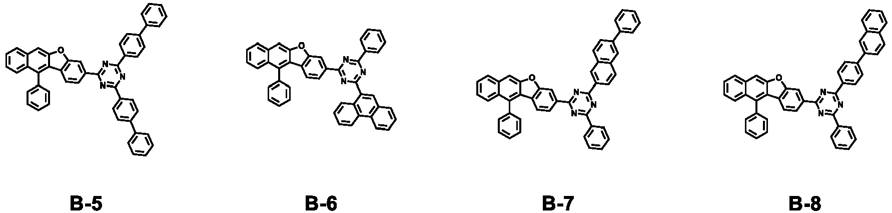

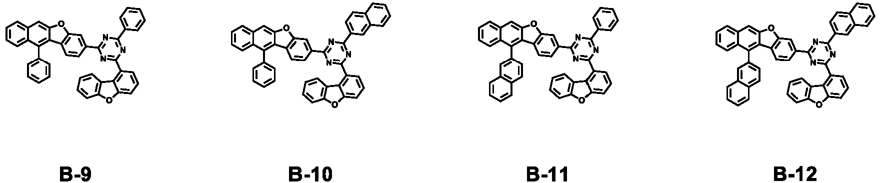

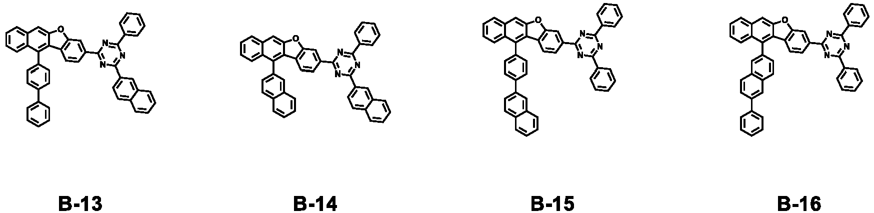

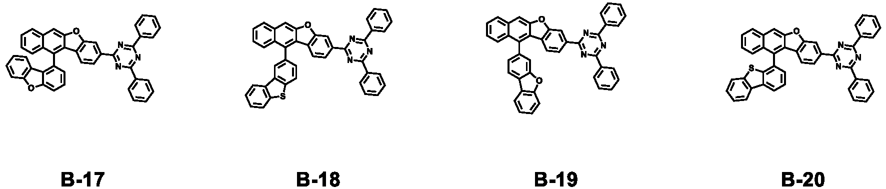

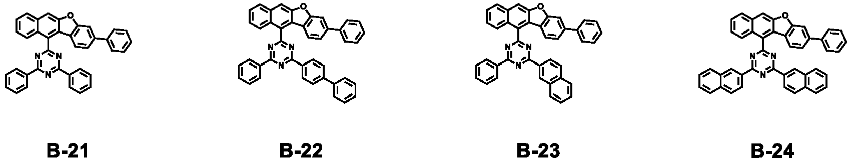

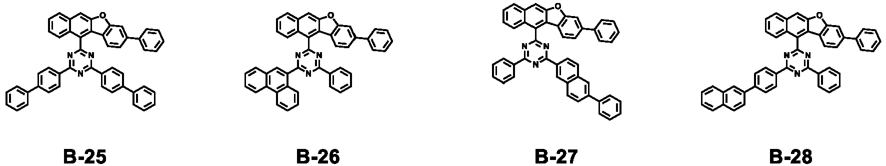

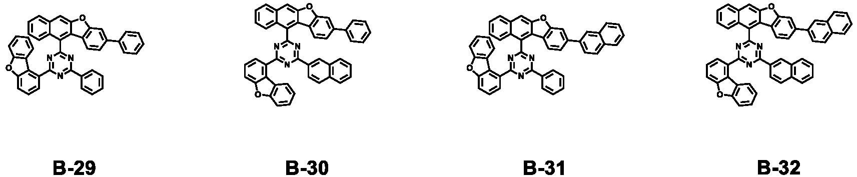

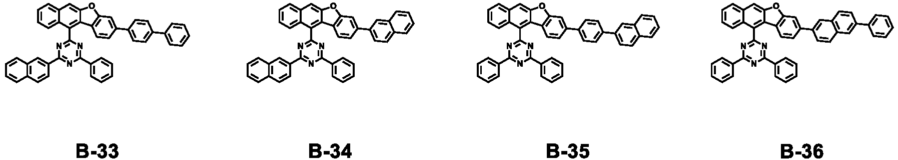

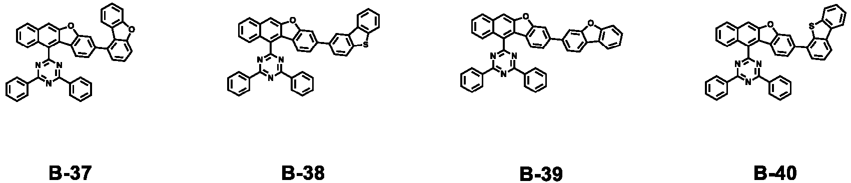

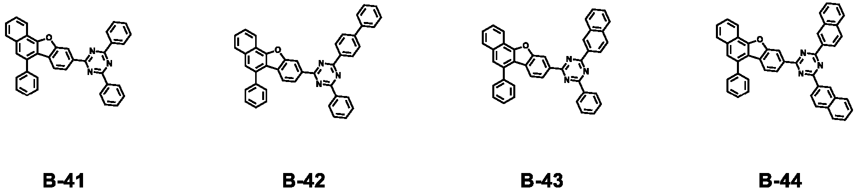

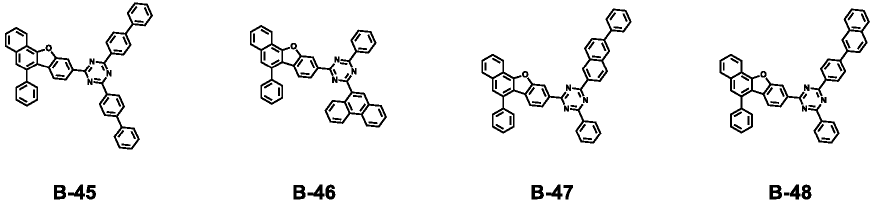

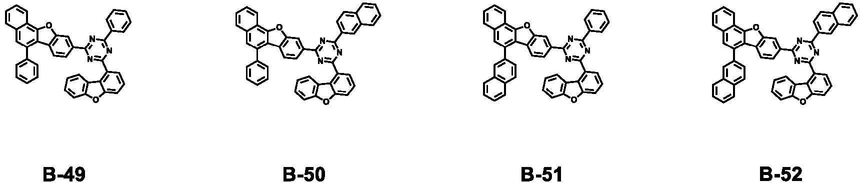

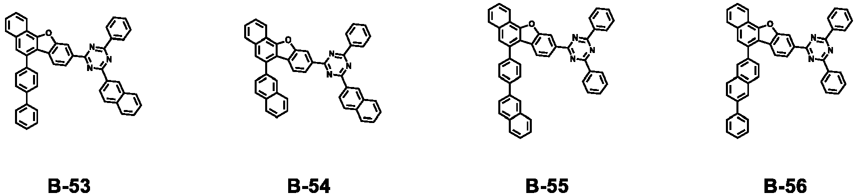

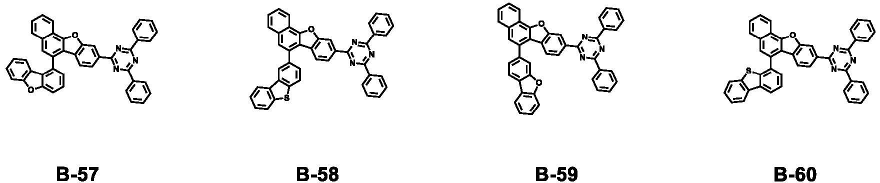

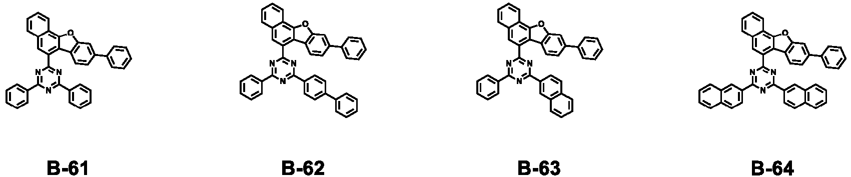

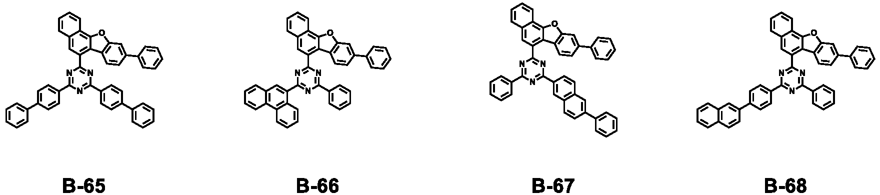

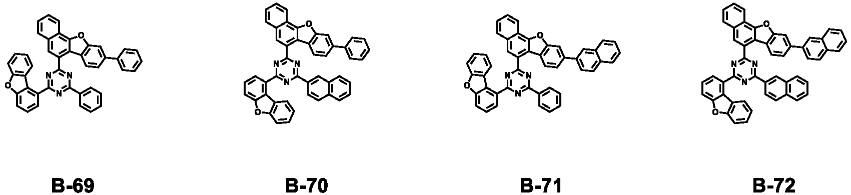

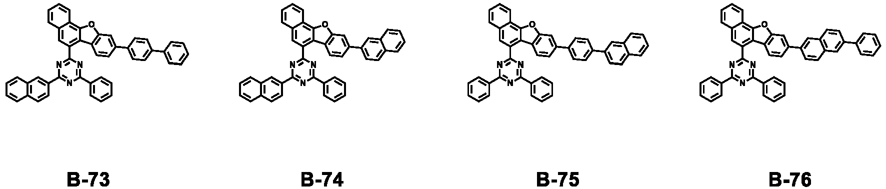

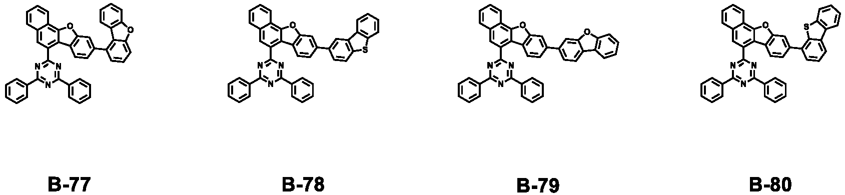

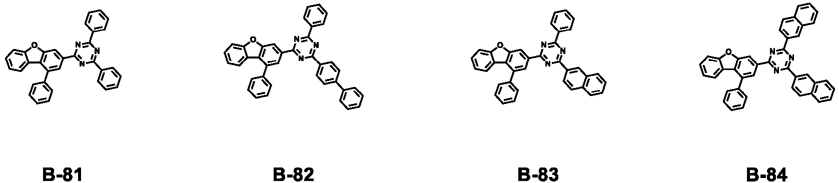

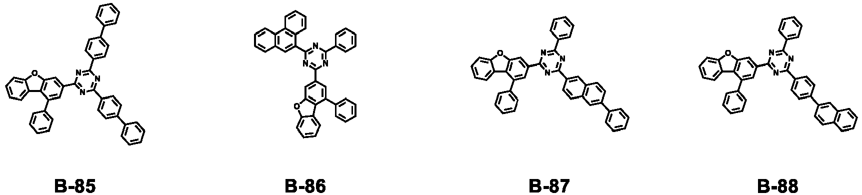

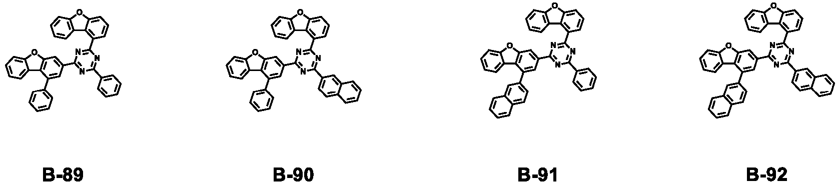

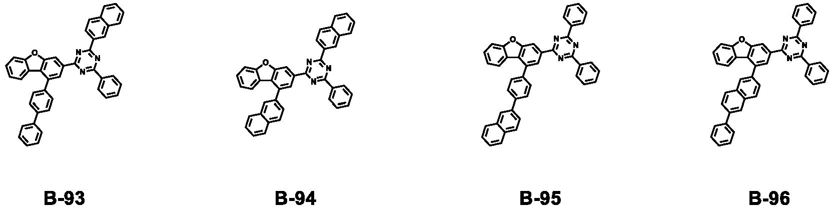

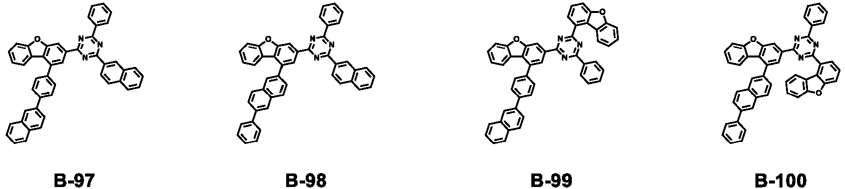

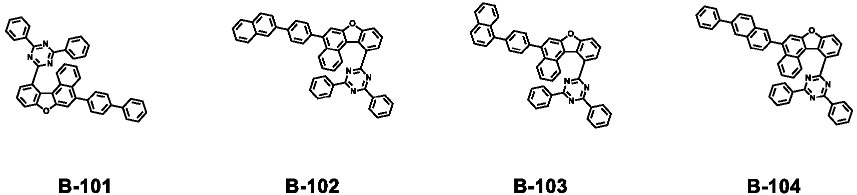

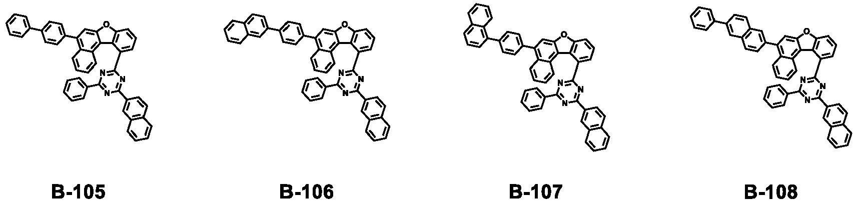

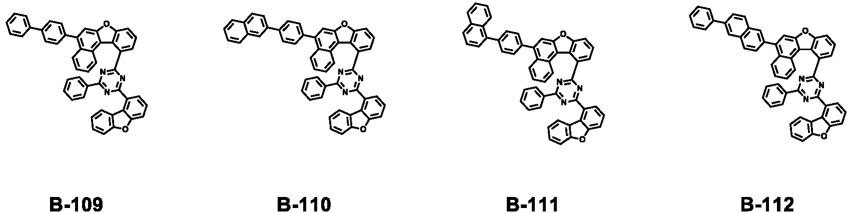

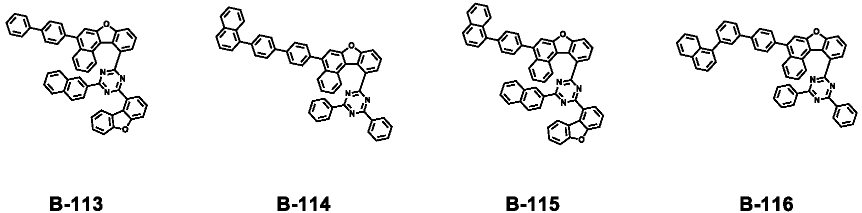

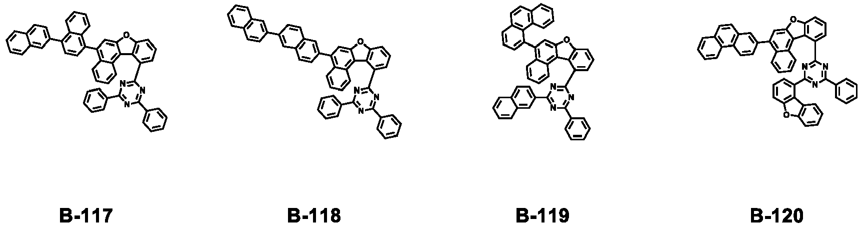

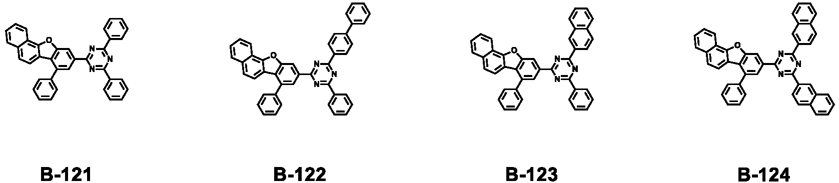

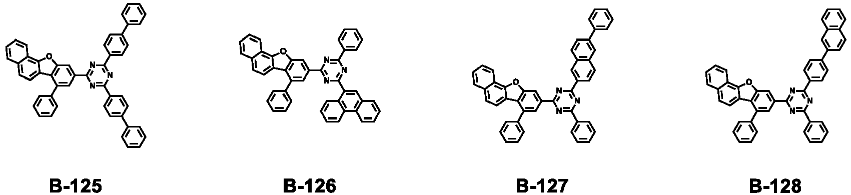

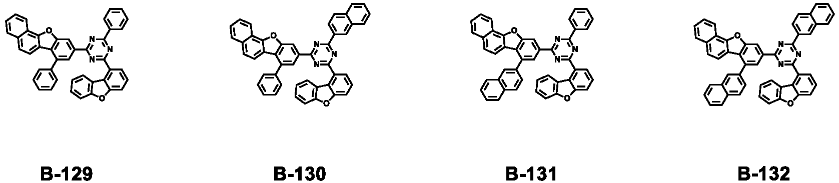

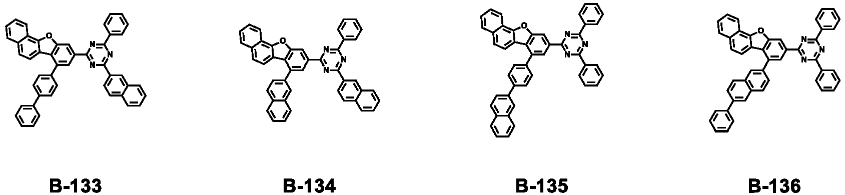

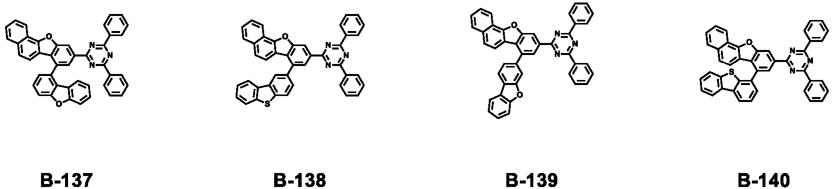

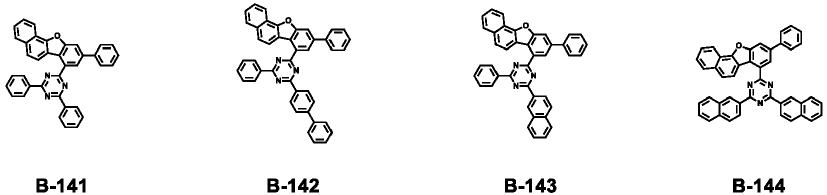

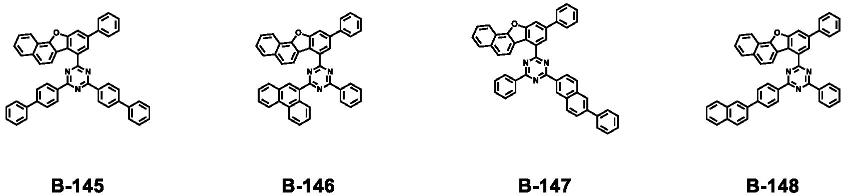

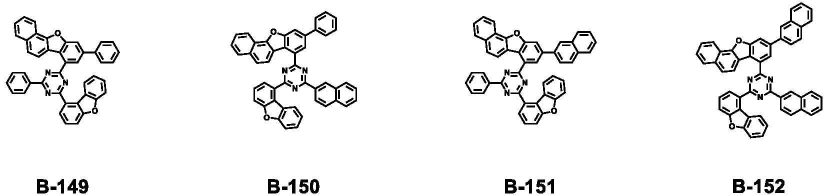

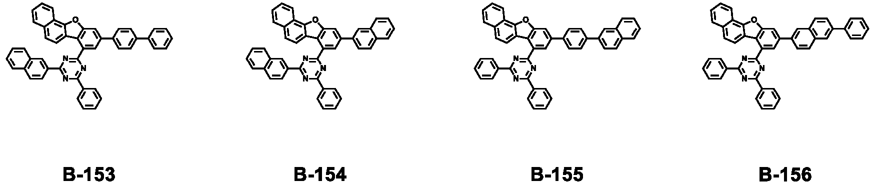

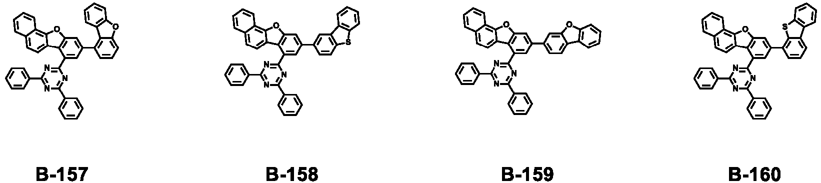

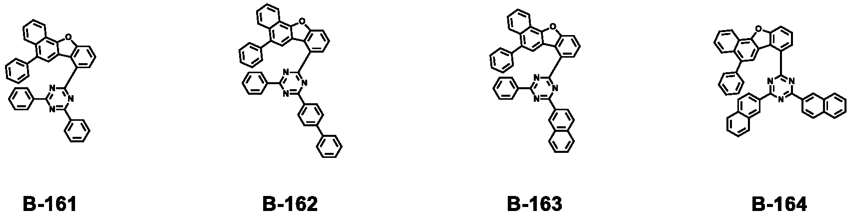

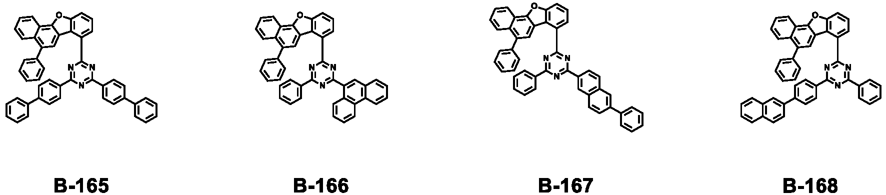

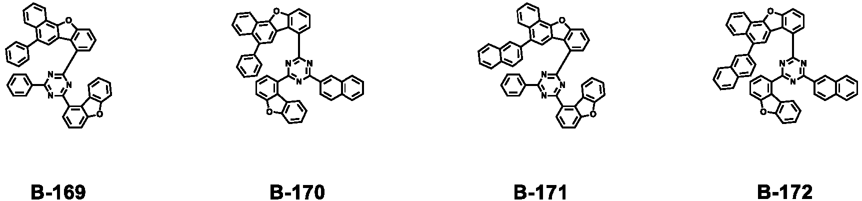

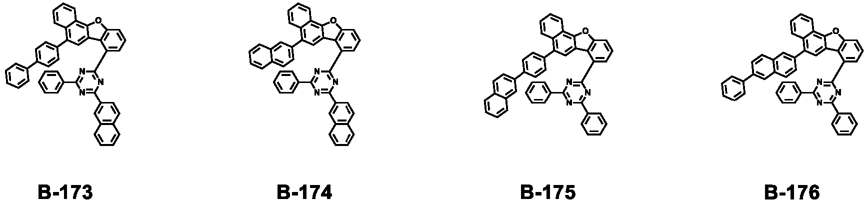

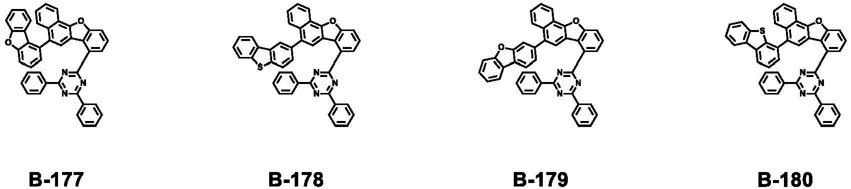

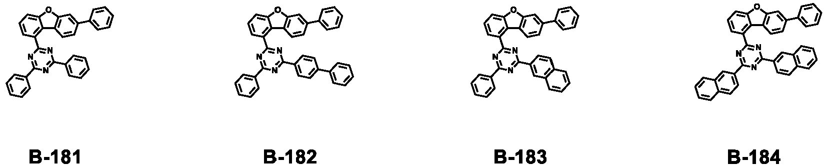

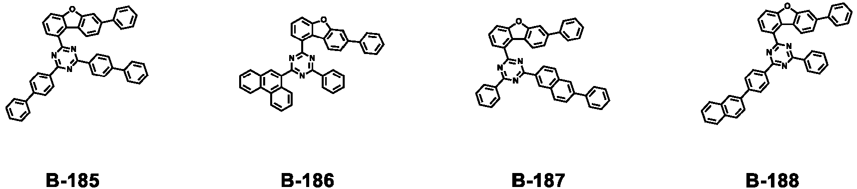

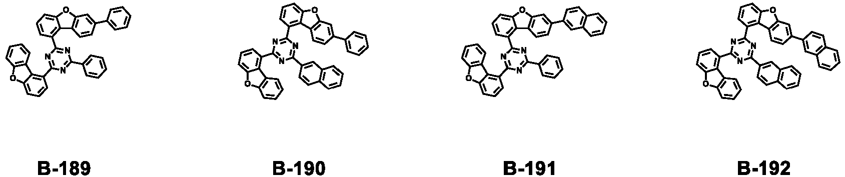

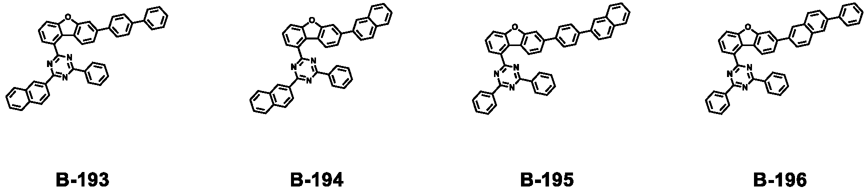

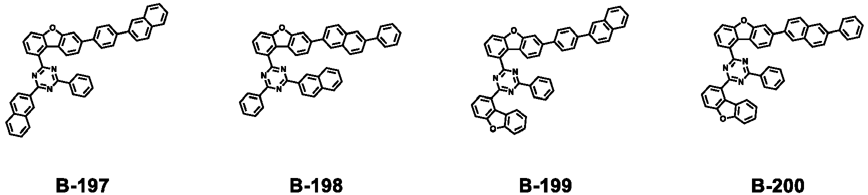

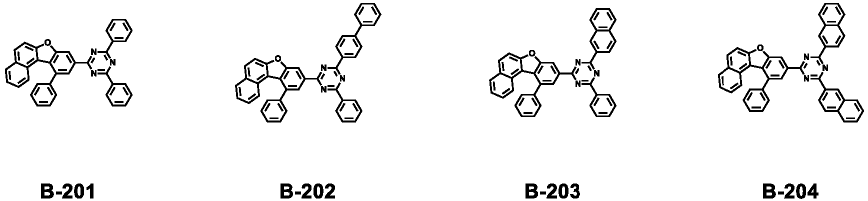

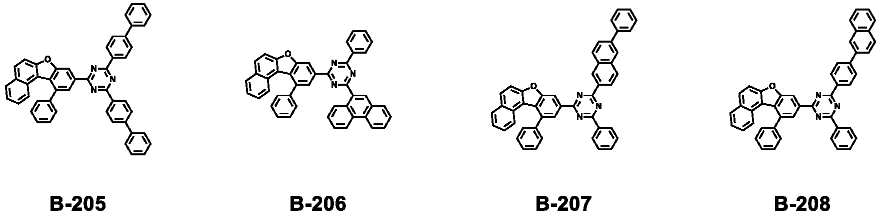

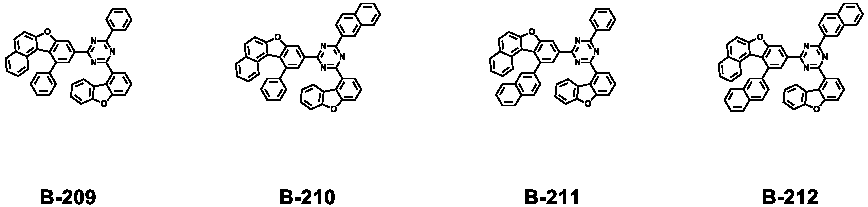

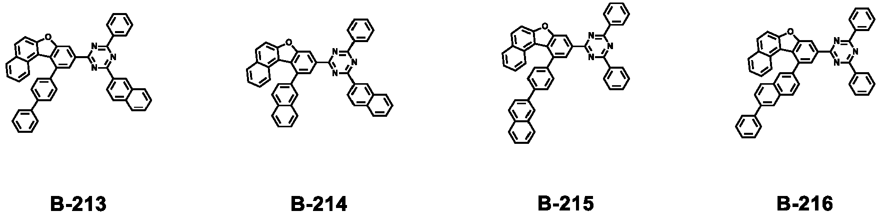

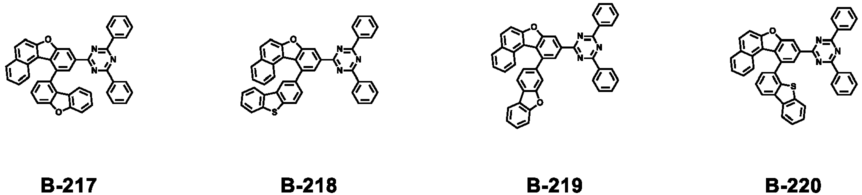

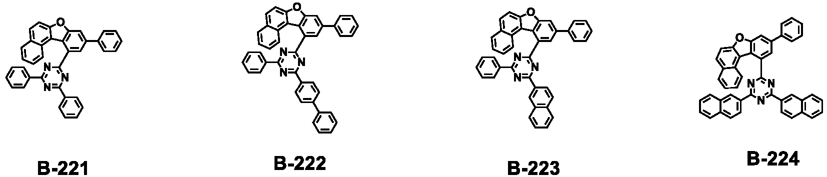

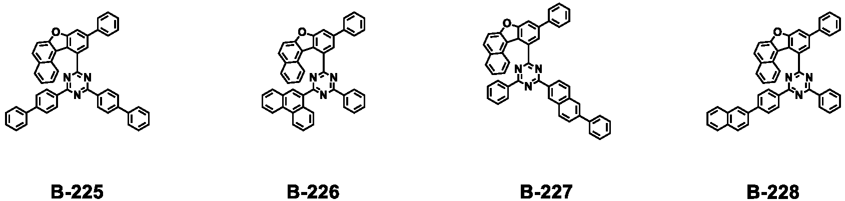

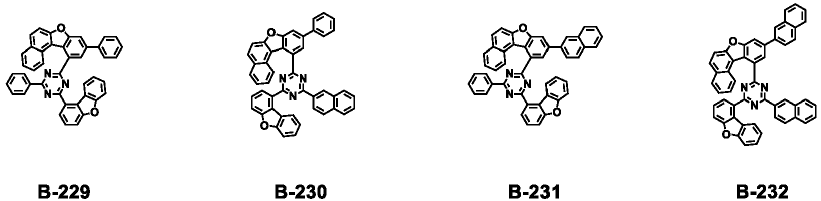

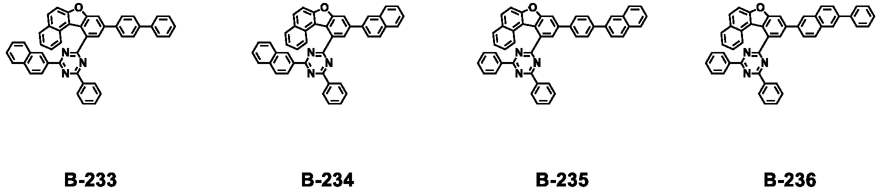

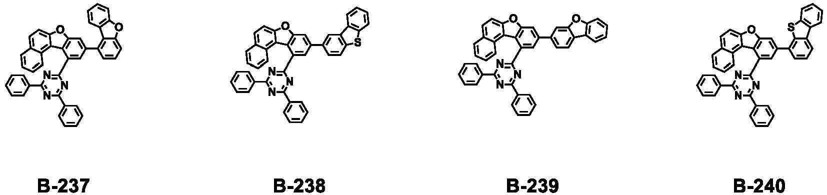

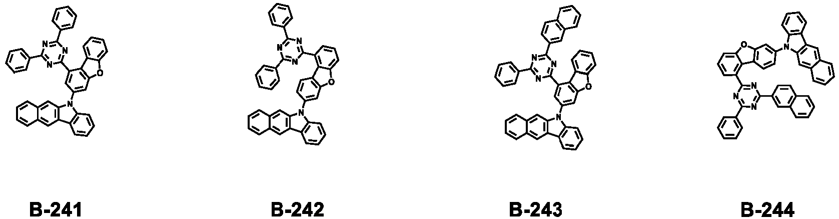

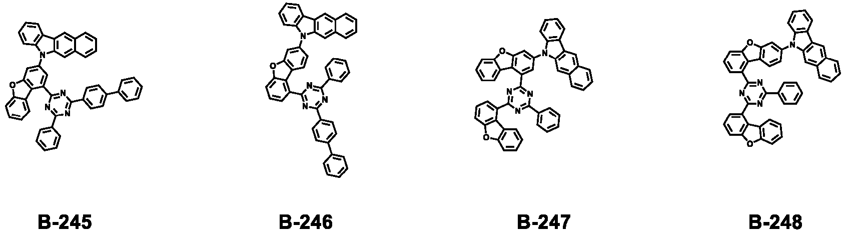

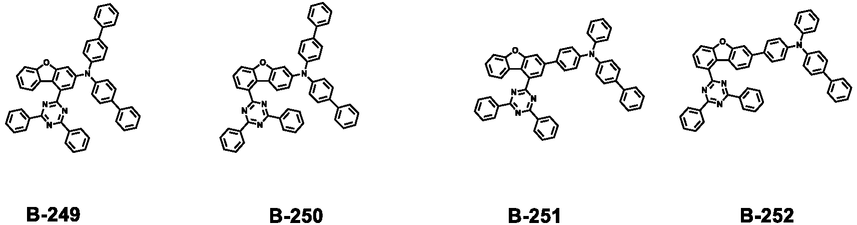

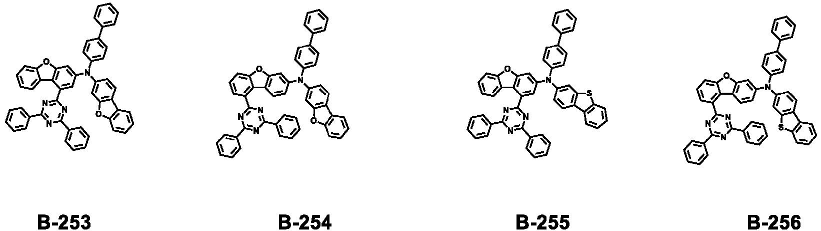

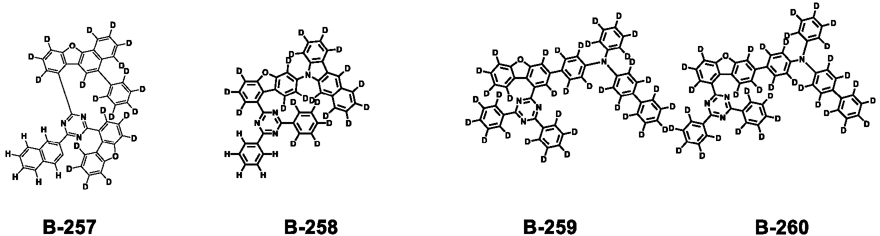

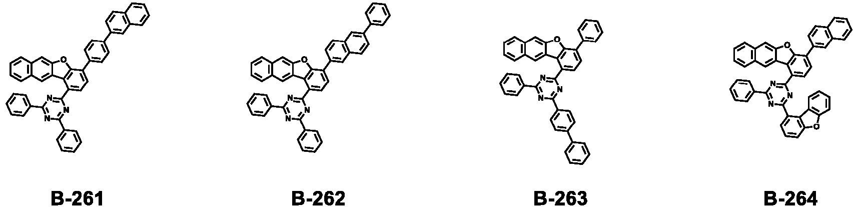

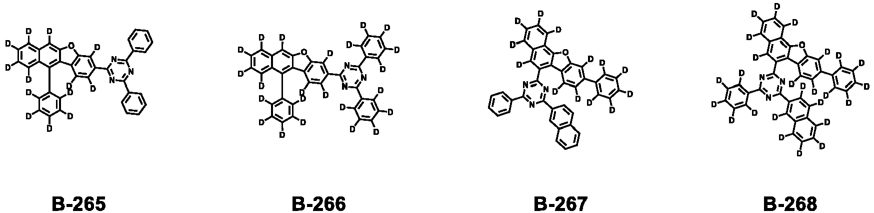

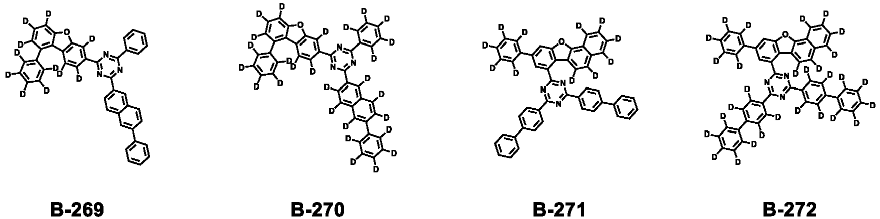

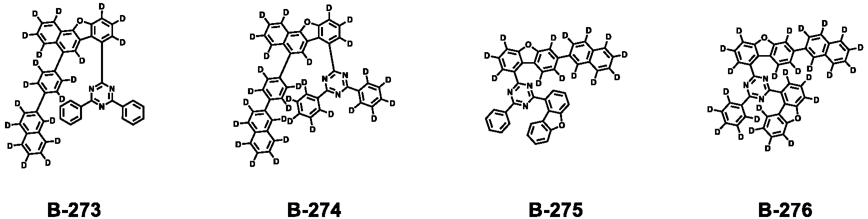

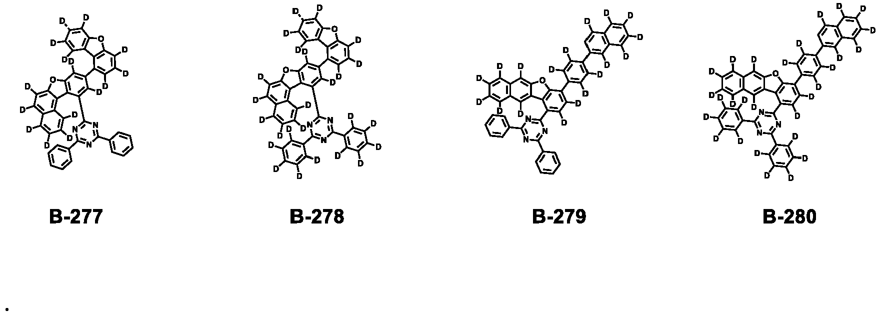

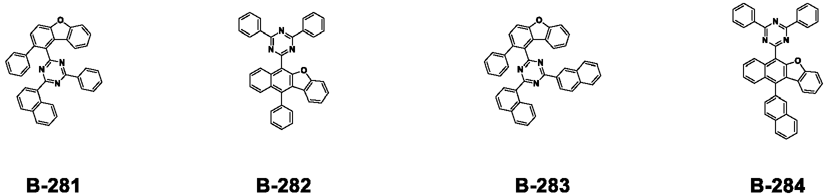

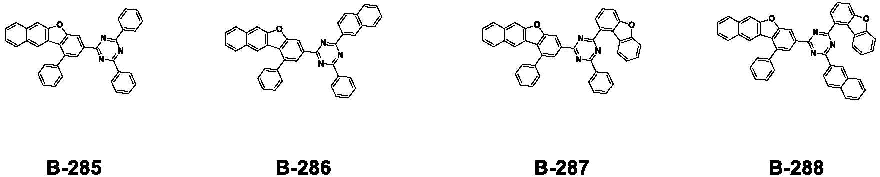

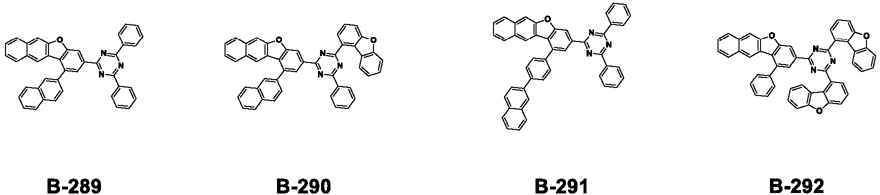

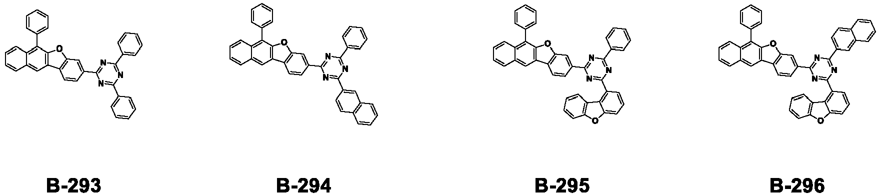

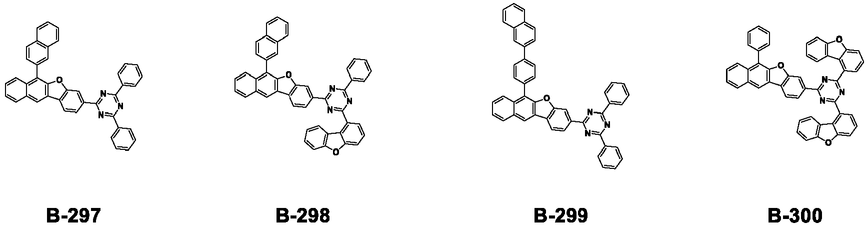

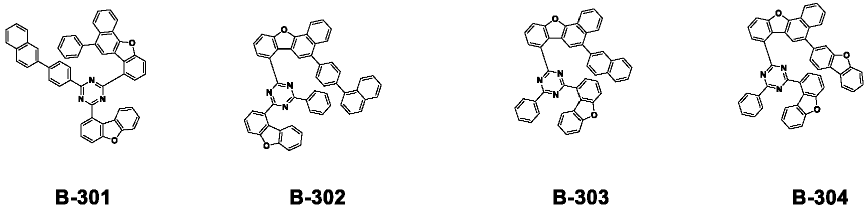

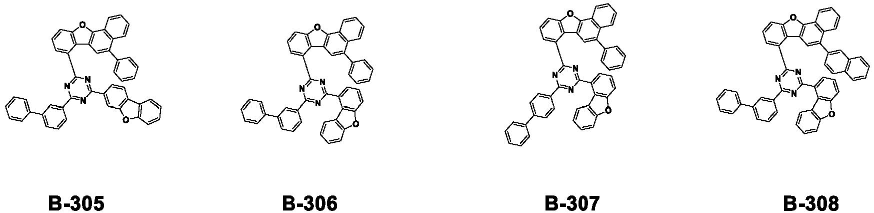

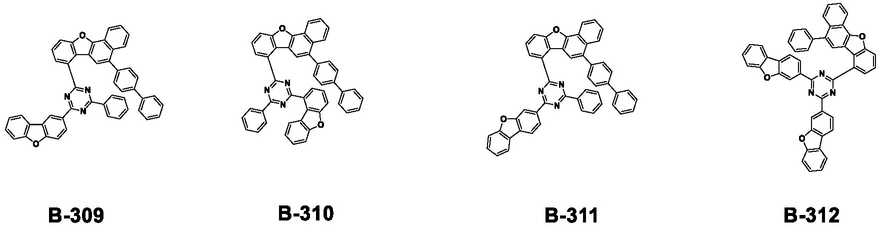

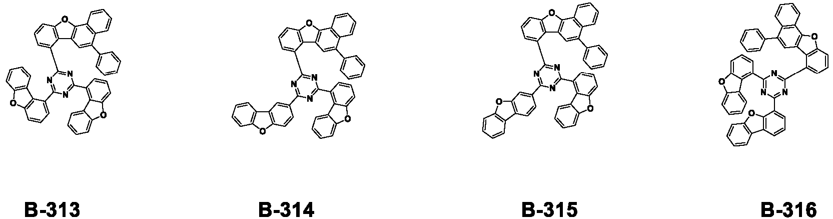

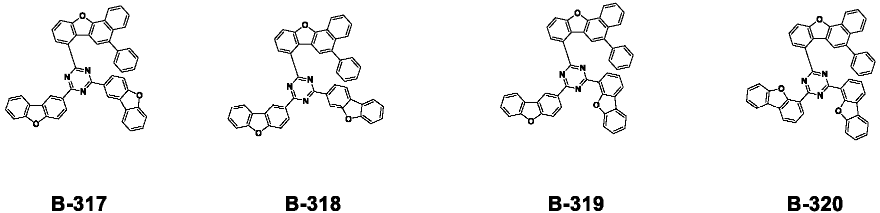

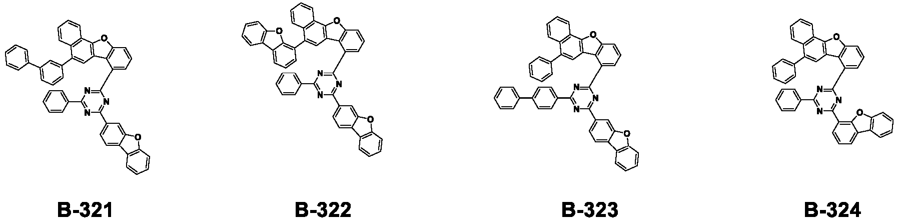

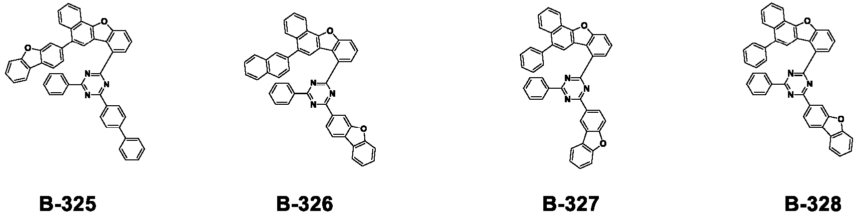

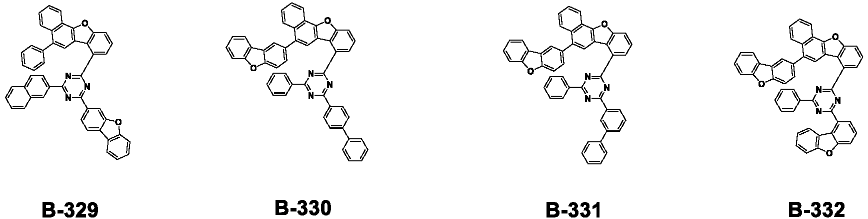

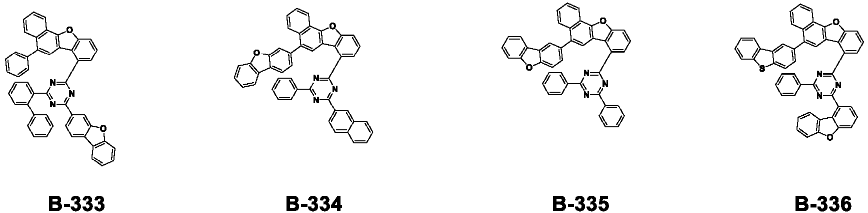

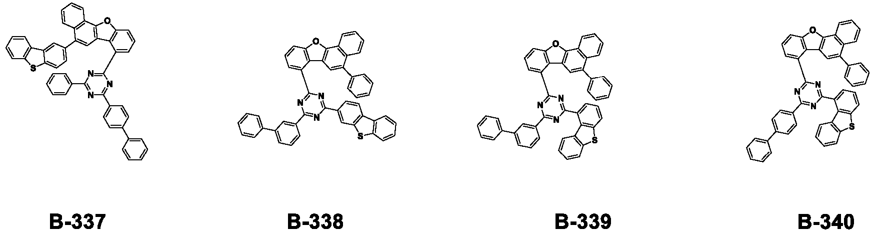

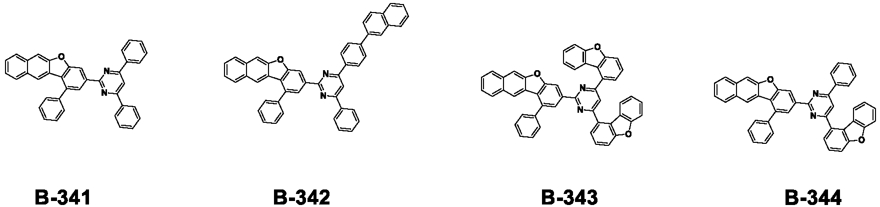

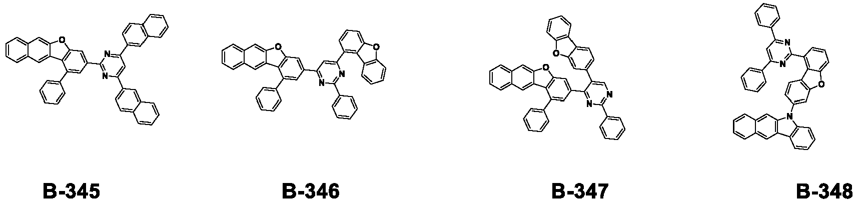

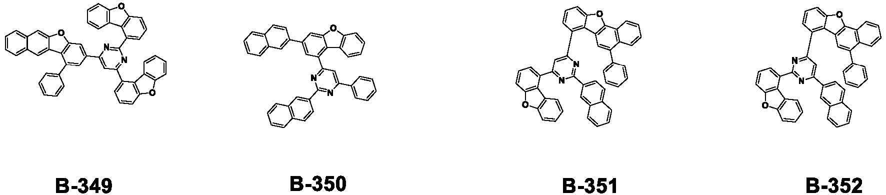

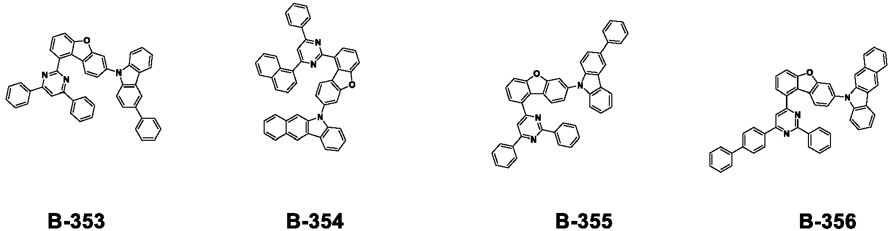

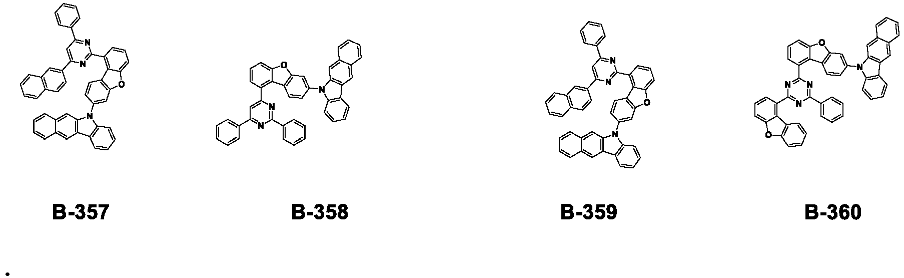

11. The organic light emitting device of claim 1, wherein the organic material layer further comprises an emission layer, and the emission layer comprises the heterocyclic compound represented by Chemical Formula A; and the heterocyclic compound represented by Chemical Formula B.

12. The organic light emitting device of claim 1, further comprising one or two or more layers selected from the group consisting of an emission layer, a hole injection layer, a hole transport layer, a hole transport auxiliary layer, an electron injection layer, an electron transport layer, an electron blocking layer, and a hole blocking layer.

13. A composition for an organic material layer of an organic light emitting device, the composition comprising a heterocyclic compound represented by the following Chemical Formula A and a heterocyclic compound represented by the following Chemical Formula B: 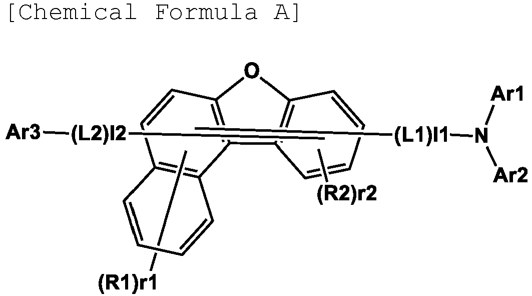 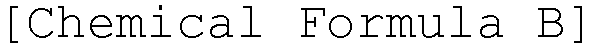 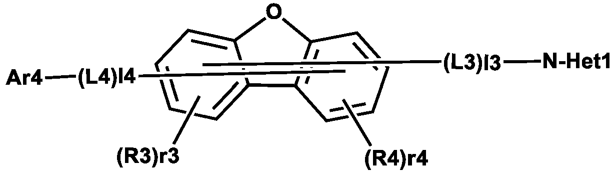
wherein, in Chemical Formulae A and B,
L1 to L4 are the same as or different from each other, and are each independently a direct bond; a substituted or unsubstituted arylene group having 6 to 60 carbon atoms; or a substituted or unsubstituted heteroarylene group having 2 to 60 carbon atoms,
Ar1 to Ar3 are the same as or different from each other, and are each independently a substituted or unsubstituted aryl group having 6 to 60 carbon atoms; a substituted or unsubstituted heteroaryl group having 2 to 60 carbon atoms; or a combination thereof,
Ar4 is a substituted or unsubstituted aryl group having 6 to 60 carbon atoms; a substituted or unsubstituted heteroaryl group having 2 to 60 carbon atoms; or a substituted or unsubstituted amine group,
R1 and R2 are the same as or different from each other, and are each independently hydrogen; deuterium; a halogen group; a cyano group; a substituted or unsubstituted alkyl group having 1 to 60 carbon atoms; a substituted or unsubstituted cycloalkyl group having 3 to 60 carbon atoms; a substituted or unsubstituted heterocycloalkyl group having 2 to 60 carbon atoms; a substituted or unsubstituted aryl group having 6 to 60 carbon atoms; or a substituted or unsubstituted heteroaryl group having 2 to 60 carbon atoms,
R3 and R4 are the same as or different from each other, and are each independently hydrogen; deuterium; a halogen group; a cyano group; a substituted or unsubstituted alkyl group having 1 to 60 carbon atoms; a substituted or unsubstituted cycloalkyl group having 3 to 60 carbon atoms; a substituted or unsubstituted heterocycloalkyl group having 2 to 60 carbon atoms; a substituted or unsubstituted aryl group having 6 to 60 carbon atoms; or a substituted or unsubstituted heteroaryl group having 2 to 60 carbon atoms, or two or more adjacent groups are bonded to each other to form a substituted or unsubstituted ring, 11 to 14 are the same as or different from each other, and are each independently an integer from 1 to 3, and when each of 11 to 14 is an integer of 2 or higher, the types of substituents in the parenthesis are the same as or different from each other,
r1 is an integer from 0 to 6,
each of r2 to r4 is an integer from 0 to 4,
the sum of r1 and r2 is 8,
the sum of r3 and r4 is 6,
when each of 11 to l4 and r1 to r4 is an integer of 2 or higher, substituents in the parenthesis are the same as or different from each other,
N-Het1 is represented by the following Chemical Formula N, 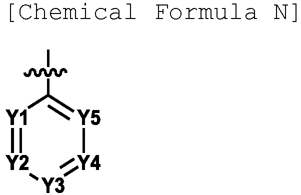
in Chemical Formula N, 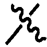
means a moiety linked to L3,
Y1 to Y5 are the same as or different from each other, and are each independently CRa or N, and at least one is N, and
Ra is a substituted or unsubstituted aryl group having 6 to 60 carbon atoms; or a substituted or unsubstituted heteroaryl group having 2 to 60 carbon atoms.

14. The composition of claim 13, wherein a weight ratio of the heterocyclic compound represented by Chemical Formula A to the heterocyclic compound represented by Chemical Formula B is 1:10 to 10:1.

15. A method for manufacturing an organic light emitting device, the method comprising:
preparing a substrate;
forming a first electrode on the substrate;
forming an organic material layer having one or more layers on the first electrode; and
forming a second electrode on the organic material layer,
wherein the forming of the organic material layer comprises forming an organic material layer having one or more layers by using the composition of claim 13.
